(19) Europäisches Patentamt
European Patent Office
Office européen des brevets

(11) EP 2 259 137 B1

# (12) EUROPEAN PATENT SPECIFICATION

(45) Date of publication and mention of the grant of the patent:
**31.08.2016 Bulletin 2016/35**

(21) Application number: **09725794.3**

(22) Date of filing: **27.03.2009**

(51) Int Cl.:
***G03F 7/033*** (2006.01) ***G03F 7/32*** (2006.01)
***B41C 1/10*** (2006.01)

(86) International application number:
**PCT/JP2009/056350**

(87) International publication number:
**WO 2009/119827 (01.10.2009 Gazette 2009/40)**

## (54) METHOD FOR PRODUCING A OF LITHOGRAPHIC PRINTING PLATE

VERFAHREN ZUR HERSTELLUNG EINER LITHOGRAFIEPLATTE

PROCÉDÉ DE PRODUCTION D'UNE PLAQUE D'IMPRESSION LITHOGRAPHIQUE

(84) Designated Contracting States:
**AT BE BG CH CY CZ DE DK EE ES FI FR GB GR HR HU IE IS IT LI LT LU LV MC MK MT NL NO PL PT RO SE SI SK TR**

(30) Priority: **27.03.2008 JP 2008084983**

(43) Date of publication of application:
**08.12.2010 Bulletin 2010/49**

(73) Proprietor: **FUJIFILM Corporation**
**Tokyo 106-0031 (JP)**

(72) Inventors:
- **TAGUCHI, Yoshinori**
  **Haibara-gun**
  **Shizuoka (JP)**
- **ARIMURA, Keisuke**
  **Haibara-gun**
  **Shizuoka (JP)**
- **OOHASHI, Hidekazu**
  **Haibara-gun**
  **Shizuoka (JP)**
- **INNO, Toshifumi**
  **Haibara-gun**
  **Shizuoka (JP)**
- **MIKOSHIBA, Hisashi**
  **Haibara-gun**
  **Shizuoka (JP)**

(74) Representative: **Hoffmann Eitle**
**Patent- und Rechtsanwälte PartmbB**
**Arabellastraße 30**
**81925 München (DE)**

(56) References cited:
**EP-A1- 0 670 521**
**EP-A1- 1 204 000**
**EP-A2- 1 216 830**
**EP-A2- 1 788 431**
**EP-A2- 2 042 923**
**JP-A- 7 219 233**
**JP-A- 2002 162 741**
**JP-A- 2006 065 321**
**JP-A- 2007 171 754**
**US-A- 2 902 365**
**US-A1- 2002 136 987**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 259 137 B1

## Description

FIELD OF THE INVENTION

The present invention relates to a process for producing a lithographic printing plate.

BACKGROUND ART

A lithographic printing plate in general has a surface consisting of a lipophilic image area and a hydrophilic non-image area. Lithographic printing is a method of alternatively supplying a fountain solution and an oily ink to the surface of a lithographic printing plate; utilizing the repellency between water and oil from each other to letting only the lipophilic image area receive the ink while letting the hydrophilic non-image area serve as a fountain solution receptive part (ink non-receiving part); and then transferring the ink to a material to be printed such as paper.

For producing this lithographic printing plate, a lithographic printing plate precursor (PS plate) having a hydrophilic support and a lipophilic photosensitive layer (image recording layer) formed thereon has conventionally been used widely. Usually, a lithographic printing plate is obtained by employing a plate making method comprising exposing a lithographic printing plate precursor to light through an original image such as lith film; and leaving a portion of the photosensitive layer which will be an image area while forming a non-image area by dissolving and removing the other unnecessary portion of the photosensitive layer with an alkaline developer or an organic solvent to expose the surface of the hydrophilic support.

Although the conventional process of making a lithographic printing plate precursor needs a step of dissolving and removing an unnecessary portion of the photosensitive layer with a developer or the like after exposure, simplification of such an additional damping treatment is one of the problems to be solved. For simplification, development with an almost neutral aqueous solution or simple water is desired.

In recent years, on the other hand, a digitization technology of electronically processing, storing, and outputting image data by using a computer has been widespread and various new image output systems coping with such digitization technology have been put into practical use. Along with this, a computer-to-plate technology is attracting attention, where digitized image data are carried on highly convergent radiation such as laser light and a lithographic printing plate precursor is subjected to scanning exposure to the light to directly produce a lithographic printing plate without using a lith film. Accordingly, one of important technical problems to be solved is to obtain a lithographic printing plate precursor suited for use in such a technology.

Based on the background as described above, there has been a growing demand for the development of a lithographic printing plate precursor capable of coping with both simplification of a plate-making work and digitization.

On the other hand, for example, Patent Document 1 describes that by incorporating a compound having an ethylene oxide chain in an image forming layer formed on a hydrophilic support of a lithographic printing plate precursor and containing a hydrophobized precursor, a hydrophilic resin, and a photothermal conversion agent, the resulting precursor can be used not only for the on-press development but also for printing after exposure and liquid development processing using water or an appropriate aqueous solution as a developer.

Moreover, patent Document 2 describes a treating method of a lithographic printing plate precursor which comprises preparing a lithographic printing plate precursor having (i) a hydrophilic support and (ii) a lipophilic thermosensitive layer that contains a radical polymerizable ethylenically unsaturated monomer, a radical polymerization initiator, and an IR absorbing dye, is cured by exposure to an infrared laser light, contains 60 mass% or greater of water, and can be developed with an aqueous developer having a pH of from 2 to 10; carrying out image-wise exposure of the precursor by using an infrared laser, and removing an uncured area from the thermosensitive layer by using the aqueous developer.

Patent Document 3 describes a production process of a lithographic printing plate, which comprises treating, in a gum solution, a lithographic printing plate precursor containing, as a photopolymerizable layer, a polymer having an ethylenically unsaturated bond as a repeating unit, thereby removing an uncured area.

Described specifically, Patent Document 2 describes an acrylic polymer; Patent Document 3 describes an aqueous development system using a polyvinyl alcohol resin modified with a quaternary pyridinium salt; and Patent Document 4 describes a polyvinyl alcohol-based polymer having a crosslinkable group. These systems however do not satisfy all of the developability, runlength, and stain resistance in a non-image area at the time of printing and there is a demand for the development of a technology capable of satisfying all of them. Patent Document 5, on the other hand, describes an aqueous development system using a carboxylic-acid modified polyvinyl alcohol resin and it is a system using an alkali development type developer.

Patent Document 1: Japanese Patent Laid-Open No. 2002-365789
Patent Document 2: U.S. Patent Application Publication No. 2004-0013968

Patent Document 3: Japanese Patent Laid-Open No. 2001-330952
Patent Document 4: European Patent Application Publication No. 1788431A2
Patent Document 5: Japanese Patent Laid-Open No. Hei 9-235438

## DISCLOSURE OF THE INVENTION

### PROBLEMS THAT THE INVENTION IS TO SOLVE

As described above, in order to keep developability with an aqueous developer having a pH from 2 to 10, a photosensitive layer should have hydrophilicity or high water penetrability. The photosensitive layer hardened by exposure does not have sufficient water resistance or film strength. In addition, binder polymers conventionally used in a lithographic printing plate cannot satisfy stain resistance in an aqueous developer having a pH from 2 to 10. With a view to overcoming these problems, it is necessary to provide a lithographic printing plate precursor in which a photosensitive layer hardened by exposure contributes to the excellent runlength of an image area and a non-image area, that is, an unexposed portion is removed completely with an aqueous developer having a pH from 2 to 10; and a production process of a lithographic printing plate by using the precursor.

### MEANS FOR SOLVING THE PROBLEMS

The present inventors have found that the above-described problems can be overcome by employing a photosensitive layer containing a specific copolymer.
A process for producing a lithographic printing plate comprising:

(i) image-wise exposing a lithographic printing plate precursor comprising at least a photosensitive layer on a support; and
(ii) removing unexposed areas of the photosensitive layer in the presence of an aqueous developer having a pH of from 2 to 10 and which contains a water soluble polymer compound and a surfactant selected from a nonionic surfactant, an amphoteric surfactant and a combination thereof to carry out development and gumming at the same time;

wherein the photosensitive layer of the lithographic printing plate precursor comprises the following components (A) , (B) , and (C):

(A) a copolymer having a repeating unit represented by the formula (1), a repeating unit represented by the formula (I) and at least either one of a repeating unit represented by the formula (2) and a repeating unit represented by the formula (3) :

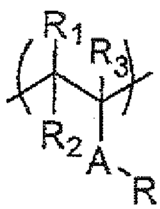 (1) 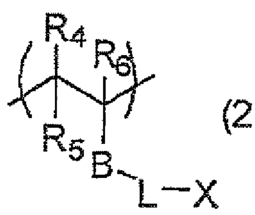 (2) 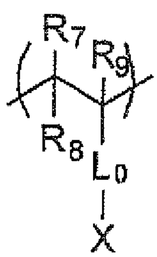 (3)

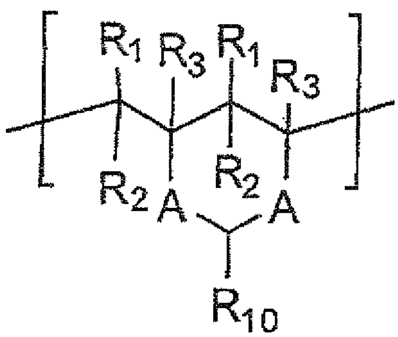 (I)

in the formulae (1), (I), (2), and (3), each A represents - O-; R represents an acyl group having from 2 to 20 carbon atoms, an alkyl group having from 1 to 20 carbon atoms, an aryl group having from 6 to 20 carbon atoms, an alkenyl group having from 2 to 20 carbon atoms, or an alkynyl group having from 2 to 20 carbon atoms; $R_1$ to $R_9$ are each independently a hydrogen atom or an alkyl group having from 1 to 20 carbon atoms; $R_{10}$ represents a hydrogen atom, a methyl group, an ethyl group, a propyl group, a phenyl group or a hydroxyphenyl group, with the proviso that any two of $R_1$ to $R_3$ in formula (I) may be the same or different; L represents a divalent linking group containing alkylene, arylene, alkenylene,-$SO_2$-, -SO-, -O-, -S-, -CO-, N($R_{3a}$), either singly or in combination, wherein $R_{3a}$ represents an alkyl group, an aryl group or a hydrogen atom; X represents a carboxylic acid group or a carboxylate salt; $L_0$ represents a single bond or a divalent hydrocarbon group having from 1 to 6 carbon atoms, with the proviso that $R_2$ and R in the formula (1), $R_5$ and L in the formula (2), and $R_8$ and $L_0$ in the formula (3) may be coupled to each other to form a ring;
(B) a compound having an ethylenically unsaturated bond;
(C) a polymerization initiator.

The invention is further defined by the appended claims.

It has not been elucidated that what brings about the effect of the invention, but it is presumed to be produced because of the following reasons. Although an increase in the hydrophilicity of a binder polymer enables development of a lithographic printing plate precursor with a developer having a pH from 2.0 to 10.0, it inevitably causes marked penetration of the developer or a fountain solution into an exposed portion, becoming a large factor of deteriorating runlength. Since the copolymer in the photosensitive layer of the invention has a repeating unit represented by the formula (1) as a hydrophobic portion and a repeating unit represented by the formula (2) and/or a repeating unit represented by the formula (3) as a hydrophilic portion, an interaction between the copolymer and a surfactant is improved, making it possible to impart the resulting lithographic printing plate precursor with developability with a developer having a pH from 2.0 to 10.0. Improvement in the runlength is presumed to occur because the copolymer in the photosensitive layer of the invention can reduce the penetrability of the developer having a pH from 2.0 to 10.0 and a fountain solution upon curing.

ADVANTAGE OF THE INVENTION

The invention makes it possible to provide a lithographic printing plate precursor for producing a lithographic printing plate capable of being developed well with a developer having a pH from 2.0 to 10.0, excellent in runlength, and excellent in stain resistance; and a production process of a lithographic printing plate.

BRIEF DESCRIPTION OF THE DRAWINGS

[FIG. 1] FIG. is a schematic view illustrating the structure of an automatic development processor.

DESCRIPTION OF THE REFERENCE NUMERALS AND SIGNS

1: Rotating brush roller
2: Backing roller
3: Transport roller
4: Transport guide plate
5: Spray pipe
6: Pipe line
7: Filter
8: Plate supply table
9: Plate discharge table
10: Developer tank
11: Circulating pump
12: Plate

BEST MODE FOR CARRYING OUT THE INVENTION

The photosensitive layer, lithographic printing plate precursor, and production process of a lithographic printing plate according to the invention will hereinafter be described specifically.

[Photosensitive layer]

The photosensitive layer of the lithographic printing plate precursor of the invention contains (A) a copolymer (which may hereinafter be called "binder polymer" or "specific binder polymer") having specific repeating units (a repeating unit represented by the formula (1), a repeating unit represented by the formula (I) and at least either one of a repeating unit represented by the formula (2) and a repeating unit represented by the formula (3)); a compound having an ethylenically unsaturated bond, and a radical polymerization initiator. Constituent components of a polymerizable composition will next be described more specifically.

(Specific binder polymer)

The specific binder polymer of the invention may be an optional compound insofar as it is a polymer containing, as specific repeating units, a repeating unit represented by the formula (1), a repeating unit represented by the formula (I) and at least either one of a repeating unit represented by the formula (2) and a repeating unit represented by the formula (3).

[Chem. 4]

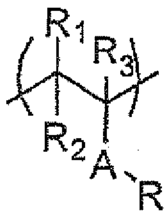 (1) 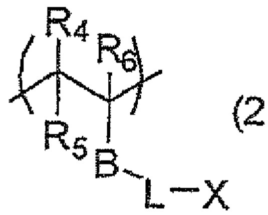 (2) 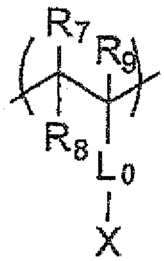 (3)

In the formulas (1), (2), and (3), each A represents -O-, from the standpoint of stain resistance.

R is an acyl group having from 2 to 20 carbon atoms, an alkyl group having from 1 to 20 carbon atoms, an aryl group having from 6 to 20 carbon atoms, an alkenyl group having from 2 to 20 carbon atoms, or an alkynyl group having from 2 to 20 carbon atoms; $R_1$ to $R_9$ are each independently a hydrogen atom or an alkyl group having from 1 to 20 carbon atoms .

L is a divalent linking group. The divalent linking group contains alkylene, arylene, alkenylene, $-SO_2-$, -SO-, -O-, -S-, -CO-, $-N(R_3)-$ (in which $R_3$ represents an alkyl group, an aryl group, or a hydrogen atom) either singly or in combination. L has preferably from 1 to 20 atoms.

X is a group selected from the class consisting of a carboxylic acid group, and monovalent groups containing a salt obtained by neutralizing a carboxylic acid.

Preferred examples of the salt upon neutralization include sodium salts, potassium salts, lithium salts, primary, secondary, or tertiary amine salts, and onium salts such as quaternary organic ammonium salts, sulfonium salts, and iodonium salts. Of these, sodium salts, tertiary amine salts, quaternary ammonium salts are especially preferred.

In the formula (3), $L_0$ represents a single bond or a divalent hydrocarbon group. The hydrocarbon group as $L_0$ has from 1 to 6 carbon atoms, preferably from 1 to 3 carbon atoms.

In addition, $R_2$ and R in the formula (1), $R_5$ and L in the formula (2), or $R_8$ and $L_0$ in the formula (3) may be coupled to form a ring. The number of the rings including the main skeleton (-C-C-) is preferably from 5 to 7.

Any process can be employed for synthesizing such a binder polymer, but a process of copolymerizing respective compounds represented by the below-described formulas (1)', (2)', and (3)' or a process of carrying out a polymer reaction while introducing a substituent is usually employed.

[Chem 5]

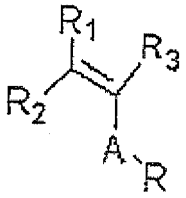 (1)'

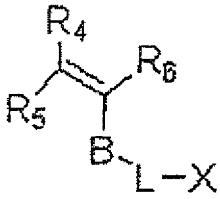 (2)'

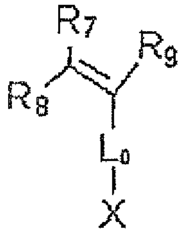 (3)'

In the formulas (1)', (2)', and (3)', R, $R_1$ to $R_9$, A, B, L, $L_0$, and X have the same meanings as described above.

In the invention, when a copolymer is formed by copolymerizing these compounds, a compound other than the compounds represented by the above formulas (1)', (2)', and (3)' may be used for the main chain and/or side chain. Examples of such a compound include those exemplified in the following (m1) to (m11). The compound other than the compounds represented by the above formulas (1)', (2)', and (3)' is contained preferably in an amount of 50 mol% or less in all the repeating units of the copolymer.

(m1) Acrylic acid esters and methacrylic acid esters having an aliphatic hydroxyl group, for example, 2-hydroxyethyl acrylate and 2-hydroxyethyl methacrylate.

(m2) Alkyl acrylates such as methyl acrylate, ethyl acrylate, propyl acrylate, butyl acrylate, amyl acrylate, hexyl acrylate, octyl acrylate, benzyl acrylate, 2-chloroethyl acrylate, and glycidyl acrylate. (m3) Alkyl methacrylates such as methyl methacrylate, ethyl methacrylate, propyl methacrylate, butyl methacrylate, amyl methacrylate, hexyl methacrylate, cyclohexyl methacrylate, benzyl methacrylate, 2-chloroethyl methacrylate, and glycidyl methacrylate.

(m4) Acrylamides and methacrylamides such as acrylamide, methacrylamide, N-methylolacrylamide, N-ethyl acrylamide, N-hexyl methacrylamide, N-cyclohexyl acrylamide, N-hydroxyethyl acrylamide, N-phenyl acrylamide, N-nitrophenyl acrylamide, and N-ethyl-N-phenyl acrylamide.

(m5) Vinyl ethers such as ethyl vinyl ether, 2-chloroethyl vinyl ether, hydroxyethyl vinyl ether, propyl vinyl ether, butyl vinyl ether, octyl vinyl ether, and phenyl vinyl ether.

(m6) Vinyl esters such as vinyl acetate, vinyl chloroacetate, vinyl butylate, and vinyl benzoate.

(m7) Styrenes such as styrene, $\alpha$-methylstyrene, methylstyrene, and chloromethylstyrene.

(m8) Vinyl ketones such as methyl vinyl ketone, ethyl vinyl ketone, propyl vinyl ketone, and phenyl vinyl ketone.

(m9) Olefins such as ethylene, propylene, isobutylene, butadiene, and isoprene.

(m10) N-vinylpyrrolidone, N-vinylcarbazole, 4-vinylpyridine, acrylonitrile, and methacrylonitrile.

(m11) Unsaturated imides such as maleimide, N-acryloylacrylamide, N-acetylmethacrylamide, N-propionylmethacrylamide, and N-(p-chlorobenzoyl)methacrylamide.

In order to impart a crosslinking property to the specific binder polymer, a crosslinkable functional group may be introduced into the main chain or side chain of the polymer. The crosslinkable functional group may be introduced by copolymerization or may be introduced by a polymer reaction.

The term "crosslinkable group" as used herein means a group capable of crosslinking the binder polymer during a radical polymerization reaction that occurs in the photosensitive layer when the lithographic printing plate precursor is exposed to light. The crosslinkable group is not particularly limited insofar as it has such a function and examples of a functional group capable of conducting an addition polymerization reaction include ethylenically unsaturated bonding groups and an epoxy group. Also, a functional group capable of forming a radical upon exposure to light may be used and examples of such a crosslinkable functional group include a thiol group, halogen groups, and onium salt structures. Of these, the ethylenically unsaturated bonding groups are preferred, and functional groups represented by the following formulas (101) to (103) are particularly preferred.

[Chem. 6]

Formula (101)

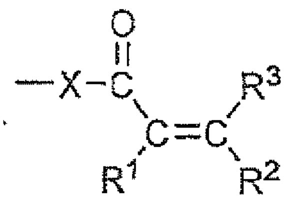

In the formula (101), each of $R^1$ to $R^3$ independently represents a hydrogen atom or a monovalent organic group. $R^1$ is preferably a hydrogen atom or an alkyl group which may have a substituent. Of these, a hydrogen atom or a methyl group is preferred because of high radical reactivity. Each of $R^2$ and $R^3$ independently represents, for example, a hydrogen atom, a halogen atom, an amino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent, or an arylsulfonyl group which may have a substituent. Of these, a hydrogen atom, a carboxyl group, an alkoxycarbonyl group, an alkyl group which may have a substituent, or an aryl group which may have a substituent is preferred because of high radical reactivity.

X represents an oxygen atom, a sulfur atom, or -N($R^{12}$) -, and $R^{12}$ represents a hydrogen atom or a monovalent organic group. The monovalent organic group is, for example, an alkyl group which may have a substituent. $R^{12}$ is preferably a hydrogen atom, a methyl group, an ethyl group, or an isopropyl group because of high radical reactivity.

Examples of the substituent which can be introduced include alkyl groups, alkenyl groups, alkynyl groups, aryl groups, alkoxy groups, aryloxy groups, halogen atoms, amino groups, alkylamino groups, arylamino groups, carboxyl groups, alkoxycarbonyl groups, sulfo groups, nitro groups, a cyano group, amide groups, alkylsulfonyl groups, and arylsulfonyl groups.

[Chem. 7]

Formula (102)

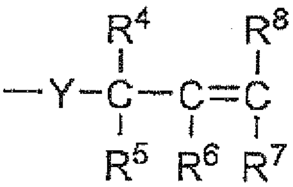

In the formula (102), each of $R^4$ to $R^8$ independently represents a hydrogen atom or a monovalent organic group. Each of $R^4$ to $R^8$ is preferably a hydrogen atom, a halogen atom, an amino group, a dialkylamino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent, and an arylsulfonyl group which may have a substituent. Of these, a hydrogen atom, a carboxyl group, an alkoxycarbonyl group, an alkyl group which may have a substituent, or an aryl group which may have a substituent is preferred.

Examples of the substituent that can be introduced include those described in the formula (101). Y represents an oxygen atom, a sulfur atom, or -N($R^{12}$) -. $R^{12}$ has the same meaning as $R^{12}$ in the formula (101) and preferable examples are also the same as those in the formula (101).

[Chem. 8]

Formula (103)

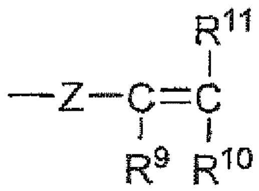

In the formula (103), $R^9$ represents a hydrogen atom or a monovalent organic group and is preferably a hydrogen atom, an alkyl group which may have a substituent, or the like. Of these, a hydrogen atom or a methyl group is preferred because of high radical reactivity. Each of $R^{10}$ and $R^{11}$ independently represents a hydrogen atom, a halogen atom, an amino group, a dialkylamino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent, or an arylsulfonyl group which may have a substituent. Of these, a hydrogen atom, a carboxyl group, an alkoxycarbonyl group, an alkyl group which may have a substituent, or an aryl group which may have a substituent is preferred because of high radical reactivity.

Examples of the substituent that can be introduced include those in the formula (101). Z represents an oxygen atom, a sulfur atom, $-N(R^{13})$ -, or a phenylene group which may have a substituent. $R^{13}$ represents alkyl group which may have a substituent or the like. Of these, a methyl group, an ethyl group, or an isopropyl group is preferred because of high radical reactivity.

Of these, a (meth)acrylic acid copolymer having a crosslinkable functional group in the side chain thereof is more preferred.

The specific binder polymer having a crosslinking property is cured, for example, in the following manner: a free radical (a polymerization initiating radical or a radical growing during the polymerization of a polymerizable compound) is added to the crosslinkable functional group to cause addition polymerization between polymers directly or through a polymerization chain of the polymerizable compound and as a result, a crosslink is formed between polymer molecules to become hardened. Alternatively, an atom (for example, a hydrogen atom on a carbon atom adjacent to the crosslinkable functional group) is withdrawn from the polymer by a free radical to produce polymer radicals and these polymer radicals are coupled to each other to form a crosslink between polymer molecules and become hardened.

The specific binder polymer is a copolymer containing, as the repeating unit represented by the formula (2) or the repeating unit represented by the formula (3), a repeating unit represented by the formula (2) or formula (3) in which X represents a carboxylic acid or a carboxylate salt and further containing a repeating unit represented by the formula (I).

[Chem. 9]

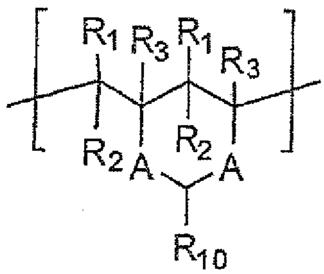

(I)

In the formula (I),
A and $R_1$ to $R_3$ have the same meanings as A and $R_1$ to $R_3$ in the formula (1), respectively.
$R_{10}$ includes a hydrogen atom, a methyl group, an ethyl group, a propyl group, a phenyl group, and a hydroxyphenyl group, with a propyl group being more preferred.

The binder can have an increased film strength by decreasing the number of repeating units represented by the formula (I).

In the specific binder polymer, preferred examples of the repeating unit represented by the formula (2) include

repeating units represented by the formula (2)'.

[Chem. 10]

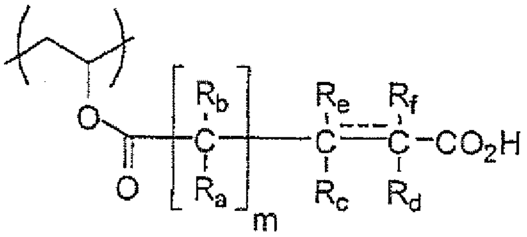

(2)'

In the formula (2)',
each of $R_a$, $R_b$, $R_c$, $R_d$, $R_e$, and $R_f$ independently represents a monovalent substituent which may have a substituent or a single bond, and m stands for an integer from 0 to 1.

Preferred examples of $R_a$, $R_b$, $R_c$, $R_d$, $R_e$, and $R_f$ include a hydrogen atom, alkyl groups which may have a substituent, halogen atoms, and aryl groups which may have a substituent. More preferred examples include a hydrogen atom, linear alkyl groups such methyl, ethyl, and propyl, alkyl groups substituted with carboxylic acid, halogen atoms, and a phenyl group. $R_c$ and $R_d$, or $R_e$ and $R_f$ may each form a cyclic structure. A bond between a carbon atom to which $R_c$ and $R_e$ are bonded and a carbon atom to which $R_d$ and $R_f$ are bonded is a single bond, a double bond, or an aromatic double bond. When it is a double bond or aromatic double bond, $R_c$-$R_d$, $R_e$-$R_f$, $R_c$-$R_f$, or $R_e$-$R_d$ are each coupled to form a single bond.

The following are specific examples of the repeating unit represented by the formula (2)', but the invention is not limited thereto.

[Chem. 11]

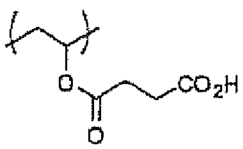
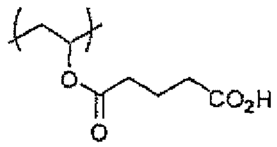
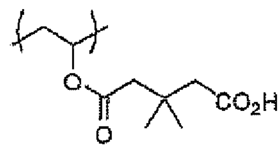

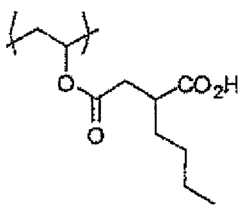
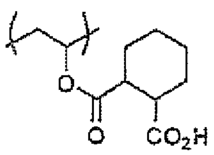
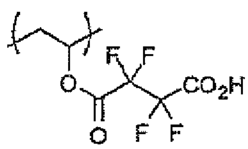
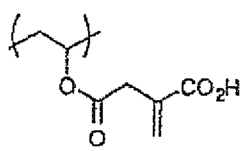

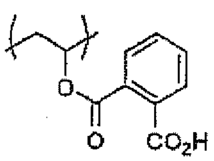
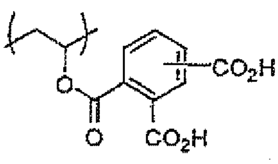
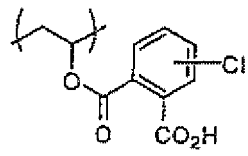

The specific binder polymer contains preferably a repeating unit represented by the formula (II) which is a repeating unit represented by the formula (3).

[Chem. 12]

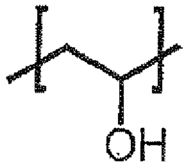

(II)

One of the preferred modes of the specific binder polymer is a structure of a copolymer containing a carboxylic acid and/or carboxylate therein. Preferred examples of the introduction method of it include a reaction between a hydroxyl group in the repeating unit represented by the formula (II) in the copolymer with a cyclic acid anhydride. The copolymer (carboxylic acid unit) obtained by using such a method sometimes become a cause of development scum because it undergoes a hydrolysis reaction in the treatment liquid, resulting in marked reduction in hydrophilicity. In such a case, the scum derived from the specific binder polymer and occuring in a developer can be reduced by increasing the number of repeating unit represented by the formula (II).

It is preferred that the specific binder polymer that contains at least either one of a repeating unit represented by the formula (2) or formula (3) in which X represents a carboxylic acid or a carboxylate salt together with a repeating unit represented by the formula (I) further contains a repeating unit represented by the formula (II) which is a repeating unit represented by the formula (3) in an amount of 30 mol% or greater but not greater than 80 mol% in the copolymer.

The specific binder polymer has a mass average molecular weight of preferably 5,000 or greater, more preferably 10,000 to 300,000 and has a number average molecular weight of preferably 1,000 or greater, more preferably 2,000 to 250,000. Polydispersity (mass average molecular weight/number average molecular weight) is preferably from 1.1 to 10. The specific binder polymer may be any of a random polymer, a block polymer, and a graft polymer, with a random polymer being preferred.

When the specific binder polymer contains a repeating unit represented by the formula (I), the mass average molecular weight (Mw) has a great influence on developability so that the mass average molecular weight (Mw) is preferably 150,000 or less from the standpoint of developability. Accordingly, the mass average molecular weight (Mw) is more preferably 5,000 or greater but not greater than 150,000, more preferably 7,000 or greater but not greater than 100,000, most preferably 10,000 or greater but not greater than 40,000. The term "mass average molecular weight" as used herein means a reduced value with polystyrene having a molecular weight determined in advance by GPC (gel permeation chromatography) as a standard material.

It is preferred that the specific binder copolymer having as X in the formula (2) or the formula (3) as a carboxylic acid and/or carboxylate and having further a repeating unit represented by the formula (I) has a mass average molecular weight (Mw) of from 10,000 to 40,000.

In the specific binder polymer, X in the formula (2) or the formula (3) in the repeating unit represents a carboxylic acid or a carboxylate salt, and more preferably from the standpoint of halftone dot reproduction the binder polymer has a monocarboxylic acid structure, that is, a structure having only one carboxylic acid or carboxylate salt structure in the repeating unit. Although details have not been elucidated, it is presumed that presence of many carboxylic acid structures (polycarboxylic acid structure) in the repeating unit inevitably increases penetration of a developer at an exposed portion, which deteriorates the halftone dot reproduction.

The specific binder polymer is preferably a copolymer having a carboxylic acid or a carboxylate salt as X in the formula (2) or formula (3), having a (monocarboxylic acid) structure, that is, a structure having only one carboxylic acid or carboxylate salt structure in the repeating unit, and having further a repeating unit represented by the formula (I).

In the specific binder polymer, which is a copolymer having, as X in the formula (2) or the formula (3), a carboxylic acid and/or a carboxylate salt and having further a repeating unit represented by the formula (I), the linking groups L and $L_0$ in the formula (2) or the formula (3) have a great influence on the developability. This is presumed to occur because motility around the carboxylic acid or carboxylate salt determining the developability changes greatly.

From the standpoint of developability, the linking groups L and $L_0$ are preferably an aliphatic linking group having a noncyclic structure compared with an aromatic group or aliphatic cyclic structure in which a linking group around a carboxylic acid or a carboxylate is rigid. An alkylene structure is especially preferred.

The binder polymer is preferably a copolymer having a carboxylic acid and/or a carboxylate salt as X in the formula (2) or the formula (3), having an aliphatic linking group which may have a substituent as L and/or $L_0$, and having further a repeating unit represented by the formula (I).

When the specific binder polymer has a carboxylate salt as X in the formula (2) or the formula (3), the counter cation is preferably a metal salt from the standpoint of the balance between developability and runlength, and scratch resistance. Preferred examples of the metal salt include salts of an alkali metal of the Group I of the periodic table such

as lithium ion, sodium ion, potassium ion, and cesium ion; and salts of a metal of the Group II of the periodic table such as magnesium ion, calcium ion, and barium ion. Of these, sodium salts, potassium salts, and calcium salts are most preferred.

The specific binder polymer is preferably a copolymer having, as X in the formula (2) or the formula (3), a carboxylate having a metal salt as a counter cation and further having a repeating unit represented by the formula (I).

In the specific binder polymer, the content of the repeating unit represented by the formula (1), in all the repeating units constituting the specific binder polymer, is usually from 5 to 95 mol%, preferably from 50 to 90 mol%, while the total content of the repeating unit represented by the formula (2) and/or the repeating unit represented by the formula (3) is usually from 1 to 60 mol%, preferably from 5 to 40 mol%.

The content of the repeating unit represented by the formula (I) in all the repeating units constituting the specific binder polymer is usually from 0.1 to 99 mol%, most preferably from 1 to 50 mol% from the standpoint of runlength, scratch resistance, and coating properties of an overcoating layer (OC).

A plurality of repeating units may be used in combination for each of the repeating units.

The specific binder polymer may be used singly or two or more specific binder polymers may be used in combination.

The content of the specific binder polymer in the total solid content of the photosensitive layer is preferably from 5 to 90 mass%, more preferably from 10 to 70 mass%, still more preferably from 10 to 60 mass%.

The following are specific examples of the binder polymer, that are used in the Reference Examples.

Incidentally, the repeating units are accompanied with the number showing a composition ratio (molar ratio).

[Chem. 13]

P-1 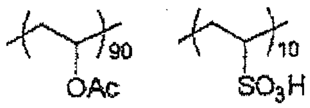 Mw= 80,000

P-2 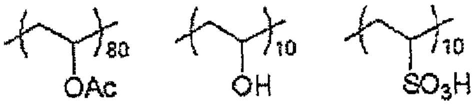 Mw= 100,000

P-3 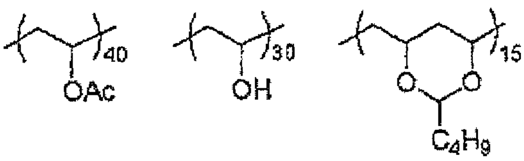 Mw= 90,000

P-4 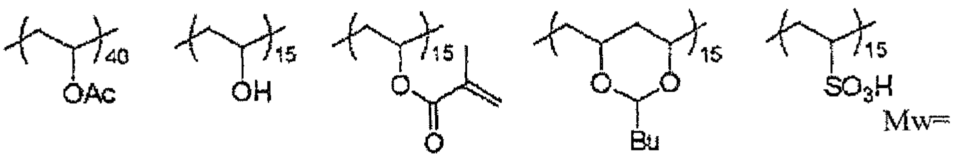 Mw= 85,000

P-5 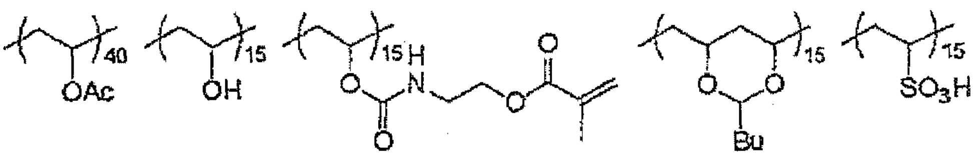 Mw= 88,000

P-6 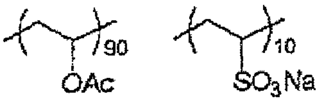 Mw= 80,000

P-7 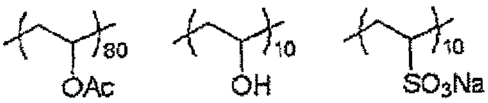 Mw= 100,000

P-8 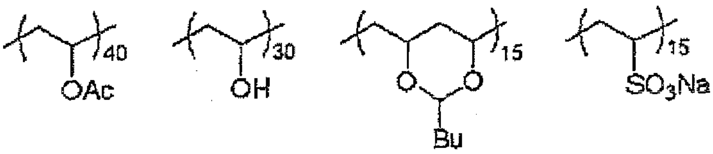 Mw= 90,000

P-9 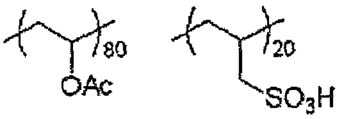 Mw= 52,000

P-10 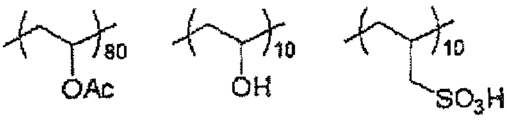 Mw= 65,000

P-11 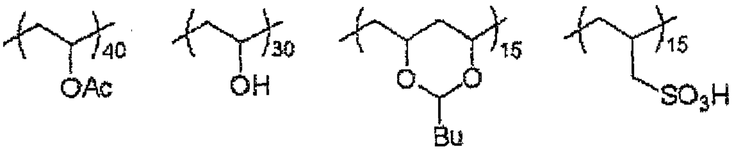 Mw= 72,000

[Chem. 14]

P-12 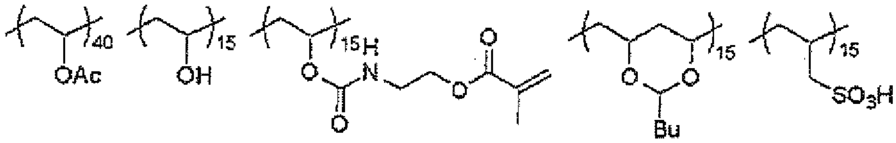 Mw= 89,000

P-13 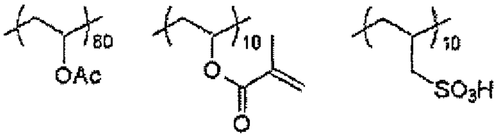 Mw= 75,000

P-14 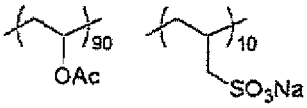 Mw= 98,000

P-15 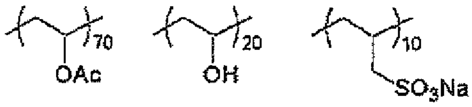 Mw= 78,000

P-16 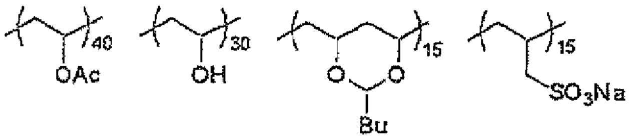 Mw= 69,000

P-17 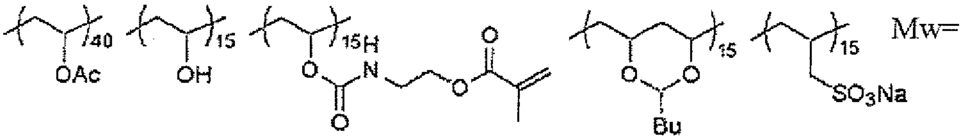 Mw= 65,000

P-18 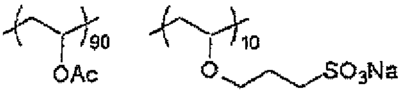 Mw= 89,000

P-19 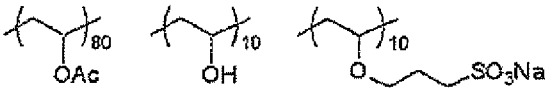 Mw= 78,000

P-20 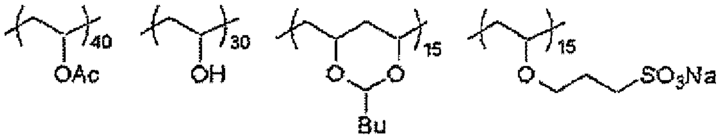 Mw= 65,000

P-21 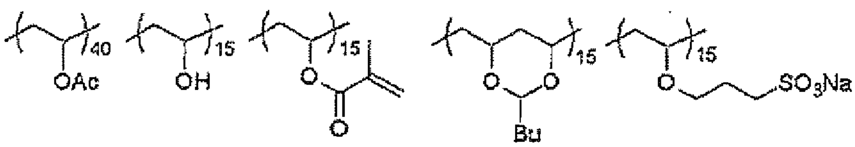 Mw= 51,000

P-22 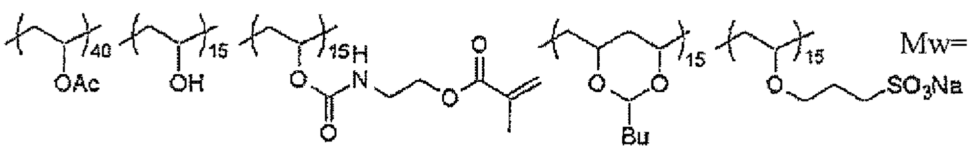 Mw= 54,000

[Chem. 15]

P-23 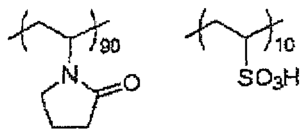 Mw= 51,000

P-24 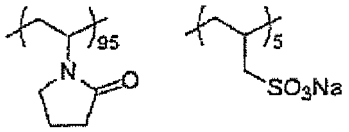 Mw= 48,000

P-25 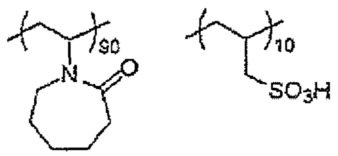 Mw= 51,000

P-26 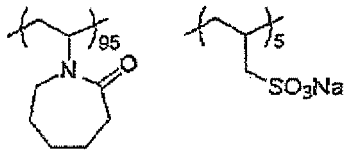 Mw= 62,000

P-27 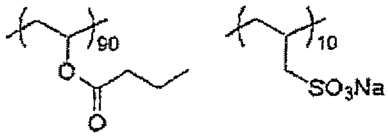 Mw= 58,000

P-28 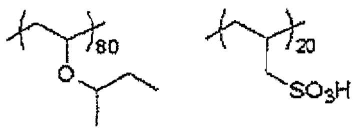 Mw= 60,000

P-29 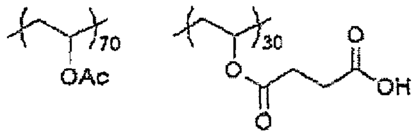 Mw= 72,000

P-30 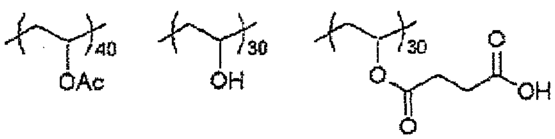 Mw= 65,000

P-31 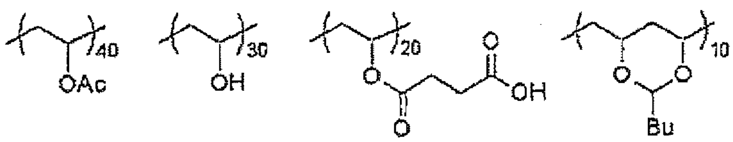 Mw= 61,000

P-32 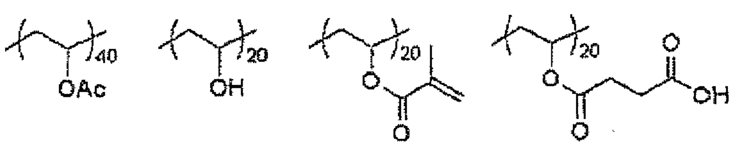 Mw= 67,000

[Chem. 16]

P-33 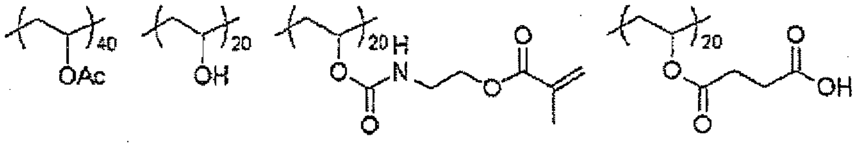 Mw= 61,000

P-34 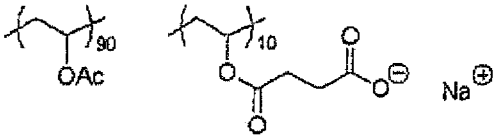 Mw= 50,000

P-35 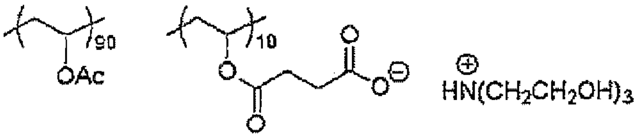 Mw= 50,000

P-36 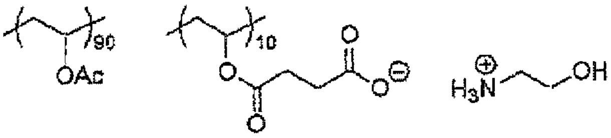 Mw= 50,000

P-37 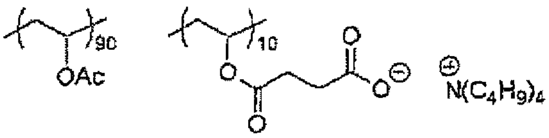 Mw= 50,000

P-38 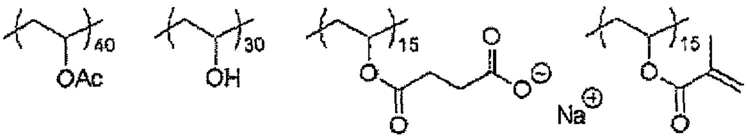 Mw= 61,000

P-39 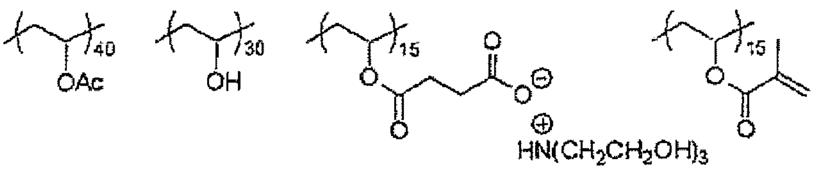 Mw= 62,000

P-40 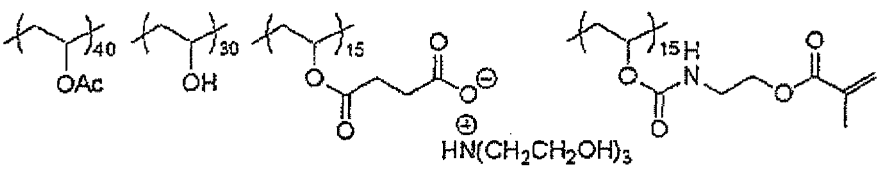 Mw= 71,000

P-41 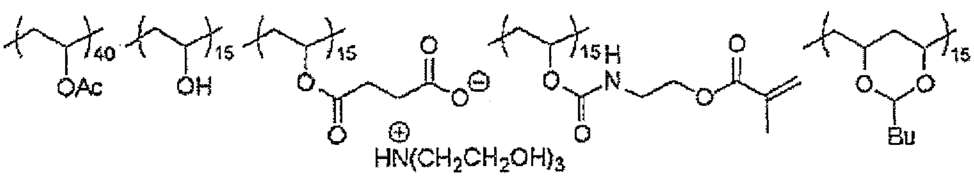

Mw= 65,000

[Chem. 17]

P-42 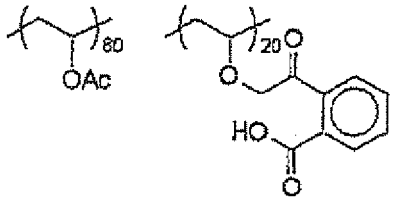 Mw= 71,000

P-43 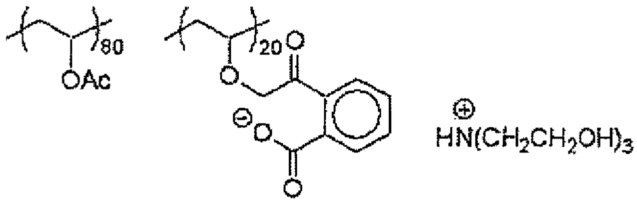 Mw= 82,000

P-44 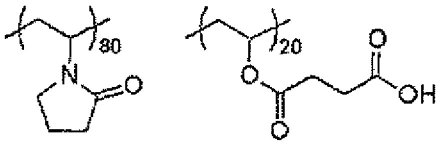 Mw= 51,000

P-45 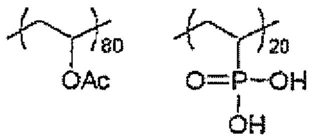 Mw= 45,000

P-46 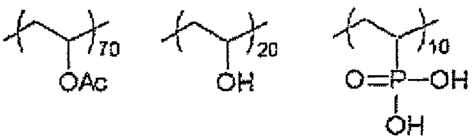 Mw= 43,000

P-47 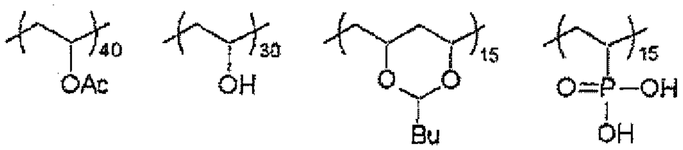 Mw= 45,000

P-48 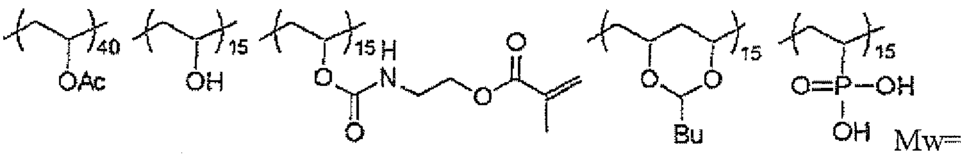 Mw= 49,000

P-49 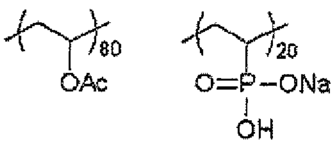 Mw= 45,000

P-50 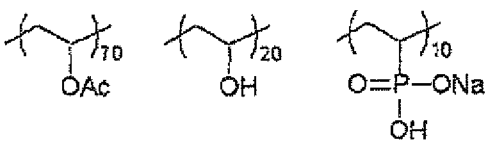 Mw= 43,000

[Chem. 18]

P-51 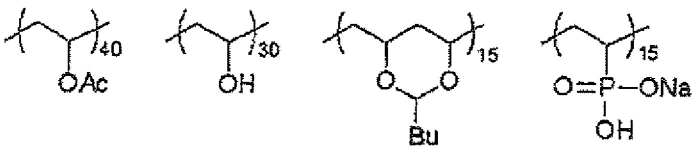 Mw= 45,000

P-52 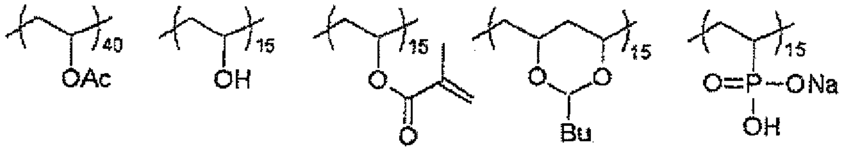 Mw= 47,000

P-53 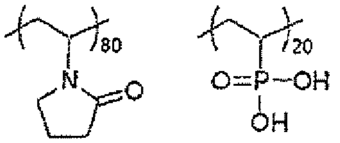 Mw= 43,000

P-54 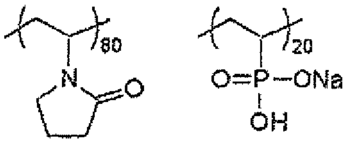 Mw= 43,000

P-55 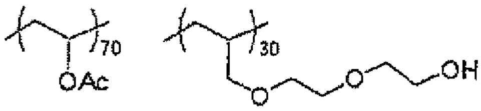 Mw= 48,000

P-56 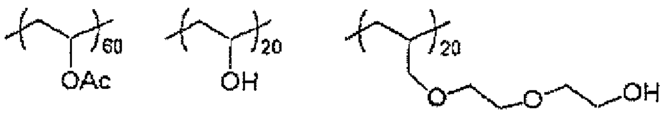 Mw= 51,000

P-57 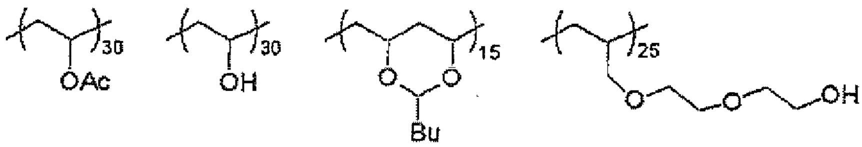 Mw= 49,000

P-58 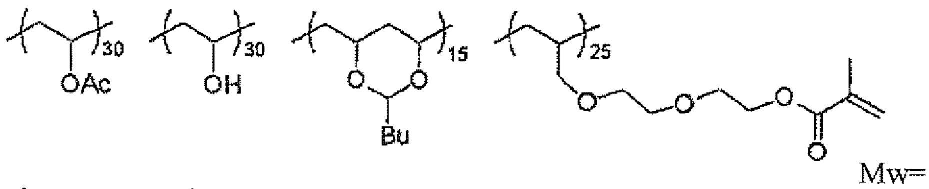 Mw= 53,000

P-59 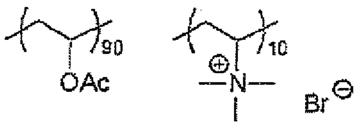 Mw= 43,000

P-60 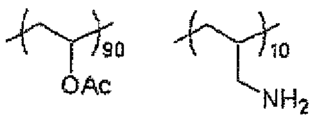 Mw= 48,000

[Chem. 19]

P-61 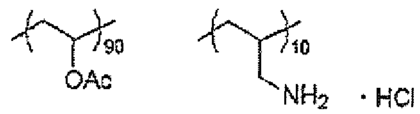 Mw= 47,000

P-62 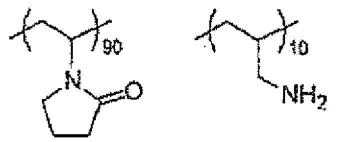 Mw= 44,000

P-63 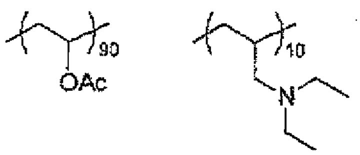 Mw= 48,000

P-64 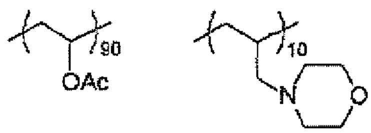 Mw= 49,000

P-65 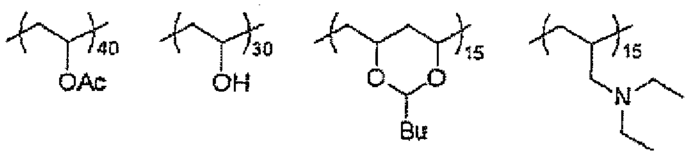 Mw= 50,000

P-66 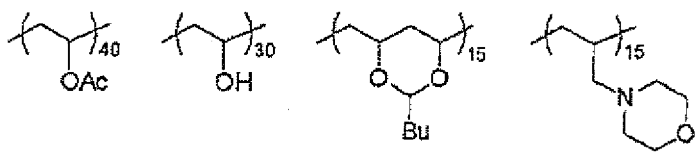 Mw= 43,000

P-67 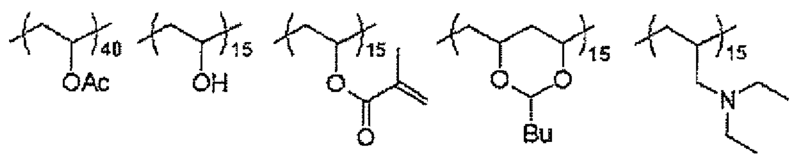 Mw= 44,000

P-68 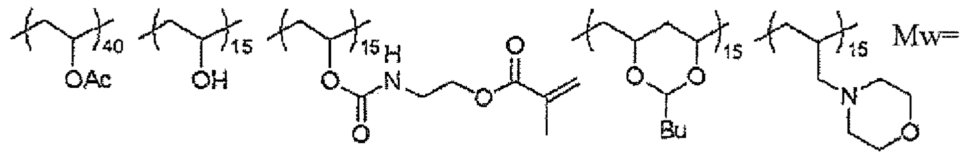 Mw= 49,000

The synthesis examples of the specific binder of the invention will next be described, but they are not limited to the below-described ones. Also, another specific binder polymer can be synthesized in accordance with the following synthesis example.

<Synthesis of Exemplified compound (P-1)>

A 500-mL three-necked flask equipped with a condenser and a stirrer was charged with 862 g of N-methylpyrrolidone. Under a nitrogen gas stream, a solution obtained by dissolving 86.09 g of vinyl acetate, 10.81 g of vinylsulfonic acid, and 0.10 g of azobisisobutyronitrile in 10 g of N-methylpyrrolidone was added and the resulting mixture was heated

to 63°C. After reaction at 63°C for 5 hours, the reaction mixture was charged in water to precipitate a copolymer. The resulting precipitate was collected by filtration, washed, and dried to obtain a binder polymer (P-1). The resulting binder polymer was identified as a target product by NMR spectrum, IR spectrum, and GPC.

<Another binder polymer>

The photosensitive layer of the invention may contain, in addition to the specific binder polymer, another binder polymer.

As the another binder polymer usable in combination for the photosensitive layer of the invention, a binder polymer having a hydrophilic group is preferred from the standpoint of developability in a developer.

The hydrophilic group is selected from monovalent and polyvalent hydrophilic groups. Preferred examples include a hydroxyl group, sulfonic acid groups, carboxylic acid groups, a phosphoric acid group, alkyleneoxy groups such as ethyleneoxy and propyleneoxy, primary amino groups, secondary amino groups, tertiary amino groups, salts formed by neutralizing an amino group with an acid, quaternary ammonium groups, sulfonium groups, an iodonium group, a phosphonium group, amide groups, ether groups, and salts formed by neutralizing an acid group such as carboxylic acid, sulfonic acid, or phosphoric acid. Of these, primary amino groups, secondary amino groups, tertiary amino groups, salts formed by neutralizing an amino group with an acid, quaternary ammonium groups, amide groups, a hydroxyl group, a $-CH_2CH_2O-$ repeating unit, and a $-CH_2CH_2NH-$ repeating unit are especially preferred, with tertiary amino groups, salts formed by neutralizing an acid group with an amino-containing compound, salts formed by neutralizing an amino group with an acid, and quaternary ammonium groups being most preferred.

The another binder polymer is preferably a copolymer. The proportion of a copolymer component having a hydrophilic group as described above in all the copolymer components of the copolymer is preferably from 1 to 70% from the standpoint of developability. In order to satisfy both the developability and runlength, the proportion is more preferably from 1 to 50%, especially preferably from 1 to 30%.

The another binder polymer has an acid value (acid content per g of a polymer, indicated by the chemical equivalent number) of usually 0.3 meq/g to 5.0 meq/g and the acid value is preferably from 0.5 meq/g to 3.0 meq/g from the standpoint of developability and runlength.

A proper solubility (binder polymer concentration at the time of saturation) of the binder polymer in water is preferably 10 mass% or less, more preferably 1.0 mass% or less. The above solubility is measured at 25°C, which is an ordinary temperature at the time of development in plate making.

As the skeleton of the another binder polymer, a polymer selected from an acrylic resin, a polyvinyl acetal resin, a polyvinyl alcohol resin, a polyurethane resin, a polyamide resin, an epoxy resin, a methacrylic resin, a styrene resin, and a polyester resin is preferred. Of these, an acrylic resin, a methacrylic resin, vinyl copolymers such as styrene resin, and a polyurethane resin are more preferred, with an acrylic resin being especially preferred.

The another binder polymer for use in the invention preferably has a crosslinkable group. The term "crosslinkable group" as used herein means a group capable of crosslinking the binder polymer during a radical polymerization reaction that occurs in the photosensitive layer when the lithographic printing plate precursor is exposed to light. The crosslinkable group is not particularly limited insofar as it has such a function and examples of a functional group capable of conducting an addition polymerization reaction include ethylenically unsaturated bonding groups, amino groups and an epoxy group. Also, a functional group capable of forming a radical upon exposure to light may be used and examples of such a crosslinkable group include a thiol group and halogen groups. Of these, ethylenically unsaturated bonding groups are preferred. The ethylenically unsaturated bonding group is preferably a styryl group, a (meth)acryloyl group, or an allyl group.

The another binder polymer is cured, for example, in the following manner: a free radical (a polymerization initiating radical or a radical growing during the polymerization of a polymerizable compound) is added to the crosslinkable functional group to cause addition polymerization between polymers directly or through a polymerization chain of the polymerizable compound and as a result, a crosslink is formed between polymer molecules to become hardened. Alternatively, an atom (for example, a hydrogen atom on a carbon atom adjacent to the crosslinkable functional group) is withdrawn from the polymer by a free radical to produce polymer radicals and these polymer radicals are coupled to each other to form a crosslink between polymer molecules and become hardened.

The content of the crosslinkable group (content of the radical-polymerizable unsaturated double bond determined by iodine titration) in the another binder polymer is preferably from 0.01 to 10.0 mmol, more preferably from 0.05 to 5.0 mmol, most preferably from 0.1 to 2.0 mmol, per g of the binder polymer.

Further, from the standpoint of improvement in the runlength, the crosslinkable group is preferably present in the vicinity of the hydrophilic group and both the hydrophilic group and the crosslinkable group may be present on the same polymerization unit.

The another binder polymer for use in the invention preferably has, in addition to the unit having a hydrophilic group, the unit having a crosslinkable group, and the unit having both a hydrophilic group and a crosslinkable group, a

unit of alkyl or aralkyl (meth)acrylate. The alkyl group in the alkyl (meth)acrylate is preferably an alkyl group having from 1 to 5 carbon atoms, more preferably a methyl group. Examples of the aralkyl (meth)acrylate include benzyl(meth)acrylate.

The another binder polymer has a mass average molecular weight of preferably 5,000 or greater, more preferably from 10,000 to 300,000, and has a number average molecular weight of 1,000 or greater, more preferably from 2,000 to 250,000. The polydispersity (mass average molecular weight/number average molecular weight) is preferably from 1.1 to 10.

The another binder polymer may be any of a random polymer, a block polymer, and a graft polymer. As the another binder polymer, one binder monomer may be used or two or more may be used in combination. The content of the another binder polymer is preferably from 5 to 75 mass%, more preferably from 7 to 60 mass%, still more preferably from 10 to 50 mass%, based on the total solid content of the photosensitive layer from the standpoint of good strength of the image area and a good image forming property.

The total content of the polymerizable compound and the another binder polymer is preferably 80 mass% or less based on the total solid content of the photosensitive layer. The total contents exceeding 80 mass% may decrease the sensitivity and deteriorate the developability. The total content is more preferably from 35 to 75 mass%.

Specific examples of the another binder polymer for use in the invention will next be shown, but the invention is not limited by these examples. The mass average molecular weight (Mw) in the table is measured using gel permeation chromatography (GPC) with polystyrene as a standard material.

[Chem. 20]

| Polymer No. | Binder structure (mol%) | Molecular weight |
|---|---|---|
| R-1 | 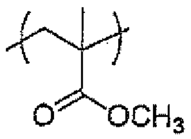 90 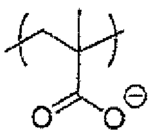 10 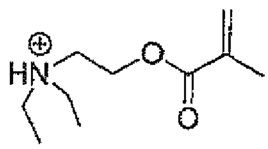 | 80,000 |
| R-2 | 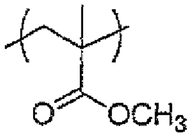 95 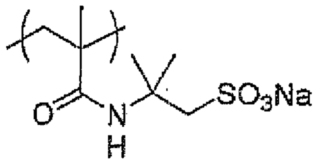 5 | 72,000 |

[Chem. 21]

| Polymer No. | Diisocyanate compound used (mol%) | Diol compound used (mol%) | Molecular weight |
|---|---|---|---|
| R-3 | 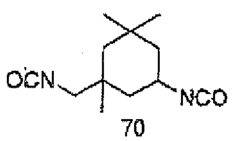 70 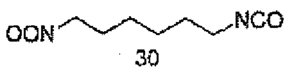 30 | 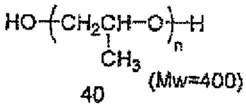 (Mw=400) 40 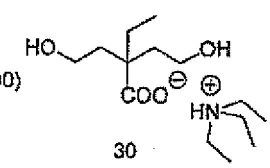 30 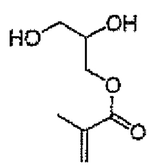 30 | 60,000 |

[Chem. 22]

| Polymer No. | Binder structure (mol%) | Molecular weight |
|---|---|---|
| R-4 | 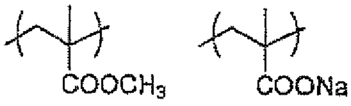 90 10 | 50,000 |
| R-5 | 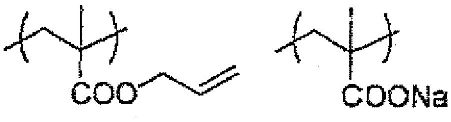 90 10 | 60,000 |
| R-6 | 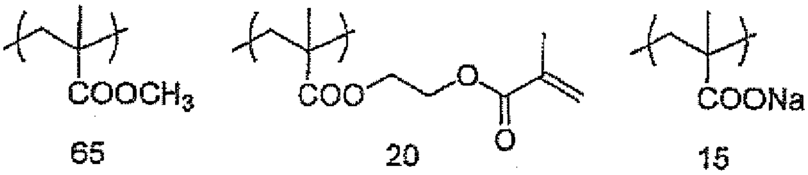 65 20 15 | 65,000 |
| R-7 | 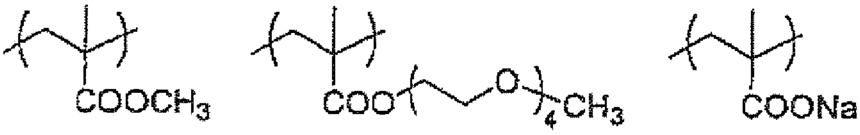 85 10 5 | 60,000 |
| R-8 | 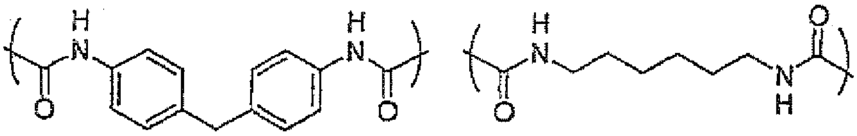 40 10 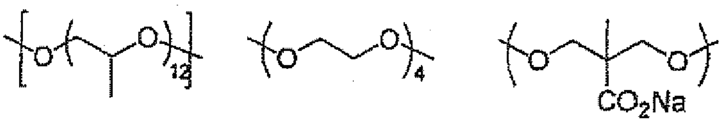 20 20 10 | 63,000 |

[Chem. 23]

| Polymer No. | Binder structure (mol%) | Molecular weight |
|---|---|---|
| R-9 | 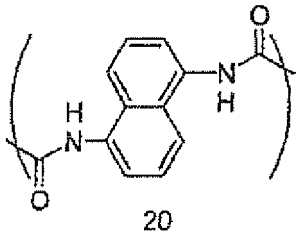 20 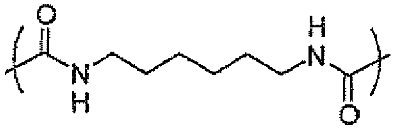 30 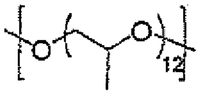 20 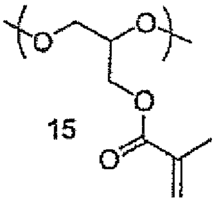 15 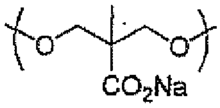 15 | 60,000 |

[Chem. 24]

| No. | Polymer structure | Composition ratio | Molecular weight |
|---|---|---|---|
| R-10 | 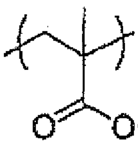 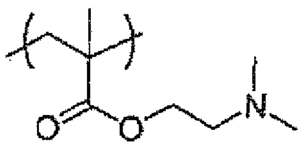 | 90/10 | 70,000 |
| R-11 | 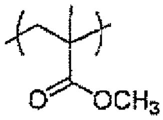 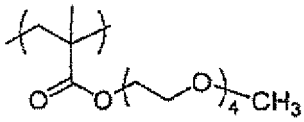 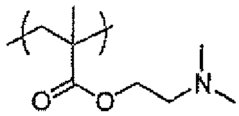 | 90/5/5 | 80,000 |
| R-12 | 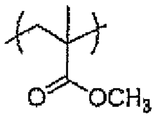 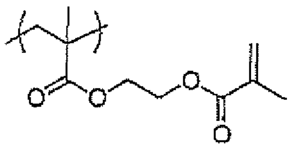 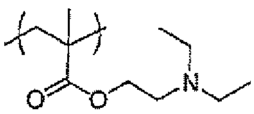 | 60/35/5 | 80,000 |

[Chem. 25]

| Polymer No. | Diisocyanate compound used (mol%) | Diol compound used (mol%) | Molecular weight |
|---|---|---|---|
| R-13 | 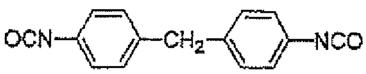 80 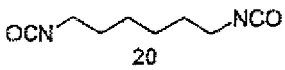 20 | 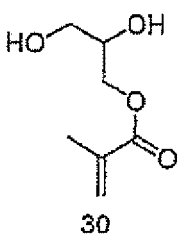 30 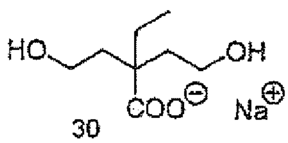 30 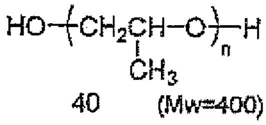 40 (Mw=400) | 57,000 |

[Chem. 26]

| Polymer No. | Polymer structure | Composition ratio | Molecular weight |
|---|---|---|---|
| R-14 | 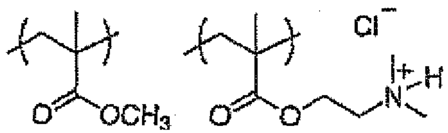 | 90/10 | 70,000 |
| R-15 | 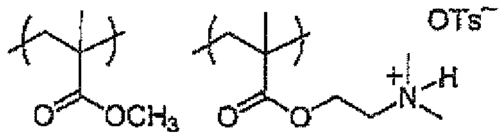 | 90/10 | 58,000 |
| R-16 | 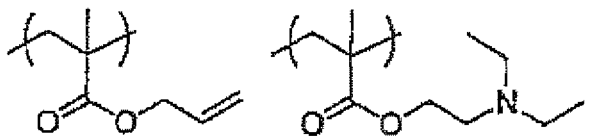 | 90/10 | 90,000 |
| R-17 | 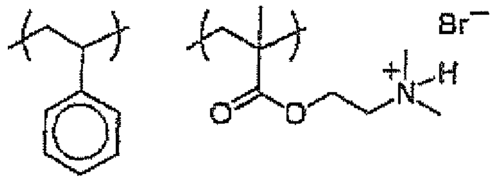 | 70/30 | 62,000 |
| R-18 | 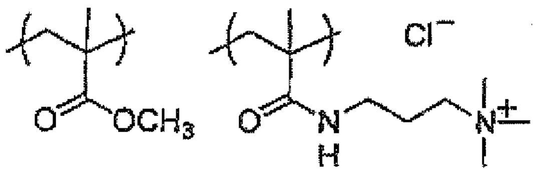 | 70/30 | 58,000 |
| R-19 | 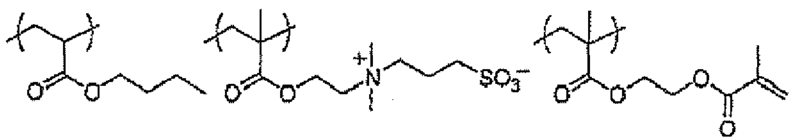 | 50/25/25 | 49,000 |

[Chem. 27]

| | Diisocyanate dicarboxylic acid structure | | Diol diamine structure | | | Mw |
|---|---|---|---|---|---|---|
| R-20 | 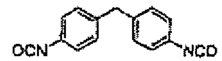 40 | 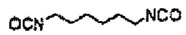 10 | $HO-(CH_2CH(CH_3)-O)_n-H$ 10 (Mw=1000) | 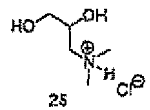 25 | 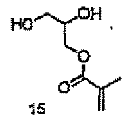 15 | 59000 |
| R-21 | 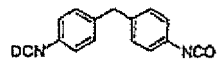 40 | 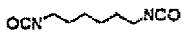 10 | $HO-(CH_2CH(CH_3)-O)_n-H$ 10 (Mw=1000) | 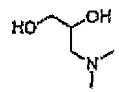 25 | 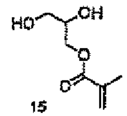 15 | 59000 |
| R-22 | 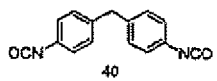 40 | 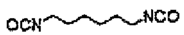 10 | $HO-(CH_2CH(CH_3)-O)_n-H$ 10 (Mw=1000) | 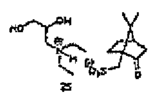 25 | 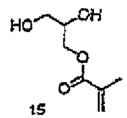 15 | 62000 |
| R-23 | 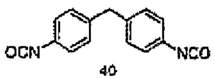 40 | 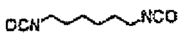 10 | 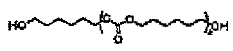 10 | 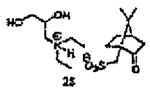 25 | 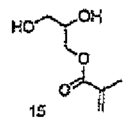 15 | 53000 |

(Compound having ethylenically unsaturated bond)

The compound having an ethylenically unsaturated bond (which may hereinafter be called "polymerizable compound") to be used in the photosensitive layer of the invention is an addition polymerizable compound having at least one ethylenically unsaturated double bond and is selected from compounds having at least one terminal ethylenically unsaturated bond, preferably two or more terminal ethylenically unsaturated bonds. Such a group of compounds is widely known in the present industrial field, and they may be used in the invention without any particular limitation. Their chemical form is, for example, a monomer, a prepolymer, that is, dimer, trimer, or oligomer, a copolymer thereof, or a mixture thereof. Examples of the monomer include unsaturated carboxylic acids (such as acrylic acid, methacrylic acid, itaconic acid, crotonic acid, isocrotonic acid, and maleic acid), and esters or amides thereof. Of these, esters of an unsaturated carboxylic acid and an aliphatic polyol compound and amides of an unsaturated carboxylic acid with an aliphatic polyamine compound are preferred. Furthermore, an addition reaction product of an unsaturated carboxylic acid ester or amide having an nucleophilic substituent such as a hydroxyl group, an amino group, or a mercapto group with a monofunctional or polyfunctional isocyanate or epoxy, a dehydration-condensation reaction product with a monofunctional or polyfunctional carboxylic acid may also be preferred. Furthermore, an addition reaction product of an unsaturated carboxylic acid ester or amide having an electrophilic substituent such as isocyanate group or epoxy group with a monofunctional or polyfunctional alcohol, an amine, or a thiol, and a substitution reaction product of an unsaturated carboxylic acid ester or amide having a leaving substituent such as a halogen group or a tosyloxy group with a monofunctional or polyfunctional alcohol, an amine, or a thiol are also suited. Furthermore, as another example, compounds obtained by replacing the above-described unsaturated carboxylic acid with an unsaturated phosphonic acid, styrene, vinyl ether, or the like may also be used.

Specific examples of the ester monomer of an aliphatic polyol compound and an unsaturated carboxylic acid include acrylic acid esters such as ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate, isocyanuric acid ethylene-oxide-modified (EO-modified) triacrylate, and a polyester acrylate oligomer.

Examples of methacrylic acid esters include tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[p-(3-methacryloxy-2-hydroxypropoxy)phenyl]dimethylmethane, and bis-[p-(methacrylaxyethoxy)phenyl]dimethylmethane.

Examples of itaconic acid esters include ethylene glycol diitaconate, propylene glycol diitaconate, 1,3-butanediol diitaconate, 1,4-butanediol diitaconate, tetramethylene glycol diitaconate, pentaerythritol diitaconate, and sorbitol tetraitaconate. Examples of crotonic acid esters include ethylene glycol dicrotonate, tetramethylene glycol dicrotonate, pentaerythritol dicrotonate, and sorbitol tetradicrotonate. Examples of isocrotonic acid esters include ethylene glycol diisocrotonate, pentaerythritol diisocrotonate, and sorbitol tetraisocrotonate. Examples of maleic acid esters include ethylene glycol dimaleate, triethylene glycol dimaleate, pentaerythritol dimaleate, and sorbitol tetramaleate.

As examples of another ester, aliphatic alcohol-based esters as described in Japanese Patent Publication No. Sho 51-47334 and Japanese Patent Laid-Open No. Sho 57-196231, esters having an aromatic skeleton as described in Japanese Patent Laid-Open No. Sho 59-5240, Japanese Patent Laid-Open No. Sho 59-5241, and Japanese Patent Laid-Open No. Hei 2-226149, esters having an amino group as described in Japanese Patent Laid-Open No. Hei 1-165613 are suited for use.

Moreover, the above-described ester monomers may be used as a mixture.

In addition, specific examples of amide monomers of an aliphatic polyamine compound and an unsaturated carboxylic acid include methylenebis-acrylamide, methylenebis-methacrylamide, 1,6-hexamethylenebis-acrylamide, 1,6-hexamethylenebis-methacrylamide, diethylenetriaminetrisacrylamide, xylylenebisacrylamide, and xylylenebismethacrylamide. Additional preferred examples of amide-based monomers include those having a cyclohexylene structure as described in Japanese Patent Publication No. Sho 54-21726.

Furthermore, a urethane-based addition polymerizable compound produced by an addition reaction of an isocyanate and a hydroxyl group is also suited. Specific examples of this compound include vinyl urethane compounds, which are described in Japanese Patent Publication No. 48-41708, containing two or more polymerizable vinyl groups per molecule obtained by adding a hydroxyl-containing vinyl monomer represented by the below-described formula (A) to a polyisocyanate compound having two or more isocyanate groups per molecule.

$$CH_2=C(R_4)COOCH_2CH(R_5)OH \qquad (A)$$

(wherein, $R_4$ and $R_5$ independently denote H or $CH_3$)

Further, urethane acrylates as described in Japanese Patent Laid-Open No. Sho 51-37193, Japanese Patent Publication No. Hei 2-32293, and Japanese Patent Publication No. Hei 2-16765, and urethane compounds having an ethylene oxide skeleton described in Japanese Patent Publication No. 58-49860, Japanese Patent Publication No. Sho 56-17654, Japanese Patent Publication No. Sho 62-39417, and Japanese Patent Publication No. Sho 62-39418 are also suited. Furthermore, by using an addition polymerizable compound having an amino structure or a sulfide structure in the molecule thereof, which compound is described in Japanese Patent Laid-Open No. Sho 63-277653, Japanese Patent Laid-Open No. Sho 63-260909, and Japanese Patent Laid-Open No. Hei 1-105238, a photopolymerizable composition excellent in photosensitive speed can be obtained.

Additional examples include polyfunctional acrylates and methacrylates, as described in Japanese Patent Laid-Open No. Sho 48-64183, Japanese Patent Publication No. Sho 49-43191, and Japanese Patent Publication No. Sho 52-30490, such as polyester acrylates and epoxy acrylates obtained by reacting an epoxy resin with (meth)acrylic acid. Examples also include specific unsaturated compounds described in Japanese Patent Publication No. Sho 46-43946, Japanese Patent Publication No. Hei 1-40337, and Japanese Patent Publication No. Hei 1-40336, and vinyl phosphonic acid compounds described in Japanese Patent Laid-Open No. Hei 2-25493. In some cases, perfluoroalkyl-containing structures described in Japanese Patent Laid-Open No. Sho 61-22048 are suitably used. Moreover, those introduced as photocurable monomers or oligomers in Journal of the Adhesion Society of Japan, 20(7), 300-308(1984) may also be used.

With regard to these polymerizable compounds, the structure, details of a using method such as single use or combined use, and the amount may be freely set according to the final performance design of a lithographic printing plate precursor. The polymerizable compound is selected, for example, from the following standpoints.

From the viewpoint of sensitivity, a structure having a large content of an unsaturated group per molecule is preferred. In many cases, a bi- or higher functional compound is preferred. Furthermore, in order to increase the strength of an image area, that is, a cured film, tri- or higher-functional compound is suited. It is also effective to adjust both sensitivity and strength by using, in combination, groups different in functionality/polymerizable group (such as acrylic acid ester, methacrylic acid ester, styrene compound, or vinyl ether compound).

In addition, a selecting/using method of the polymerizable compound is an important factor for compatibility or dispersibility with another component (such as binder polymer, polymerization initiator, or colorant) in the photosensitive layer. For example, compatibility can be improved by using a low-purity compound or using two or more compounds in combination. It is also possible to select a specific structure with a view to improving the adhesion with a support or a protective layer which will be described later. In addition, with respect to the using method of the polymerizable compound, an appropriate structure, proportion, and amount can be selected freely from the standpoint of the degree of polymerization inhibition due to oxygen, resolution, susceptibility to fogging, change in refractive index, surface tackiness, or the like. Further, in some cases, a layer constitution/coating method including undercoating and overcoating may be taken into consideration.

The above-described polymerizable compound is used in an amount of preferably from 5 to 75 mass%, more preferably from 25 to 70 mass%, especially preferably from 30 to 60 mass%, based on the total solid content of the photosensitive layer.

(Polymerization initiator)

The photosensitive layer of the invention contains a polymerization initiator (which may hereinafter also be called "initiator compound"). The initiator compound is a compound undergoing a chemical change due to an action such as electron transfer, energy transfer, or heat generation resulting from the electron excited state of a sensitizing dye to generate at least one species selected from radicals, acids, and bases. The radicals, acids, and bases thus generated will hereinafter be called "active species". When the initiator compound is not present or when it is used alone, sensitivity sufficient for practical use cannot be achieved. As one mode of using a sensitizing dye and the initiator compound in combination, they can be used as as a single compound by utilizing an appropriate chemical method (for example, linking of the sensitizing dye and the initiator compound via a chemical bond).

It is presumed that many of these initiator compounds ordinarily generate active species through an initial chemical process as typified by the following processes (1) to (3). Described specifically, they are (1) reductive decomposition of the initiator compound based on an electron transfer reaction from a sensitizing dye in the electron excited state to the initiator compound, (2) oxidative decomposition of the initiator compound based on electron transfer from the initiator compound to a sensitizing dye in the electron excited state, and (3) decomposition of the initiator compound in the electron excited state based on energy transfer from a sensitizing dye in the electron excited state to the initiator compound. Although it is unclear in many cases to which of the types (1) to (3) an individual initiator compound belongs,

the sensitizing dye in the invention has a very high sensitizing effect when used in combination with any initiator compound.

As the initiator compound in the invention, compounds known to those skilled in the art can be used without limitation. Specific examples include trihalomethyl compounds, carbonyl compounds, organic peroxides, azo compounds, azide compounds, metallocene compounds, hexaarylbiimidazole compounds, organic boron compounds, disulfone compounds, oxime ester compounds, onium salt compounds, and iron arene complexes. Of these, at least one compound selected from the hexaarylbiimidazole compounds, onium salts, trihalomethyl compounds, and metallocene compounds is preferred, with the hexaarylbiimidazole compounds being especially preferred. These polymerization initiators may be used in combination of two or more thereof as needed.

Examples of the hexaarylbiimidazole compounds include lophine dimers described in Japanese Patent Publication No. Sho 45-37377 and Japanese Patent Publication No. Sho 44-86516 such as 2,2'-bis(o-chlorophenyl)-4,4',5,5'-tetraphenylbiimidazole, 2,2'-bis(o-bromophenyl)-4,4',5,5'-tetraphenylbiimidazole, 2,2'-bis(o,p-dichlorophenyl)-4,4',5,5'-tetraphenylbiimidazole, 2,2'-bis(o-chlorophenyl)-4,4',5,5'-tetra(m-methoxyphenyl)biimidazole, 2,2'-bis(o,o'-dichlorophenyl)-4,4',5,5'-tetraphenylbiimidazole, 2,2'-bis(o-nitrophenyl)-4,4',5,5'-tetraphenylbiimidazole, 2,2'-bis(o-methylphenyl)-4,4',5,5'-tetraphenylbiimidazole, and 2,2'-bis(o-trifluorophenyl)-4,4',5,5'-tetraphenylbiimidazole.

The hexaarylbiimidazole compounds are particularly preferred when used in combination with a sensitizing dye having an absorption maximum in a wavelength region of from 300 to 450 nm.

The onium salt (functions not an acid generator but an ionic polymerization initiator in the invention) preferably used in the invention includes onium salts represented by the following formulas (RI-I) to (RI-III):

[Chem. 28]

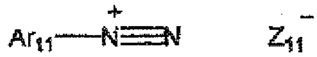

(RI-I)

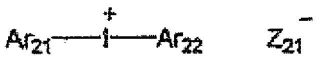

(RI-II)

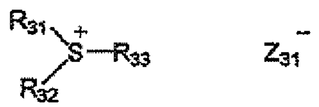

(RI-III)

In the formula (RI-I), $Ar_{11}$ represents an aryl group which has 20 or less carbon atoms and may have 1 to 6 substituents. Preferred examples of the substituent include alkyl groups having from 1 to 12 carbon atoms, alkenyl groups having from 1 to 12 carbon atoms, alkynyl groups having from 1 to 12 carbon atoms, aryl groups having from 1 to 12 carbon atoms, alkoxy groups having from 1 to 12 carbon atoms, aryloxy groups having from 1 to 12 carbon atoms, halogen atoms, alkylamino groups having from 1 to 12 carbon atoms, dialkylamino groups having from 1 to 12 carbon atoms, alkylamide or acrylamide groups having from 1 to 12 carbon atoms, carbonyl groups, carboxyl groups, a cyano group, sulfonyl groups, thioalkyl groups having from 1 to 12 carbon atoms, and thioaryl groups having from 1 to 12 carbon atoms. $Z_{11}^-$ represents a monovalent anion. Specific examples of it include a halogen ion, a perchlorate ion, a borate ion, a sulfonate ion, a sulfinate ion, a thiosulfonate ion, and a sulfate ion. Of these, a perchlorate ion, a hexafluorophosphate ion, a tetrafluoroborate ion, a sulfonate ion, and a sulfinate ion are preferred from the standpoint of stability.

In the formula (RI-II), each of $Ar_{21}$ and $Ar_{22}$ independently represents an aryl group which has 20 or less carbon atoms and may have 1 to 6 substituents. Preferred examples of the substituent include alkyl groups having from 1 to 12 carbon atoms, alkenyl groups having from 1 to 12 carbon atoms, alkynyl groups having from 1 to 12 carbon atoms, aryl groups having from 1 to 12 carbon atoms, alkoxy groups having from 1 to 12 carbon atoms, aryloxy groups having from 1 to 12 carbon atoms, halogen atoms, alkylamino groups having from 1 to 12 carbon atoms, dialkylamino groups having from 1 to 12 carbon atoms, alkylamide or arylamide groups having from 1 to 12 carbon atoms, carbonyl groups, carboxyl groups, a cyano group, sulfonyl groups, thioalkyl groups having from 1 to 12 carbon atoms, and thioaryl groups having from 1 to 12 carbon atoms. $Z_{21}^-$ represents a monovalent anion. Specific examples include a halogen ion, a perchlorate ion, a hexafluorophosphate ion, a tetrafluoroborate ion, a sulfonate ion, a sulfinate ion, a thiosulfonate ion, and a sulfate ion. Of these, a perchlorate ion, a hexafluorophosphate ion, a tetrafluoroborate ion, a sulfonate ion, a sulfinate ion, and a carboxylate ion are preferred in view of stability and reactivity.

In the formula (RI-III), each of $R_{31}$, $R_{32}$ and $R_{33}$ independently represents an aryl group which has 20 or less carbon atoms and may have 1 to 6 substituents, an alkyl group, an alkenyl group, or an alkynyl group. Of these, the aryl

group is preferred in view of reactivity and stability. Preferred examples of the substituent include alkyl groups having from 1 to 12 carbon atoms, alkenyl groups having from 1 to 12 carbon atoms, alkynyl groups having from 1 to 12 carbon atoms, aryl groups having from 1 to 12 carbon atoms, alkoxy groups having from 1 to 12 carbon atoms, aryloxy groups having from 1 to 12 carbon atoms, halogen atoms, alkylamino groups having from 1 to 12 carbon atoms, dialkylamino groups having from 1 to 12 carbon atoms, alkylamide or arylamide groups having from 1 to 12 carbon atoms, carbonyl groups, carboxyl groups, a cyano group, sulfonyl groups, thioalkyl groups having from I to 12 carbon atoms, and thioaryl groups having from 1 to 12 carbon atoms. $Z_{31}^-$ represents a monovalent anion. Specific examples include a halogen ion, a perchlorate ion, a hexafluorophosphate ion, a tetrafluoroborate ion, a sulfonate ion, a sulfinate ion, a thiosulfonate ion, and a sulfate ion. Of these, a perchlorate ion, a hexafluorophosphate ion, a tetrafluoroborate ion, a sulfonate ion, a sulfinate ion, and a carboxylate ion are preferred in view of stability and reactivity, of which a carboxylate ion described in Japanese Patent Laid-Open No. 2001-343742 is more preferred, with a carboxylate ion described in Japanese Patent Laid-Open No. 2002-148790 being especially preferred.

The onium salt is especially preferred when used in combination with an IR absorbing agent having an absorption maximum in a wavelength range of from 750 to 1400 nm.

In addition, polymerization initiators described in Japanese Patent Laid-Open No. 2007-171406, Japanese Patent Laid-Open No. 2007-206216, Japanese Patent Laid-Open No. 2007-206217, Japanese Patent Laid-Open No. 2007-225701, Japanese Patent Laid-Open No. 2007-225702, Japanese Patent Laid-Open No. 2007-316582, and Japanese Patent Laid-Open No. 2007-328243 are preferred as another polymerization initiator.

In the invention, the polymerization initiators are preferably used either singly or in combination of two or more thereof.

The amount of the polymerization initiator in the photosensitive layer in the invention is preferably from 0.01 to 20 mass%, more preferably from 0.1 to 15 mass%, still more preferably from 1.0 to 10 mass%, each based on the mass of a total solid content of the photosensitive layer.

(Sensitizing dye)

The photosensitive layer of the invention preferably contains a sensitizing dye. High sensitivity lithographic printing plates for a 405 nm violet laser, a 532 nm green laser, and a 803 nm IR laser ordinarily used in this industry can be provided, respectively, by adding for example a sensitizing dye having an absorption maximum at from 300 to 450 nm, a sensitizing dye having an absorption maximum at from 500 to 600 nm and an IR absorbing agent having an absorption maximum at from 750 to 1,400 nm to the photosensitive layer.

First, the sensitizing dye having an absorption maximum in a wavelength range of from 350 to 450 nm is described below. Examples of such a sensitizing dye include merocyanine dyes, benzopyranes, coumarins, aromatic ketones, and anthracenes.

Of the sensitizing dyes having an absorption maximum in a wavelength range of from 360 nm to 450 nm, dyes represented by the following formula (IX) are more preferred from the standpoint of high sensitivity.

[Chem 29]

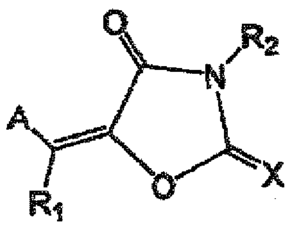

(IX)

(In formula (IX), A represents an aromatic cyclic group or heterocyclic group, which may have a substituent, X represents an oxygen atom, a sulfur atom, or N-($R_3$), and each of $R_1$, $R_2$ and $R_3$ independently represents a monovalent non-metallic atomic group, or A and $R_1$ or $R_2$ and $R_3$ may be coupled to each other to form an aliphatic or aromatic ring).

The formula (IX) will next be described in more detail. Each of $R_1$, $R_2$ and $R_3$ independently represents a monovalent non-metallic atomic group, preferably a substituted or unsubstituted alkyl group, a substituted or unsubstituted alkenyl group, a substituted or unsubstituted aryl group, a substituted or unsubstituted aromatic heterocyclic residue, a substituted or unsubstituted alkoxy group, a substituted or unsubstituted alkylthio group, a hydroxyl group, or a halogen atom.

Next, A in formula (IX) will be described. A represents an aromatic cyclic group or heterocyclic group which

may have a substituent. Specific examples of the aromatic cyclic group or heterocyclic group which may have a substituent include those described in $R_1$, $R_2$ and $R_3$ in the formula (IX).

As specific examples of such a sensitizing dye, compounds described in [0047] to [0053] of Japanese Patent Laid-Open No. 2007-58170 are preferably used.

Further, sensitizing dyes represented by the following formulas (V) to (VII) can also be used.

[Chem. 30]

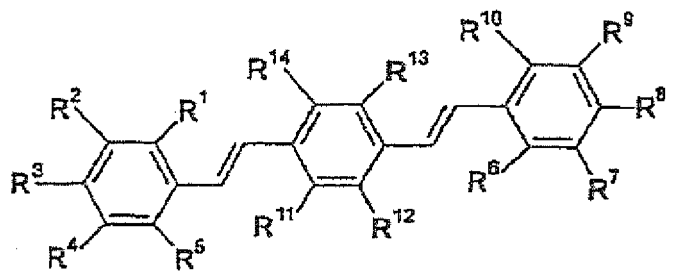

(V)

[Chem. 31]

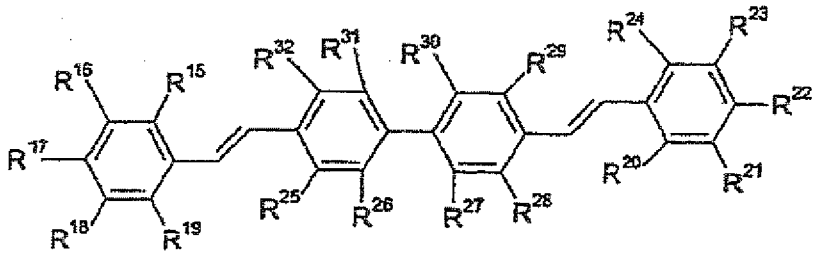

(VI)

In the formula (V), each of $R^1$ to $R^{14}$ independently represents a hydrogen atom, an alkyl group, an alkoxy group, a cyano group, or a halogen atom, with the proviso that at least one of $R^1$ to $R^{10}$ represents an alkoxy group having 2 or more carbon atoms.

In the formula (VI), each of $R^{15}$ to $R^{32}$ independently represents a hydrogen atom, an alkyl group, an alkoxy group, a cyano group, or a halogen atom, with the proviso that at least one of $R^{15}$ to $R^{24}$ represents an alkoxy group having two or more carbon atoms.

[Chem. 32]

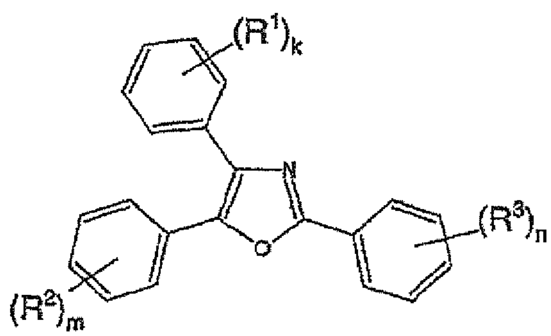

(VII)

In the formula (VII), each of $R^1$, $R^2$, and $R^3$ independently represents a halogen atom, an alkyl group, an aryl group, an aralkyl group, $-NR^4R^5$ group, or an $-OR^6$ group, in which each of $R^4$, $R^5$, and $R^6$ independently represents a hydrogen atom, an alkyl group, an aryl group, or an aralkyl group, and k, m, and n each stands for an integer from 0 to 5.

Sensitizing dyes described in Japanese Patent Laid-Open No. 2007-171406, Japanese Patent Laid-Open No. 2007-206216, Japanese Patent Laid-Open No. 2007-206217, Japanese Patent Laid-Open No. 2007-225701, Japanese

Patent Laid-Open No. 2007-225702, Japanese Patent Laid-Open No. 2007-316582, and Japanese Patent Laid-Open No. 2007-328243 are also preferred.

The amount of the sensitizing dye is preferably from 0.05 to 30 mass%, more preferably from 0.1 to 20 mass%, most preferably from 0.2 to 10 mass%, based on the total solid content of the photosensitive layer.

The sensitizing dye having an absorption maximum at from 750 to 1400 nm and preferably used in the invention will next described in detail.

It is presumed that the sensitizing dye used here is electron-excited with high sensitivity upon irradiation (exposure) of infrared laser, and electron transfer, energy transfer, or heat generation (photothermal conversion function) relating to such an electron excited state acts on a polymerization initiator present in the photosensitive layer to cause a chemical change of the polymerization initiator, thereby generating a radical. Anyway, it is especially preferred for plate making, in which direct drawing is performed with an infrared laser light having a wavelength of from 750 nm to 1400 nm, to add the sensitizing dye having an absorption maximum at 750 to 1400 nm and a higher image forming property can be achieved in comparison with a conventional lithographic printing plate precursor.

The IR absorbing agent is preferably a dye or pigment having an absorption maximum in a wavelength range of from 750 nm to 1400 nm.

As the dye, commercially available dyes and known dyes described in literatures, for example, Senryo Binran (compiled by The Society of Synthetic Organic Chemistry, Japan, published in 1970) can be used. Specific examples include azo dyes, metal complex salt azo dyes, pyrazolone azo dyes, naphthoquinone dyes, anthraquinone dyes, phthalocyanine dyes, carbonium dyes, quinoneimine dyes, methine dyes, cyanine dyes, squarylium dyes, pyrylium salts and metal thiolate complexes.

Of these dyes, cyanine dyes, squarylium dyes, pyrylium dyes, nickel thiolate complexes, and indolenine cyanine dyes are especially preferred. Further, cyanine dyes and indolenine cyanine dyes are more preferred. Cyanine dyes represented by the following formula (a) are especially preferred.

[Chem. 33]

Formula (a)

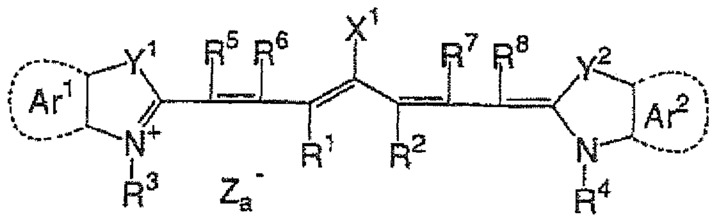

In the formula (a), $X^1$ represents a hydrogen atom, a halogen atom, $-NPh_2$, $X^2$-$L^1$, or a group shown below, in which $X^2$ represents an oxygen atom, a nitrogen atom, or a sulfur atom, and $L^1$ represents a hydrocarbon group having from 1 to 12 carbon atoms, an aromatic ring having a hetero atom, or a hetero-containing hydrocarbon group having from 1 to 12 carbon atoms. The hetero atom used herein means N, S, O, a halogen atom, or Se. $Xa^-$ has the same meaning as $Za^-$ which will be defined later. $R^a$ represents a substituent selected from a hydrogen atom, an alkyl group, an aryl group, a substituted or unsubstituted amino group, and a halogen atom.

[Chem. 34]

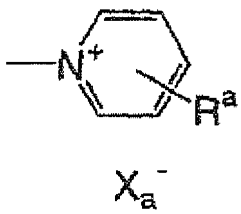

Each of $R^1$ and $R^2$ independently represents a hydrocarbon group having from 1 to 12 carbon atoms. From the standpoint of storage stability of a photosensitive layer coating solution, $R^1$ and $R^2$ each preferably represents a hydrocarbon group having two or more carbon atoms. Further, it is especially preferred that $R^1$ and $R^2$ are coupled to eacah other to form a 5-membered or 6-membered ring.

$Ar^1$ and $Ar^2$ may be the same or different and each represents an aromatic hydrocarbon group which may have

a substituent. Preferred examples of the aromatic hydrocarbon group include a benzene ring and a naphthalene ring. Preferred examples of the substituent include hydrocarbon groups having 12 or less carbon atoms, halogen atoms, and alkoxy groups having 12 or less carbon atoms. $Y^1$ and $Y^2$ may be the same or different and each represents a sulfur atom or a dialkylmethylene group having 12 or less carbon atoms. $R^3$ and $R^4$ may be the same or different and each represents a hydrocarbon group which has 20 or less carbon atoms and may have a substituent. Preferred examples of the substituent include alkoxy groups having 12 or less carbon atoms, carboxyl groups, and sulfo groups. $R^5$, $R^6$, $R^7$, and $R^8$ may be the same or different and each represents a hydrogen atom or a hydrocarbon group having 12 or less carbon atoms. From the standpoint of availability of raw materials, a hydrogen atom is preferred. $Za^-$ represents a counter anion. However, $Za^-$ is not necessary when the cyanine dye represented by formula (a) has an anionic substituent in the structure thereof and neutralization of charge is not necessary. From the standpoint of storage stability of the photosensitive layer coating solution, preferred examples of $Za^-$ include a halogen ion, a perchlorate ion, a tetrafluoroborate ion, a hexafluorophosphate ion, and a sulfonate ion, with a perchlorate ion, a hexafluorophosphate ion, and an arylsulfonate ion being especially preferred. As the counter ion, that not containing a halogen ion is particularly preferred.

Specific examples of the cyanine dye represented by formula (a) and preferably used include those described in the paragraphs [0017] to [0019] of Japanese Patent Laid-Open No. 2001-133969.

Especially preferred examples include specific indolenine cyanine dyes described in the Japanese Patent Laid-Open No. 2002-278057.

As the pigment, commercially available pigments and pigments described in Color Index (C.I.), Saishin Ganryo Binran (compiled by Pigment Technology Society of Japan and published in 1977), Saishin Ganryo Oyou Gijutsu (published by CMC Publishing in 1986) and Insatsu Ink Gijutsu (published by CMC Publishing in 1984) are usable.

Examples of the pigment include black pigments, yellow pigments, orange pigments, brown pigments, red pigments, purple pigments, blue pigments, green pigments, fluorescent pigments, metal powder pigments, and polymer-bonded dyes. Specific examples include insoluble azo pigments, azo lake pigments, condensed azo pigments, chelate azo pigments, phthalocyanine pigments, anthraquinone pigments, perylene and perynone pigments, thioindigo pigments, quinacridone pigments, dioxazine pigments, isoindolinone pigments, quinophthalone pigments, dying lake pigments, azine pigments, nitroso pigments, nitro pigments, natural pigments, fluorescent pigments, inorganic pigments, and carbon black. Of the pigments, carbon black is preferred.

These pigments may be used without surface treatment or may be used after surface treatment. For the surface treatment, there may be a method of coating the surface of a resin or wax, a method of attaching a surfactant, and a method of bonding a reactive substance (for example, a silane coupling agent, an epoxy compound, or polyisocyanate) to the pigment surface. These surface treatment methods are described in Kinzoku Sekken no Seishitsu to Oyo (Saiwai Shobo), Insatsu Ink Gijutsu (published by CMC Publishing in 1984), and Saishin Ganryo Oyo Gijutsu (published by CMC Publishing in 1986).

The pigment has a particle size of preferably from 0.01 $\mu$m to 10 $\mu$m, more preferably from 0.05 $\mu$m to 1 $\mu$m, especially preferably from 0.1 $\mu$m to 1 $\mu$m. Within this preferred range, excellent dispersion stability of the pigment in the photosensitive layer can be achieved and a uniform photosensitive layer can be obtained.

For dispersing the pigment, known dispersing techniques used in the production of ink or toner may be used. Examples of the dispersing machine include an ultrasonic dispersing machine, a sand mill, an attritor, a pearl mill, a super mill, a ball mill, an impeller, a disperser, a KD mill, a colloid mill, a dynatron, a three roll mill, and a pressure kneader. The dispersing machines are described in detail in Saishin Ganryo Oyo Gijutsu (published by CMC Publishing in 1986).

The IR absorbing agent may be added together with other components to the same layer or may be added to a layer provided separately.

The IR absorbing agent may be added in an amount of from 0.01 to 50 mass%, preferably from 0.1 to 10 mass% based on the total solid content constituting the photosensitive layer from the standpoint of uniformity in the photosensitive layer and durability of the photosensitive layer. It can be added in an amount of especially preferably from 0.5 to 10 mass% for dyes and from 0.1 to 10 mass% for the pigments.

<Microcapsule>

In the invention, the above-described photosensitive-layer constituting components and other constituent components, which will be described later, may be incorporated in the photosensitive layer by enclosing a portion of the constituting components in a microcapsule and adding the microcapsule to the photosensitive layer as described in, for example, Japanese Patent Laid-Open No. 2001-277740 and Japanese Patent Laid-Open No. 2001-277742. In this case, the constituent components may be incorporated inside and outside the microcapsule at any ratio.

For microencapsulating the constituent components of the photosensitive layer, known methods can be used. Examples of the production method of a microcapsule include, but not limited to, a method utilizing coacervation described in U.S. Pat. Nos. 2800457 and 2800458, a method utilizing interfacial polymerization described in U.S. Pat. No. 3287154,

Japanese Patent Publication Nos. Sho 38-19574 and Sho 42-446, a method utilizing polymer precipitation described in U.S. Pat. Nos. 3418250 and 3660304, a method using an isocyanate polyol wall material described in U.S. Pat. No. 3796669, a method using an isocyanate wall material described in U.S. Pat. No. 3914511, a method using a urea-formaldehyde or urea-formaldehyde-resorcinol wall-forming material described in U.S. Pat. Nos. 4001140, 4087376 and 4089802, a method using a wall material such as melamine-formaldehyde resin or hydroxy cellulose described in U.S. Pat. No. 4025445, an in situ method utilizing monomer polymerization described in Japanese Patent Publication Nos. Sho 36-9163 and Sho 51-9079, a spray drying method described in British Patent 930422 and U.S. Pat. No. 3111407, and an electrolytic dispersion cooling method described in British Patents 952807 and 967074.

The microcapsule wall preferably used in the invention has a three-dimensional crosslink and has a property of swelling with a solvent. From such a standpoint, the wall material of the microcapsule is preferably polyurea, polyurethane, polyester, polycarbonate, or polyamide, or a mixture thereof, more preferably polyurea or polyurethane. The above-described compound having a crosslinkable functional group such as ethylenically unsaturated bond, which can be introduced into the water soluble polymer, may be introduced into the microcapsule wall.

The average particle size of the microcapsule is preferably from 0.01 to 3.0 μm, more preferably from 0.05 to 2.0 μm, especially preferably from 0.10 to 1.0 μm. Within the above range, good resolution and good aging stability can be achieved.

<Other photosensitive layer components>

Various additives can be added to the photosensitive layer of the invention further if desired. Examples of the additive include a surfactant for enhancing the developability and improving the state of a coated surface, a hydrophilic polymer for improving the developability and dispersion stability of microcapsules, a coloring agent or print-out agent for visually distinguishing the image area from the non-image area, a polymerization inhibitor for preventing undesirable thermal polymerization of the radical polymerizable compound during production or storage of the photosensitive layer, a higher fatty acid derivative for preventing polymerization inhibition due to oxygen, fine inorganic particles for increasing strength of the cured film in the image area, a hydrophilic low molecular weight compound for improving the developability, a co-sensitizer or chain transfer agent for increasing sensitivity, and a plasticizer for improving plasticity. As these additives, known compounds are used. For example, compounds described in Japanese Patent Laid-Open No. 2007-171406, Japanese Patent Laid-Open No. 2007-206216, Japanese Patent Laid-Open No. 2007-206217, Japanese Patent Laid-Open No. 2007-225701, Japanese Patent Laid-Open No. 2007-225702, Japanese Patent Laid-Open No. 2007-316582, or Japanese Patent Laid-Open No. 2007-328243 are used.

As the compound acting as a chain transfer agent, for example, a group of compounds having, in the molecule thereof, SH, PH, SiH, or GeH is used. They can form radicals by donating hydrogen to low active radical species or by deprotonation after oxidation.

For the photosensitive layer of the invention, thiol compounds (such as 2-mercaptobenzimidazoles, 2-mercaptobenzothiazoles, 2-mercaptobenzoxazoles, 3-mercaptotriazoles, and 5-mercaptotetrazoles) can be preferably used as a chain transfer agent.

Of these, thiol compounds represented by the below-described formula (I) are especially preferred. Using these thiol compounds as a chain transfer agent makes it possible to produce a lithographic printing plate precursor featuring excellent storage stability, high sensitivity, and high runlength while avoiding an odor problem and a decrease in sensitivity due to evaporation from a photosensitive layer or diffusion into another layer.

[Chem. 35]

Formula (1)

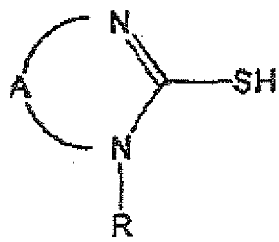

In the formula (1), R represents an alkyl group which may have a substituent or an aryl group which may have a substituent, A represents an atomic group forming a 5-membered or 6-membered heterocycle having a carbon atom

together with a N=C-N portion, and A may have a substituent further.

As the chain transfer agent, compounds represented by the following formula (IA) or (IB) are still more preferred.

[Chem. 36]

Formula (IA)

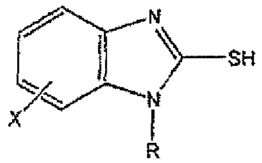

Formula (IB)

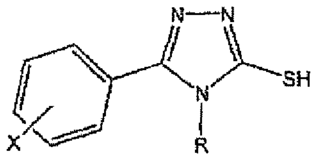

In the formulas (IA) and (IB), R represents an alkyl group which may have a substituent or an aryl group which may have a substituent, and X represents a halogen atom, an alkoxy group, an alkyl group which may have a substituent, or an aryl group which may have a substituent.

Specific examples of the compound represented by the formula (I) will next be shown, but the invention is not limited thereto.

[Chem. 37]

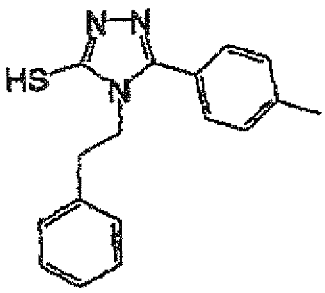

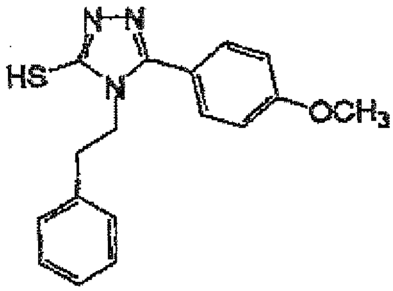

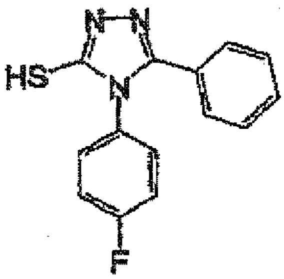

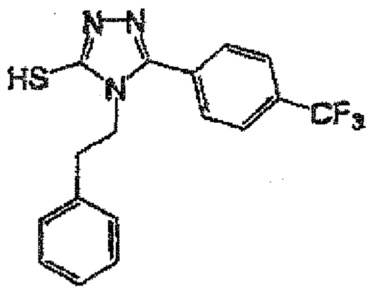

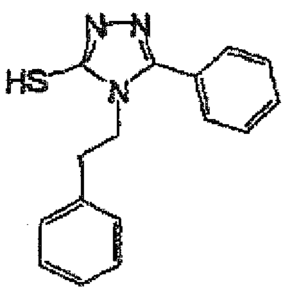

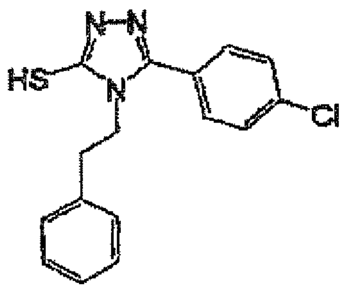

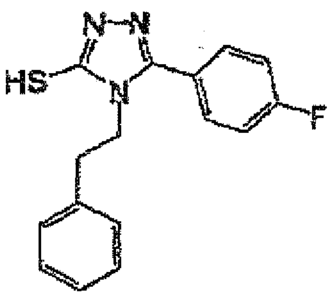

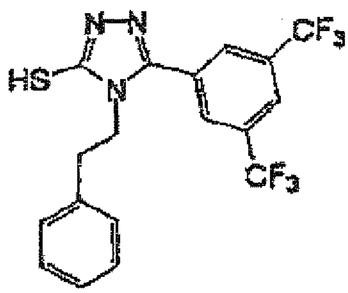

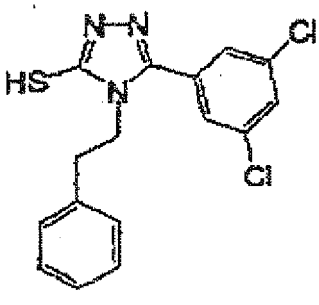

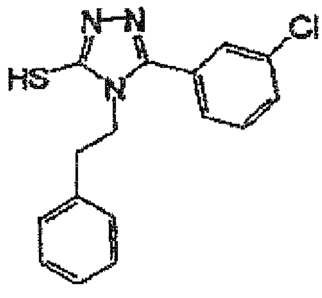

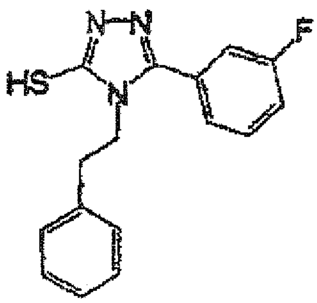

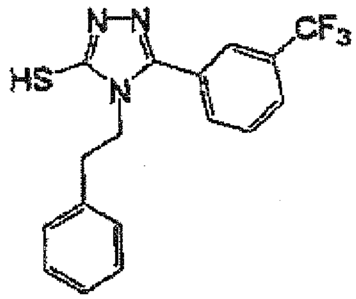

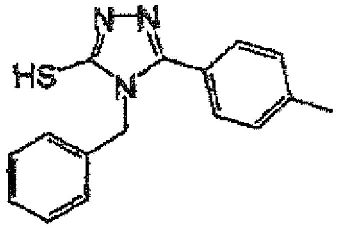

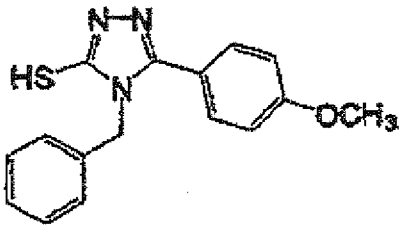

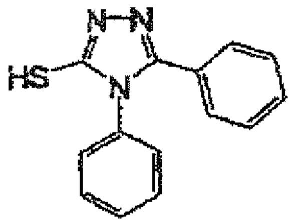

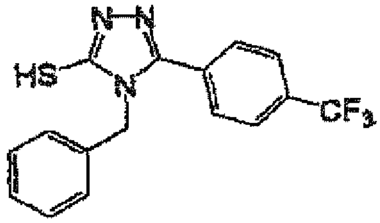

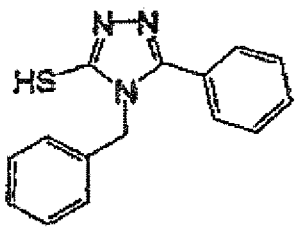

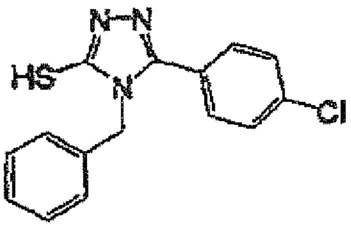

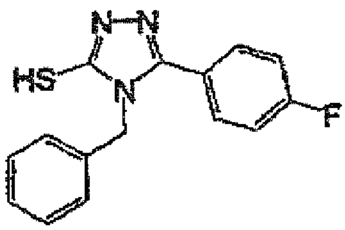

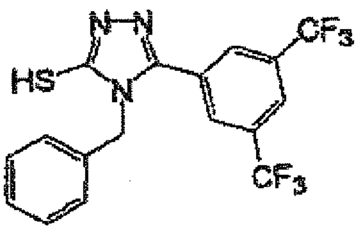

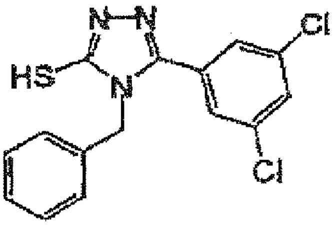

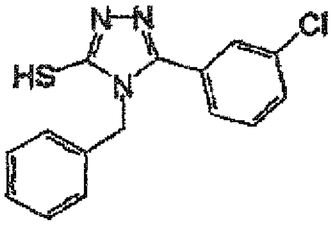

[Chem. 39]

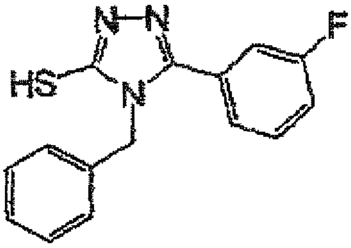
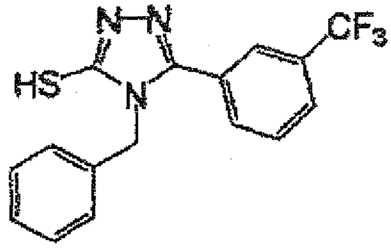
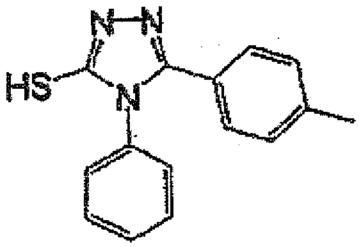
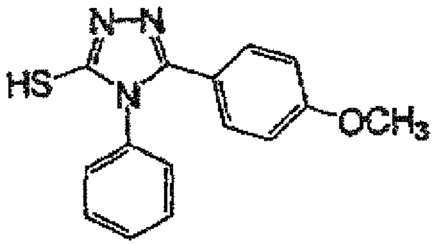
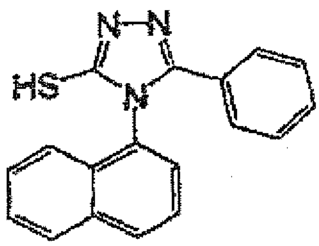
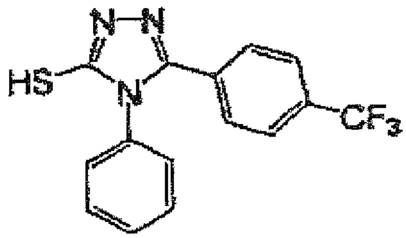
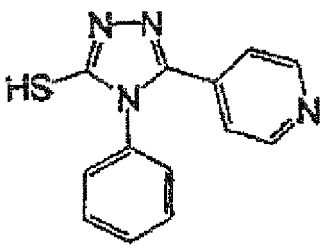
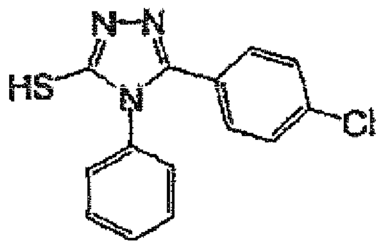
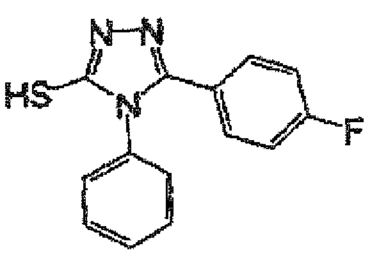
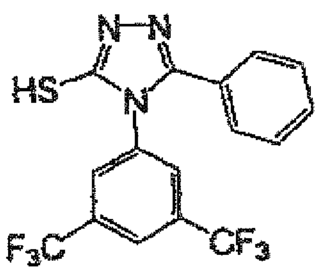

[Chem. 40]

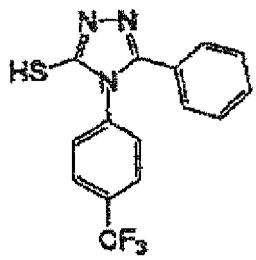
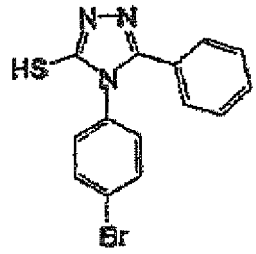
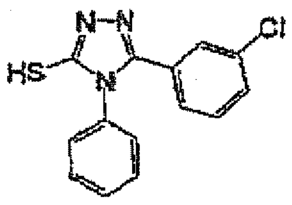
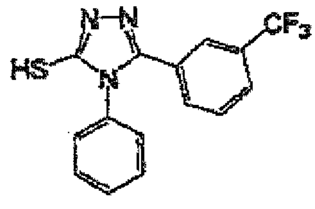
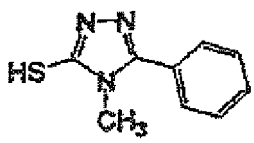
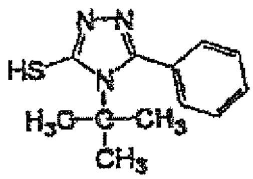
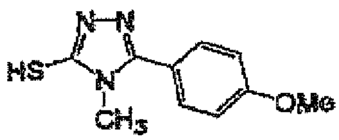
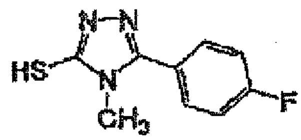
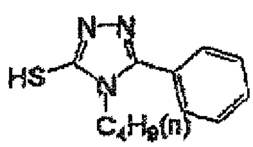
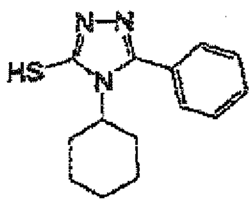
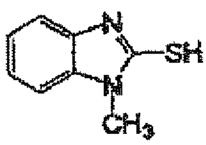
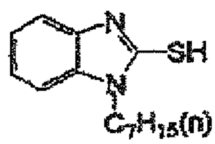
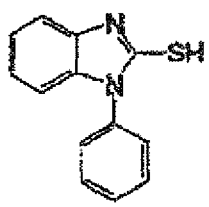
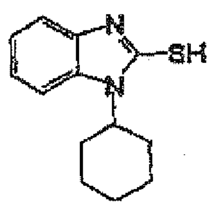

[Chem. 41]

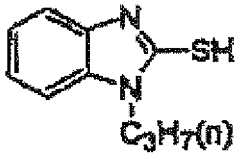

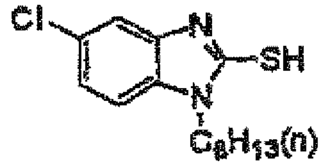

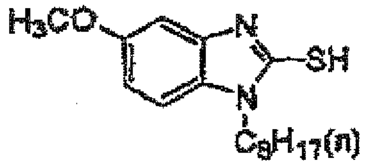

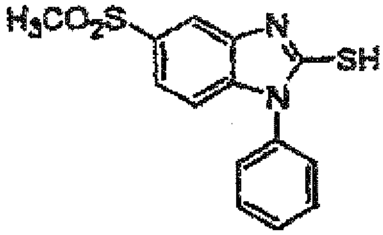

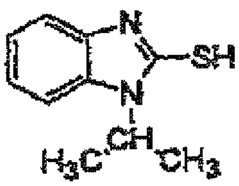

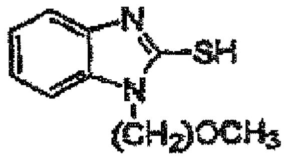

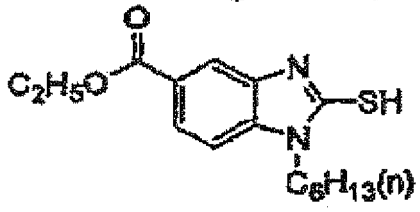

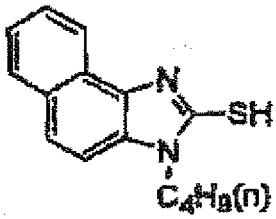

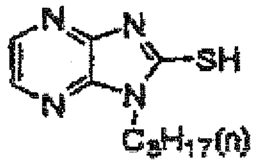

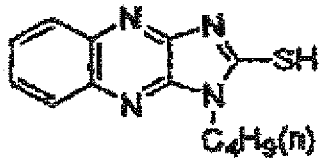

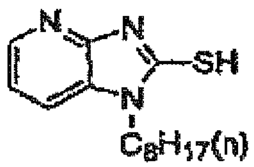

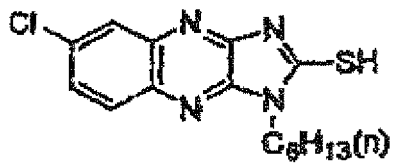

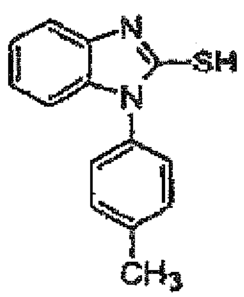

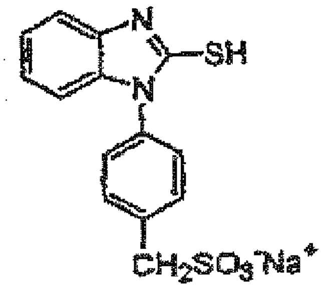

These thiol compounds are each used in an amount of preferably from 0.01 to 20 mass%, more preferably from 0.1 to 15 mass%, still more preferably from 1.0 to 10 mass% based on the total solid content, by mass, of the photosensitive layer.

<Formation of photosensitive layer>

The photosensitive layer of the invention is formed by applying a coating solution obtained by dispersing or dissolving the above-described necessary components in a solvent. Examples of the solvent used here include, but not limited to, ethylene dichloride, cyclohexanone, methyl ethyl ketone, methanol, ethanol, propanol, ethylene glycol monomethyl ether, 1-methoxy-2-propanol, 2-methoxyethyl acetate, 1-methoxy-2-propyl acetate, dimethoxyethane, methyl lactate, ethyl lactate, N,N-dimethylacetamide, N,N-dimethylformamide, tetramethylurea, N-methylpyrrolidone, dimethylsulfoxide, sulfolane, γ-butyrolactone, toluene, and water. These solvents may be used either singly or as a mixture. The solid content concentration of the coating solution is preferably from 1 to 50 mass%.

The photosensitive layer of the invention may also be formed by preparing a plurality of coating solutions obtained by dispersing or dissolving the above-described components, which may be varied or not, in the same solvent or in different solvents, respectively and repeating application and drying in plural times.

The application amount (solid content) of the photosensitive layer on a support obtained after application and drying varies depending on the intended use, but in general, it is preferably from 0.3 to 3.0 $g/m^2$. Within this range, good sensitivity and good film characteristics of the photosensitive layer can be achieved.

Various methods can be employed as the application method. Examples include bar coater coating, spin coating, spray coating, curtain coating, dip coating, air knife coating, blade coating, and roll coating.

<Protective layer>

The lithographic printing plate precursor of the invention is preferably equipped, on the photosensitive layer, with a protective layer (oxygen blocking layer) in order to block diffusion and penetration of oxygen that disturbs a polymerization reaction upon exposure. The protective layer to be used in the invention has preferably oxygen permeability (A) of $1.0 \leq (A) \leq 20$ ($mL/m^2 \cdot day$) at 25°C under one atmospheric pressure. When the oxygen permeability (A) is extremely low and is less than 1.0 ($mL/m^2 \cdot day$), problems such as undesirable polymerization reaction arising during the production or storage before image exposure and appearance of fog or dot gain at the time of image exposure. On the contrary, oxygen permeability (A) exceeding 20 ($mL/m^2 \cdot day$) causes a decrease in sensitivity. The oxygen permeability (A) is more preferably $1.5 \leq (A) \leq 12$ ($mL/m^2 \cdot day$), still more preferably $2.0 \leq (A) \leq 10.0$ ($mL/m^2 \cdot day$). In addition to the above-described oxygen permeability, the protective layer is desired to show excellent adhesion to the photosensitive layer and to be easily removable during a development step after exposure without substantially hindering the transmission of light used for exposure. Contrivances on the protective layer have been conventionally made and they are described in detail in U.S. Pat. No. 3,458,311 and Japanese Patent Publication No. Sho 55-49729.

As the material usable for the protective layer, water soluble polymer compounds relatively excellent in crystallinity are preferred. Specific examples of the water soluble polymer include polyvinyl alcohol, vinyl alcohol/vinyl phthalate copolymer, vinyl acetate/vinyl alcohol/vinyl phthalate copolymer, vinyl acetate/crotonic acid copolymer, polyvinylpyrrolidone, acidic celluloses, gelatin, gum arabic, polyacrylic acid, and polyacrylamide. These compounds may be used either singly or as a mixture. Of these, using polyvinyl alcohol as a main component gives the best results to the fundamental characteristics, for example, oxygen blocking property and removability of the protective layer by development.

Polyvinyl alcohol to be used for the protective layer may be partially substituted with ester, ether or acetal insofar as it contains an unsubstituted vinyl alcohol unit in order to provide the protective layer with the necessary oxygen blocking property and water solubility. Also, a portion of polyvinyl alcohol may have another copolymer component. Specific examples of the polyvinyl alcohol include those having a hydrolysis degree of from 71 to 100 mol% and polymerization repeating units of from 300 to 2400. Specific examples include "PVA-105", "PVA-110", "PVA-117", "PVA-117H", "PVA-120", "PVA-124", "PVA-124H", "PVA-CS", "PVA-CST", "PVA-HC", "PVA-203", "PVA-204", "PVA-205", "PVA-210", "PVA-217", "PVA-220", "PVA-224", "PVA-217EE", "PVA-217E", "PVA-220E", "PVA-224E", "PVA405", "PVA-420", "PVA-613", and "L-8", each produced by Kuraray Co., Ltd. They can be used either singly or as a mixture. In a preferred mode, the content of polyvinyl alcohol in the protective layer is from 20 to 95 mass%, more preferably from 30 to 90 mass%.

Also, known modified polyvinyl alcohol can be preferably used. Examples include polyvinyl alcohols of various polymerization degrees having at random various hydrophilic modified sites, for example, a site modified with an anion such as carboxyl group or sulfo group, a site modified with a cation such as amino group or ammonium group, a silanol-modified site, or a thiol-modified site, and polyvinyl alcohols of various polymerization degrees having at the terminal of the polymer various modified sites, for example, the above-described anion-modified site, cation-modified site, silanol-modified site, or thiol-modified site, an alkoxyl-modified site, a sulfide-modified site, a site modified with an ester between vinyl alcohol and an organic acid, a site modified with an ester between the above-described anion-modified site and an alcohol, or an epoxy-modified site.

As a component used as a mixture with polyvinyl alcohol, polyvinyl pyrrolidone or a modified product thereof is preferred from the standpoint of the oxygen-blocking property and removability of the protective layer by development.

The content of it in the protective layer is from 3.5 to 80 mass%, preferably from 10 to 60 mass%, more preferably from 15 to 30 mass%.

The components of the protective layer (selection of PVA and use of additives), coating amount, and the like are determined in consideration of fogging property, adhesion, and scratch resistance as well as the oxygen-blocking property and removability of the protective layer by development. In general, as the rate of hydrolysis of the PVA used (the unsubstituted vinyl alcohol unit content in the protective layer) is higher and the protective layer is thicker, the oxygen-blocking property becomes higher, which is advantageous in sensitivity. The molecular weight of the (co)polymer, for example, polyvinyl alcohol (PVA) is from 2,000 to 10,000,000, preferably from 20,000 to 3,000,000.

As another composition of the protective layer, glycerin, dipropylene glycol, or the like can be added to the (co)polymer in an amount of several mass% to provide flexibility. Further, an anionic surfactant such as sodium alkyl sulfate or sodium alkyl sulfonate, an amphoteric surfactant such as alkylaminocarboxylate and alkylaminodicarboxylate, or a nonionic surfactant such as polyoxyethylene alkyl phenyl ether can be added to the (co)polymer in an amount of several mass%.

The adhesion of the protective layer to an image area and scratch resistance are also extremely important in view of handling of the printing plate. Described specifically, when a hydrophilic layer composed of a water soluble polymer is stacked on an oleophilic photosensitive layer, peeling of the layer is liable to occur due to insufficient adhesion, and the peeled portion causes defects such as curing failure due to inhibition of polymerization by oxygen. Various proposals have been made for improving the adhesion between these two layers. It is described, for example, in U.S. patent application Ser. Nos. 292,501 and 44,563 that sufficient adhesion can be achieved by mixing from 20 to 60 mass% of an acrylic emulsion or a water-insoluble vinylpyrrolidone/vinyl acetate copolymer with a hydrophilic polymer composed mainly of polyvinyl alcohol and stacking the resulting mixture on the photosensitive layer. Any of these known techniques can be applied to the protective layer of the invention. Application methods of the protective layer are described in detail, for example, in U.S. Pat. No. 3,458,311 and Japanese Patent Publication No. Sho 55-49729.

Further, it is also preferred to incorporate an inorganic laminar compound into the protective layer of the lithographic printing plate precursor of the invention with a purpose of improving the oxygen blocking property and surface protecting property of the photosensitive layer. The inorganic laminar compound used here is a particle having a thin tabular shape. Examples of it include a group of mica such as natural mica or synthetic mica represented by the following formula:

$$A(B,C)_{2\text{-}5}D_4O_{10}(OH,F,O)_2,$$

(wherein A represents any one of K, Na and Ca, B and C each represents any one of Fe(II), Fe(III), Mn, Al, Mg, and V, and D represents Si or Al) or synthetic mica, talc represented by the following formula: $3MgO\cdot 4SiO\cdot H_2O$, teniolite, montmorillonite, saponite, hectoliter, and zirconium phosphate.

Of the above-described inorganic laminar compounds, fluorine-based swellable synthetic mica, which is a synthetic inorganic laminar compound, is particularly useful in the invention.

The aspect ratio of the inorganic laminar compound of the invention is preferably 20 or greater, more preferably 100 or greater, especially preferably 200 or greater. The aspect ratio of a particle is a ratio of the major axis to the thickness and can be determined, for example, from a projection view of the microphotograph of the particle. The greater the aspect ratio, the greater the effect produced.

With regard to the particle size of the inorganic laminar compound to be used in the invention, an average major axis is from 0.3 to 20 μm, preferably from 0.5 to 10 μm, especially preferably from 1 to 5 μm. An average thickness of the particle is 0.1 μm or less, preferably 0.05 μm or less, especially preferably 0.01 μm or less. For example, in the swellable synthetic mica that is a typical compound of the inorganic laminar compounds, thickness is approximately from 1 to 50 nm and face size is approximately from 1 to 20 μm

When particles of such an inorganic laminar compound having a large aspect ratio are incorporated in the protective layer, the film strength is improved and the permeation of oxygen and moisture can be effectively prevented so that deterioration of the protective layer due to deformation or the like can be restrained. Even when the lithographic printing plate precursor is stored under a high humidity condition for a long period of time, it is free from deterioration of the image forming property due to a moisture change and excellent storage stability can be ensured.

The content of the inorganic laminar compound in the protective layer is preferably from 5/1 to 1/100, in terms of mass ratio, of the amount of binder used in the protective layer. When a plurality of inorganic laminar compounds is used in combination, the total amount of the inorganic laminar compounds preferably fulfills the above-described mass ratio.

As a dispersing method of the inorganic laminar compound added to the protective layer, methods described in Japanese Patent Laid-Open No. 2007-171406, Japanese Patent Laid-Open No. 2007-206216, Japanese Patent Laid-Open No. 2007-206217, Japanese Patent Laid-Open No. 2007-225701, Japanese Patent Laid-Open No. 2007-225702, Japanese Patent Laid-Open No. 2007-316582, and Japanese Patent Laid-Open No. 2007-328243 are used.

The coating weight of the protective layer is preferably in a range of from 0.05 to 10 g/m$^2$ in terms of the coating weight after drying. When the protective layer contains the inorganic laminar compound, it is more preferably in a range of from 0.1 to 5 g/m$^2$, while when the protective layer does not contain the inorganic laminar compound, it is more preferably in a range of from 0.5 to 5 g/m$^2$.

The support to be used in the lithographic printing plate precursor of the invention is not particularly limited insofar as it is a dimensionally stable plate-like hydrophilic support. Examples of the support include paper, paper laminated with plastic (such as polyethylene, polypropylene, or polystyrene), a metal plate (such as aluminum, zinc, or copper), a plastic film (such as cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate, or polyvinyl acetal), and paper or a plastic film laminated or deposited with the metal described above. Preferred supports include a polyester film and an aluminum plate. Of these, the aluminum plate is preferred because of good dimensional stability and relatively low cost.

The aluminum plate may be a pure aluminum plate, an alloy plate containing aluminum as a main component and containing a trace of elements different therefrom, or a thin film of aluminum or aluminum alloy laminated with plastic. The element contained in the aluminum alloy and different from aluminum is silicon, iron, manganese, copper, magnesium, chromium, zinc, bismuth, nickel, titanium, or the like. The content of it in the aluminum alloy is preferably 10 mass% or less. Although a pure aluminum plate is preferred in the invention, completely pure aluminum is difficult to be produced in view of the refining technique so that the aluminum plate may contain a slight amount of the element different from aluminum. The composition of the aluminum plate is not specified and conventionally known materials can be used as needed.

The thickness of the support is preferably from 0.1 to 0.6 mm, more preferably from 0.15 to 0.4 mm, still more preferably from 0.2 to 0.3 mm.

The aluminum plate is preferably subjected to surface treatment such as roughening treatment or anodizing treatment prior to its use. The surface treatment facilitates improvement in the hydrophilicity and securement of adhesion between the photosensitive layer and the support. Prior to the roughening treatment of the aluminum plate, a degreasing treatment with a surfactant, an organic solvent, an aqueous alkaline solution, or the like is conducted for removing a rolling oil from the surface of the aluminum plate if desired.

The roughening treatment of the surface of the aluminum plate is conducted by various methods. Examples of it include mechanical roughening treatment, electrochemical roughening treatment (roughening treatment of electrochemically dissolving the surface), and chemical roughening treatment (roughening treatment of chemically dissolving the surface selectively).

As the method of the mechanical roughening treatment, a known method such as ball polishing method, a brush polishing method, a blast polishing method, or a buff polishing method can be used.

Examples of the electrochemical roughening treatment method include a method of roughening by applying an alternating or direct current in an electrolytic solution containing an acid such as hydrochloric acid or nitric acid. A method of using a mixed acid as described in Japanese Patent Laid-Open No. 54-63902 can also be used.

The surface roughened aluminum plate is then subjected to an alkali etching treatment with an aqueous solution of potassium hydroxide, sodium hydroxide, or the like if necessary and is further subjected to a neutralizing treatment, followed by anodizing treatment in order to enhance the abrasion resistance, if desired.

As the electrolyte to be used for the anodizing treatment of the aluminum plate, various electrolytes capable of forming a porous oxide film can be used. Sulfuric acid, hydrochloric acid, oxalic acid, or chromic acid, or a mixed acid thereof is ordinarily used. The concentration of the electrolyte can be determined as needed, depending on the kind of the electrolyte.

Since the conditions of the anodizing treatment vary, depending on the electrolyte used, they cannot be specified generally. It is ordinarily conducted under the following conditions: electrolyte concentration from 1 to 80 mass% in the solution, liquid temperature of from 5 to 70°C, current density of from 5 to 60 A/dm$^2$, voltage of from 1 to 100 V, and electrolysis time of from 10 seconds to 5 minutes. The amount of the anodized film thus formed is preferably from 1.0 to 5.0 g/m$^2$, more preferably from 1.5 to 4.0 g/m$^2$. Within the above-described range, good runlength and good scratch resistance in the non-image area of a lithographic printing plate can be achieved.

As the support to be used in the invention, such a surface-treated substrate having an anodized film may be used as is, but in order to further improve adhesion to a layer provided thereon, hydrophilicity, stain resistance, heat insulating property or the like, a surface treatment selected as needed from an enlarging treatment and sealing treatment of micropores of the anodized film described in Japanese Patent Laid-Open No. 2001-253181 and Japanese Patent Laid-Open No. 2001-322365, or a surface hydrophilizing treatment by immersing the substrate in an aqueous solution containing a hydrophilic compound may be conducted. It is needless to say that the enlarging treatment or sealing treatment is not limited to that described in the above-described documents and any conventionally known method may be employed.

As the sealing treatment, it is also possible to carry out, as well as a sealing treatment with steam, a sealing

treatment with an aqueous solution containing an inorganic fluorine compound such as treatment with fluorozirconic acid alone or treatment with sodium fluoride, a sealing treatment with steam having lithium chloride added thereto, or a sealing treatment with hot water.

Of these, the sealing treatment with an aqueous solution containing an inorganic fluorine compound, the sealing treatment with steam, and the sealing treatment with hot water are preferred.

The hydrophilizing treatment includes an alkali metal silicate method as described in U.S. Pat. Nos. 2,714,066, 3,181,461, 3,280,734, and 3,902,734. In this method, the support is dipped or electrolyzed in an aqueous solution of sodium silicate or the like. Additional examples include a method of treating with potassium fluorozirconate described in Japanese Patent Publication No. Sho 36-22063 and a method of treating with polyvinylphosphonic acid described in U.S. Pat. Nos. 3,276,868, 4,153,461, and 4,689,272.

When a support having a surface having insufficient hydrophilicity such as polyester film is used as the support of the invention, it is desired to make the surface hydrophilic by applying a hydrophilic layer thereon. Preferred examples of the hydrophilic layer include a hydrophilic layer, described in Japanese Patent Laid-Open No. 2001-199175, formed by applying a coating solution containing a colloid of an oxide or hydroxide of at least one element selected from beryllium, magnesium, aluminum, silicon, titanium, boron, germanium, tin, zirconium, iron, vanadium, antimony, and transition metals; a hydrophilic layer, described in Japanese Patent Laid-Open No. 2002-79772, having an organic hydrophilic matrix available by crosslinking or pseudo-crosslinking of an organic hydrophilic polymer; a hydrophilic layer having an inorganic hydrophilic matrix available by sol-gel conversion comprising hydrolysis and condensation reaction of a polyalkoxysilane, titanate, zirconate or aluminate; and a hydrophilic layer composed of an inorganic thin film having a metal-oxide-containing surface. Of these, the hydrophilic layer formed by applying a coating solution containing a colloid of an oxide or hydroxide of silicon is preferred.

When a polyester film or the like is used as the support of the invention, it is preferred to provide an antistatic layer on the side of the hydrophilic layer, on the opposite side, or on both sides thereof. When the antistatic layer is provided between the support and the hydrophilic layer, it also contributes to improve the adhesion with the hydrophilic layer. As the antistatic layer, a polymer layer, described in Japanese Patent Laid-Open No. 2002-79772, having metal oxide fine particles or matting agent dispersed therein can be used.

The support preferably has a center line average roughness of from 0.10 to 1.2 $\mu$m. Within the above-described range, good adhesion to the photosensitive layer, good runlength, and good stain resistance can be achieved.

The color density of the support is preferably from 0.15 to 0.65 in terms of the reflection density. Within the above-described range, halation at the image exposure can be prevented, leading to a good image forming property and good plate checkability after development.

[Undercoat layer]

In the lithographic printing plate precursor of the invention, a compound containing a polymerizable group is preferably applied as an undercoat layer on the support. When the undercoat layer is used, the photosensitive layer is provided on the undercoat layer. The undercoat layer reinforces adhesion between the support and the photosensitive layer at the exposed portion, while it facilitates peeling of the photosensitive layer from the support in the unexposed portion, thereby improving developability.

Specific preferred examples of the compound for the undercoat layer include silane coupling agents, described in Japanese Patent Laid-Open No. Hei 10-282679, having an addition polymerizable ethylenic double bond reactive group and phosphorus compounds, described in Japanese Patent Laid-Open No. Hei 2-304441, having an ethylenic double bond reactive group. Especially preferred examples of the compounds include compounds having a polymerizable group such as methacryl group or allyl group and a support adsorptive group such as sulfonic acid group, phosphoric acid group, or phosphate ester. Compounds having, in addition to the polymerizable group and the support adsorptive group, a hydrophilicity-imparting group such as ethylene oxide group are also preferred.

The coating weight (solid content) for forming the undercoat layer is preferably from 0.1 to 100 mg/m$^2$, more preferably from 1 to 30 mg/m$^2$.

[Backcoat layer]

After the surface treatment of the support or formation of the undercoat layer, a backcoat layer may be provided on the backside of the support as needed.

Preferred examples of the backcoat layer include a coating layer composed of an organic polymer compound described in Japanese Patent Laid-Open No. Hei 5-45885 and a coating layer, described in Japanese Patent Laid-Open No. Hei 6-35174, composed of a metal oxide available by hydrolysis and polycondensation of an organic metal compound or an inorganic metal compound. Of these, using an alkoxy compound of silicon such a $Si(OCH_3)_4$, $Si(OC_2H_5)_4$, $Si(OC_3H_7)_4$, or $Si(OC_4H_9)_4$ is preferred because the raw material is inexpensive and easily available.

[Plate Making Method]

A lithographic printing plate is made by subjecting the lithographic printing plate precursor of the invention to image-wise exposure and development. The development is performed, for example, by (1) a method of developing with an alkali developer (having a pH exceeding 10), (2) a method of developing with a developer having a pH from 2 to 10, or (3) a method of developing (on-press development) while supplying a fountain solution and/or ink on a printing machine. In the invention, the method of developing with a developer having a pH from 2 to 10 is employed.

Specifically, immediately after simultaneously removing the protective layer and the photosensitive layer of the unexposed portion with a developer having a pH from 2 to 10, the lithographic printing plate precursor of the invention is mounted on a printing machine to conduct printing. The conventional developing step with the alkali developer (1) comprises removal of the protective layer in a preliminary water washing step, development with an alkali, removal of the alkali in a post water washing step, gumming in a gumming step, and drying in a drying step. In the invention, on the other hand, the developer contains a water soluble polymer compound and development and gumming are carried out at the same time. Accordingly, the post water washing step is not required and the drying step is preferably conducted after development and gumming are performed in one bath. It is more preferred to carry out removal of the protective layer, development, and gumming at the same time without carrying out the preliminary water washing step. It is also preferred to carry out drying after development and gumming and then removal of an excess developer by using a squeeze roller. The photosensitive lithographic printing plate precursor of the invention is developed in the conventional manner at a temperature of from about 0 to 60°C, preferably from about 15°C to 40°C, for example, by immersing the photosensitive lithographic printing plate precursor, which has been subjected to exposure treatment, in a developer and rubbing it with a brush.

Such development by using an automatic development processor is advantageous because no measure against development scum derived from the protective layer/photosensitive layer, which will otherwise appear in the case of the on-press development, is necessary.

The developer to be used in the invention is an aqueous solution having a pH from 2 to 10. The developer is water or an aqueous solution composed mainly of water (containing 60 mass% or more water). An aqueous solution having the same composition as conventionally known fountain solution, is preferred. An aqueous solution containing both a surfactant and a water soluble polymer compound is used. The pH of the developer is preferably from 3 to 8, more preferably from 4 to 7.

When an acidic to neutral developer is used, the developer preferably contains either an organic acid or an inorganic acid. By incorporating the organic acid or inorganic acid in the developer, the developability at the time of plate making can be improved and the appearance of stain in the non-image area of a printing plate thus made can be prevented.

Examples of the nonionic surfactant to be used in the invention include polyethylene glycol type higher alcohol ethylene oxide adducts, alkylphenol ethylene oxide adducts, fatty acid ethylene oxide adducts, polyol fatty acid ester ethylene oxide adducts, higher alkylamine ethylene oxide adducts, fatty acid amide ethylene oxide adducts, ethylene oxide adducts of fat or oil, polypropylene glycol ethylene oxide adducts, dimethylsiloxane-ethylene oxide block copolymers, dimethylsiloxane-(propylene oxide-ethylene oxide) block copolymers, fatty acid esters of polyol type glycerol, fatty acid esters of pentaerythritol, fatty acid esters of sorbitol and sorbitan, fatty acid esters of sucrose, alkyl ethers of polyols, and fatty acid amides of alkanolamines.

These nonionic surfactants may be used either singly or as a mixture of two or more. In the invention, ethylene oxide adducts of sorbitol and/or sorbitan fatty acid esters, polypropylene glycol ethylene oxide adducts, dimethylsiloxane-ethylene oxide block copolymers, dimethylsiloxane-(propylene oxide-ethylene oxide) block copolymers, and fatty acid esters of polyols are more preferred.

As the nonionic surfactant, nonionic aromatic ether surfactants represented by the following formula (1) are especially preferred.

$$X\text{-}Y\text{-}O\text{-}(A)_n\text{-}(B)_m\text{-}H \qquad (1)$$

(wherein, X represents an aromatic group which may have a substituent, Y represents a single bond or an alkylene group having from 1 to 10 carbon atoms, A and B may be groups different from each other and represent either one of $-CH_2CH_2O-$ or $-CH_2CH(CH_3)O-$, and n and m each stands for 0 or an integer from 1 to 100, with the proviso that n and m do not stand for 0 at the same time and when either one of n and m is 0, the other one of n and m is not 1).

In the above formula, examples of the aromatic group represented by X include a phenyl group, a naphthyl group, and an anthranyl group. These aromatic groups may have a substituent. Examples of the substituent include organic groups having from 1 to 100 carbon atoms. As the organic group, all the organic groups described relating to the below-described formulas (1-A) and/or (1-B) can be given. When the surfactant has both A and B, it may be either a random or block copolymer.

More specifically, these compounds include compounds represented by the following formula (1-A) or (1-B).

[Chem. 42]

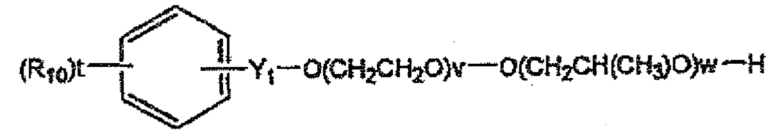

(1-A)

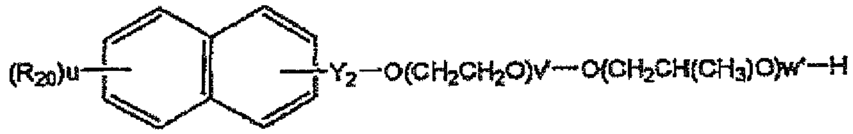

(1-B)

(In the above formulas, $R_{10}$ and $R_{20}$ each represents a hydrogen atom or an organic group having from 1 to 100 carbon atoms; t and u each stands for 1 or 2; $Y_1$ and $Y_2$ each represents a single bond or an alkylene group having from 1 to 10 carbon atoms; v and w each stands for 0 or an integer from 1 to 100, with the proviso that v and w do not stand for 0 at the same time and when either one of v and w is 0, the other one of v and w is not 1; v' and w' each stands for 0 or an integer from 1 to 100, with the proviso that v' and w' do not stands for 0 at the same time and when either one of v' and w' is 0, the other one of v' and w' is not 1).

When t stands for 2 and $R_{10}$ represents an organic group having from 1 to 100 carbon atoms, $R_{10}$s may be the same or different and may be coupled to form a ring, and when u stands for 2 and $R_{20}$ represents an organic group having from 1 to 100 carbon atoms, $R_{20}$s may be the same or different and may be coupled to form a ring.

Specific examples of the organic group having from 1 to 100 carbon atoms include saturated or unsaturated, linear or branched aliphatic hydrocarbon groups and aromatic hydrocarbon groups such as alkyl groups, alkenyl groups, alkynyl groups, aryl groups, aralkyl groups and in addition, alkoxy groups, aryloxy groups, N-alkylamino groups, N,N-dialkylamino groups, N-arylamino groups, N,N-diarylamino groups, N-alkyl-N-arylamino groups, acyloxy groups, carbamoyloxy groups, N-alkylcarbamoyloxy groups, N-arylcarbamoyloxy groups, N,N-dialkylcarbamoyloxy groups, N,N-diarylcarbamoyloxy groups, N-alkyl-N-arylcarbamoyloxy groups, acylamino groups, N-alkylacylamino groups, N-arylacylamino groups, acyl groups, alkoxycarbonylamino groups, alkoxycarbonyl groups, aryloxycarbonyl groups, carbamoyl groups, N-alkylcarbamoyl groups, N,N-dialkylcarbamoyl. groups, N-arylcarbamoyl groups, N,N-diarylcarbamoyl groups, N-alkyl-N-arylcarbamoyl groups, polyoxyalkylene chains, and the above exemplified organic groups to which a polyoxyalkylene chain has been bound. The alkyl groups may be either linear or branched.

Preferred examples of $R_{10}$ or $R_{20}$ include a hydrogen atom, linear or branched alkyl groups having from 1 to 10 carbon atoms, alkoxy groups having from 1 to 10 carbon atoms, alkoxycarbonyl groups, N-alkylamino groups, N,N-dialkylamino groups, N-alkylcarbamoyl groups, acyloxy groups, and acylamino groups, polyoxyalkylene chains having from about 5 to 20 repeating units, aryl group having from 6 to 20 carbon atoms, and aryl groups to which a polyoxyalkylene chain having from about 5 to 20 repeating units has been bound.

In the compound represented by the formula (1-A) or (1-B), the number of repeating units in the polyoxyethylene chain is preferably from 3 to 50, more preferably from 5 to 30. The number of repeating units in the polyoxypropylene chain is preferably from 0 to 10, more preferably from 0 to 5. The compound may be either a random or block copolymer having polyoxyethylene segments and polyoxypropylene segments.

Examples of the compound represented by the formula (1-A) include polyoxyethylene phenyl ether, polyoxyethylene methyl phenyl ether, polyoxyethylene octyl phenyl ether, and polyoxyethylene nonyl phenyl ether.

Examples of the compound represented by the formula (1-B) include polyoxyethylene naphthyl ether, polyoxyethylene methyl naphthyl ether, polyoxyethylene octyl naphthyl ether, and polyoxyethylene nonyl naphthyl ether.

Further, the nonionic surfactant to be used in the developer in the invention has an HLB (Hydrophile-Lipophile Balance) value of preferably 6 or greater, more preferably 8 or greater from the viewpoint of stable solubility in water or turbidity. The proportion of the nonionic surfactant contained in the developer is preferably from 0.01 to 10 mass%, more preferably from 0.01 to 5 mass%.

Furthermore, acetylene glycol-based or acetylene alcohol-based oxyethylene adducts, fluorine-containing surfactants, and silicone-based surfactants can also be used.

As the surfactant to be used in the developer in the invention, the nonionic surfactants are especially preferred from the standpoint of defoaming properties.

As the surfactant to be used in the developer in the invention, a surfactant selected from the nonionic surfactants and the amphoteric surfactants, and combinations thereof are used.

Although no particular limitation is imposed on the amphoteric surfactant, examples include amine oxide-based ones such as alkyldimethylamine oxide, betaine-based ones such as alkyl betaines, and amino acid-based ones such as sodium salts of an alkylamino fatty acid.

In particular, alkyldimethylamine oxides which may have a substituent, alkylcarboxybetaines which may have a substituent, and alkylsulfobetaines which may have a substituent are preferred. As specific examples of them, those described in [0255] to [0278] of Japanese Patent Laid-Open No. 2008-203359 and [0028] to [0052] of Japanese Patent Laid-Open No. 2008-276166 can be used. Preferred examples include 2-alkyl-N-carboxymethyl-N-hydroxyethyl imidazolinium betaine, alkyldiaminoethyl glycine hydrochloride liquid, lauryl dimethylaminoacetic acid betaine, N-lauric acid amidopropyl dimethyl betaine, and N-lauric acid amidopropyl dimethylamine oxide.

Two or more of these surfactants may be used. The proportion of the surfactant contained in the developer is preferably from 0.01 to 20 mass%, more preferably from 0.1 to 10 mass%.

Examples of the water soluble polymer compound usable in the developer in the invention include soybean polysaccharides, modified starch, gum arabic, dextrin, cellulose derivatives (for example, carboxymethyl cellulose, carboxyethyl cellulose, and methyl cellulose) or modified products thereof, pullulan, polyvinyl alcohol or a derivative thereof, polyvinylpyrrolidone, polyacrylamide or acrylamide copolymers, a vinyl methyl ether/maleic anhydride copolymer, a vinyl acetate/maleic anhydride copolymer, and a styrene/maleic anhydride copolymer.

As the soybean polysaccharides, known ones can be used. For example, " SOYAFIBE" (trade name, manufactured by Fuji Oil) is a commercially available product and various grade products can be used. A soybean polysaccharide having a viscosity, as a 10 mass% aqueous solution thereof, falling within a range of from 10 to 100 mPa/sec can be preferably used.

As the modified starch, known ones can be used. The modified starch can be prepared, for example, by a method which comprises degrading a starch such as corn, potato, tapioca, rice, or wheat starch with an acid or enzyme to have from 5 to 30 glucose residues per molecule and then adding oxypropylene thereto in an alkali.

Two or more water soluble polymer compounds may be used in combination. The content of the water soluble polymer compound in the developer is preferably from 0.1 to 20 mass%, more preferably from 0.5 to 10 mass%.

The developer to be used in the invention may contain an organic solvent. Examples of the organic solvent that can be contained in the developer include aliphatic hydrocarbons (such as hexane, heptane, "Isopar E, H, G" (product of Esso Chemical), gasoline, and kerosene), aromatic hydrocarbons (such as toluene and xylene), halogenated hydrocarbons (such as methylene dichloride, ethylene dichloride, trichlene, and monochlorobenzene), and polar solvents.

Examples of the polar solvent include alcohols (such as methanol, ethanol, propanol, isopropanol, benzyl alcohol, ethylene glycol monomethyl ether, 2-ethyoxyethanol, diethylene glycol monoethyl ether, diethylene glycol monohexyl ether, triethylene glycol monomethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, methyl phenyl carbinol, n-amyl alcohol, and methylamyl alcohol), ketones (such as acetone, methyl ethyl ketone, ethyl butyl ketone, methyl isobutyl ketone, and cyclohexanone), esters (such as ethyl acetate, propyl acetate, butyl acetate, amyl acetate, benzyl acetate, methyl lactate, butyl lactate, ethylene glycol monobutyl acetate, propylene glycol monomethyl ether acetate, diethylene glycol acetate, diethyl phthalate, and butyl levulinate), and others (such as triethyl phosphate and tricresyl phosphate).

In another preferred mode of the organic solvent to be contained in the developer, organic amine compounds such as triethylamine and tributylamine can be given from the standpoint of developability. Of these, compounds simultaneously having an N atom and an O atom such as 2-aminoethanol, 2-(2-aminoethoxy)ethanol, N-phenylethanolamine, N-phenyldiethanolamine, N-methyldiethanolamine, N-ethyldiethanolamine, 4-(2-aminoethyl)morpholine, N-(3-aminopropyl)diethanolamine, 4-(2-hydroxyethyl)morpholine, 1-piperazineethanol, 1-piperidineethanol, diethanolamine, and triethanolamine are especially preferred.

In the especially preferred mode, the organic solvents to be contained in the developer are represented by any of the following formulas (I) to (III):

$$R^1\text{-O-(-CH}_2\text{-CH}_2\text{-O-)}_m\text{-H} \qquad (I)$$

$$R^1\text{-O-(-CH}_2\text{-CH(CH}_3\text{)-O-)}_m\text{-H} \qquad (II)$$

$$R^1\text{-O-(-CH}_2\text{-CH}_2\text{-CH}_2\text{-O-)}_m\text{-H} \qquad (III)$$

$R^1$ represents an alkyl group having from 1 to 4 carbon atoms, a substituted or unsubstituted aryl group having from 6 to 10 carbon atoms, or a hydrogen atom and m stands for an integer from 1 to 3. In the above formulas, the alkyl group as $R^1$ may be either a linear alkyl group or a branched alkyl group. The substituent of the substituted aryl group as $R^1$ is a halogen atom, an alkyl group which may have a substituent, or an alkoxy group which may have a substituent. As $R^1$, a propyl group, an isopropyl group, an n-butyl group, an isobutyl group, a t-butyl group, a phenyl group, and the like are especially preferred.

The organic solvent is preferably in liquid form at 20°C at 1 atmospheric pressure and has a boiling point of 150°C or greater.

Specific examples of the compound represented by the formula (I) include ethylene glycol, diethylene glycol, triethylene glycol, ethylene glycol monomethyl ether, diethylene glycol monomethyl ether, triethylene glycol monomethyl ether, ethylene glycol monoethyl ether, diethylene glycol monoethyl ether, triethylene glycol monoethyl ether, ethylene glycol monoisobutyl ether, diethylene glycol monoisobutyl ether, triethylene glycol monoisobutyl ether, ethylene glycol monopropyl ether, diethylene glycol monopropyl ether, triethylene glycol monopropyl ether, ethylene glycol mono-n-butyl ether, ethylene glycol mono-t-butyl ether, diethylene glycol mono-n-butyl ether, diethylene glycol mono-t-butylbutyl ether, triethylene glycol mono-n-butyl ether, triethylene glycol mono-t-butyl ether, ethylene glycol monophenyl ether, diethylene glycol monophenyl ether, triethylene glycol monophenyl ether, ethylene glycol mono(p-t-butyl-phenyl)ether, diethylene glycol mono(p-t-butyl-phenyl)ether, triethylene glycol mono(p-t-butyl-phenyl)ether, ethylene glycol mono(p-methoxyphenyl)ether, diethylene glycol mono(p-methoxy-phenyl)ether, and triethylene glycol mono(p-methoxy-phenyl)ether.

Specific examples of the compound represented by the formula (II) include propylene glycol, dipropylene glycol, tripropylene glycol, propylene glycol monomethyl ether, dipropylene glycol monomethyl ether, tripropylene glycol monomethyl ether, propylene glycol monoethyl ether, dipropylene glycol monoethyl ether, tripropylene glycol monoethyl ether, propylene glycol monopropyl ether, dipropylene glycol monopropyl ether, tripropylene glycol monopropyl ether, propylene glycol monoisopropyl ether, dipropylene glycol monoisopropyl ether, tripropylene glycol monoisopropyl ether, propylene glycol mono-n-butyl ether, dipropylene glycol mono-n-butyl ether, tripropylene glycol mono-n-butyl ether, propylene glycol monoisobutyl ether, dipropylene glycol monoisobutyl ether, tripropylene glycol monoisobutyl ether, propylene glycol mono-t-butyl ether, dipropylene glycol mono-t-butyl ether, tripropylene glycol mono-t-butyl ether, propylene glycol monophenyl ether, dipropylene glycol monophenyl ether, tripropylene glycol monophenyl ether, propylene glycol mono(p-t-butyl-phenyl)ether, dipropylene glycol mono(p-t-butyl-phenyl)ether, tripropylene glycol mono(p-t-butyl-phenyl)ether, propylene glycol mono(p-methoxyphenyl)ether, dipropylene glycol mono(p-methoxy-phenyl)ether, and tripropylene glycol mono(p-methoxy-phenyl)ether.

Specific examples of the compound represented by the formula (III) include 1,3-propanediol, 3-methoxy-1-propanol, 3-ethoxy-1-propanol, 3-n-butoxy-1-propanol, 3-t-butoxy-1-propanol, 3-phenoxy-1-propanol, 3-(4-t-butyl-phenoxy)-1-propanol, 3-(4-methoxy-phenoxy)-1-propanol, 3-(3-hydroxypropoxy)-1-propanol, 3-(3-methoxypropoxy)-1-propanol, 3-(3-ethoxypropoxy)-1-propanol, 3-(3-t-butoxypropoxy)-1-propanol, and 3-(3-phenoxypropoxy)-1-propanol.

The organic solvents represented by the formula (II) or (III) are preferred, with the organic solvents represented by the formula (III) being more preferred.

The content of the organic solvent in the developer is preferably from 0.1 to 10 mass%, more preferably from 1 to 5 mass%.

When the organic solvent is insoluble in water, it may be solubilized in water by using a surfactant or the like. When the organic solvent is incorporated in the developer, the concentration of the solvent is desirably less than 40 mass% from the standpoint of safety and flammability.

The developer of the invention may contain an organic acid and/or a derivative thereof. Examples of the organic solvent to be incorporated include acetic acid, oxalic acid, malonic acid, salicylic acid, caprylic acid, levulinic acid, p-toluenesulfonic acid, xylenesulfonic acid, phytic acid, and organic phosphonic acid. The organic acid may be used in the form of an alkali metal salt or ammonium salt thereof.

In an especially preferred mode, examples of the organic acid derivative include low molecular weight hydroxycarboxylate ion. Specific examples of low molecular weight hydroxycarboxylic acid which will be a source of low molecular weight hydroxycarboxylate ion include gluconic acid, glycolic acid, lactic acid, tartronic acid, hydroxybutyric acids (such as 2-hydroxybutyric acid, 3-hydroxybutyric acid, and $\gamma$-hydroxybutyric acid), malic acid, tartaric acid, citramalic acid, citric acid, isocitric acid, leucic acid, mevalonic acid, pantoic acid, ricinoleic acid, ricinelaidic acid, cerebronic acid, quinic acid, shikimic acid, monohydroxybenzoic acid derivatives (such as salicylic acid, creosotic acid (also known as homosalicylic acid or hydroxy(methyl)benzoic acid), vanillic acid, and syringic acid), dihydroxybenzoic acid derivatives (such as pyrocatechuic acid, resorcylic acid, protocatechuic acid, gentisic acid, and orsellinic acid), trihydroxybenzoic acid derivatives (such as gallic acid), phenylacetic acid derivatives (such as mandelic acid, benzilic acid, and atrolactic acid), and hydrocinnamic acid derivatives (such as melilotic acid, phloretic acid, coumaric acid, umbellic acid, caffeic acid, ferulic acid, and sinapic acid). Of these, low molecular weight hydroxycarboxylic acids having at least two carboxylic acid groups are preferred, of which citric acid, malic acid, and tartaric acid are more preferred, with citric acid being most preferred.

Compounds that have at least one carboxylic acid group and at least two hydroxyl groups are also preferably used as the low molecular weight hydroxycarboxylic acid. Specific examples of such low molecular weight hydroxycarboxylic acids include gluconic acid, tartaric acid, mevalonic acid, pantoic acid, quinic acid, shikimic acid, dihydroxybenzoic acid derivatives, trihydroxybenzoic acid derivatives, umbellic acid, caffeic acid, dimethylolpropionic acid, and carminic acid. Of these, gluconic acid, tartaric acid, mevalonic acid, shikimic acid, gallic acid, dimethylolpropionic acid, and carminic acid are preferred. Low molecular weight hydroxycarboxylic acids having at least four hydroxyl groups are also preferred. Preferred examples thereof include gluconic acid and carminic acid.

Although there are no particular limitations imposed on the low molecular weight hydroxycarboxylic acid salt,

alkali metal salts are preferred. The alkali metals include lithium, sodium, and potassium, with sodium being especially preferred. They may be used either singly or in combination of two or more.

The amount of the low molecular weight hydroxycarboxylate ion to the developer is suitably from 0.05 mol/L to 5 mol/L, preferably from 0.2 mol/L to 2 mol/L, most preferably from 0.25 mol/L to 0.75 mol/L. Amounts of 0.05 mol/L or greater are sufficiently effective for inhibiting fingerprint stain. On the other hand, when the amount is not greater than 5 mol/L, precipitates or crystals are not produced easily and further, gelation does not occur easily upon neutralization at the time of waste developer disposal so that no problem occurs upon waste water disposal.

Examples of the inorganic acid or salt thereof include phosphoric acid, metaphosphoric acid, ammonium dihydrogen phosphate, diammonium hydrogen phosphate, sodium dihydrogen phosphate, disodium hydrogen phosphate, potassium dihydrogen phosphate, dipotassium hydrogen phosphate, sodium tripolyphosphate, potassium pyrophosphate, sodium hexametaphosphate, magnesium nitrate, sodium nitrate, potassium nitrate, ammonium nitrate, sodium sulfate, potassium sulfate, ammonium sulfate, sodium sulfite, ammonium sulfite, sodium hydrogen sulfate, and nickel sulfate.

The developer of the invention may contain, in addition to the above-described components, an antiseptic, a chelating compound, a defoamer, and the like.

The above-described developer can be used as a developer or a developer replenisher of a negative lithographic printing plate precursor which has been exposed to light and it is preferably employed in an automatic processor which will be described later. When development is performed using an automatic processor, the developer becomes exhausted in accordance with the amount processed so that a processing capacity may be restored using a replenisher or a fresh developer. This replenishing system is employed preferably also in a plate making method of the lithographic printing plate of the invention.

The development processing with an aqueous solution having a pH of from 2 to 10 in the invention can be suitably conducted by using an automatic processor equipped with a feed means of a developer and a rubbing member. Examples of such an automatic processor include automatic processors, described in Japanese Patent Laid-Open No. H02-220061 and Japanese Patent Laid-Open No. S60-59351, in which a lithographic printing plate precursor after image recording is subjected to a rubbing treatment while being transported; and automatic developers described in U.S. Pat. Nos. 5148746 and 5568768 and British Patent No. 2297719, in which a lithographic printing plate precursor after image recording mounted on a cylinder is subjected to a rubbing treatment while rotating the cylinder. Of these, the automatic processor using a rotating brush roll as the rubbing member is especially preferred.

The rotating brush roll usable in the invention can be selected as needed in consideration of scratch resistance of an image area, rigidity of the support of the lithographic printing plate precursor, and the like. As the rotating brush roll, known ones obtained by implanting a plastic or metal roll with brush raw materials are usable. Examples include rotating brush rolls obtained by closely and radially winding a plastic or metal roll, which will serve as a core, with a metal or plastic grooved member having brush raw materials implanted therein in rows, as described in Japanese Patent Laid-Open No. S58-159533, Japanese Patent Laid-Open No. H03-100554, or Examined Utility Model Publication No. S62-167253.

As the brush raw materials, plastic fibers (for example, polyester synthetic fibers such as polyethylene terephthalate and polybutylene terephthalate; polyamide synthetic fibers such as nylon 6.6 and nylon 6.10; polyacrylic synthetic fibers such as polyacrylonitrile and polyalkyl (meth)acrylate; and polyolefin synthetic fibers such as polypropylene and polystyrene) may be used. For example, a brush material having a fiber bristle diameter of from 20 to 400 $\mu$m and a bristle length of from 5 to 30 mm is preferred.

The outer diameter of the rotating brush roller is preferably from 30 to 200 mm, and the peripheral speed at the tip of the brush rubbing the plate surface is preferably from 0.1 to 5 m/sec.

Furthermore, it is preferred to use two or more rotating brush rollers.

The rotation direction of the rotating brush roller to be used in the invention may be the same direction or the opposite direction relative to the transport direction of the lithographic printing plate precursor of the invention. When two or more rotating brush rollers are used as in an automatic processor as shown in FIG. 1, it is preferred to rotate at least one rotating brush roller in the same direction and at least one rotating brush roller in the opposite direction, each relative to the transport direction. This makes it possible to remove a thermosensitive layer in the non-image area more reliably. Furthermore, fluctuation of the rotating brush roller in the rotational axis direction of the brush roller is also effective.

The developer may be used at an arbitrary temperature but preferably at from 10°C to 50°C.

In the invention, the lithographic printing plate after the rubbing treatment may be subsequently subjected to water washing, a drying treatment, and an oil-desensitization treatment. In the de-oleophilization treatment, a known oil-desensitization liquid can be used.

Furthermore, in the making process of a lithographic printing plate from the lithographic printing plate precursor of the invention, the entire surface may be heated before or during exposure or between exposure and development if necessary. By heating in such a manner, an image-forming reaction in the photosensitive layer is accelerated and

advantages such as improvement in sensitivity and runlength and stabilization of sensitivity are achieved. For the purpose of improving image strength and runlength further, overall post-heating or overall exposure of the image after development is also effective. Heating before development is usually preferably carried out under mild conditions at 150°C or less. When the temperature is too high, the problem of undesirable fogging occurs even in the non-image area. Heating after development can be carried out using very severe conditions, usually within a range of from 100 to 500°C. At temperatures lower than this range, a sufficient effect of strengthening the image cannot be obtained, while at temperatures higher than this range, problems of deterioration of the support and thermal decomposition of the image area occur.

Prior to the development processing, the lithographic printing plate precursor is laser-exposed through a transparent original having a line image, a halftone dot image, or the like or image-wise exposed by using, for example, laser beam scanning based on digital data.

A preferred wavelength of a light source is from 350 nm to 450 nm or from 700 nm to 1200 nm. When it is from 350 nm to 450 nm, a lithographic printing plate precursor having a photosensitive layer containing a sensitizing dye having an absorption maximum in this region is used, and when it is from 700 nm to 1200 nm, a lithographic printing plate precursor containing an IR absorbing agent, which is a sensitizing dye having an absorption maximum in this region, is used. As a light source for from 350 nm to 450 nm, a semiconductor laser is suited. As a light source for from 700 nm to 1200 nm, a solid laser or semiconductor laser emitting infrared rays is suited.

The exposure mechanism may be any of an internal drum system, an external drum system, a flatbed system, and the like.

EXAMPLES

The present invention will hereinafter be described further by Examples. It should however be borne in mind that the invention is not limited to or by them.

<Reference Examples 1 to 22, Comparative Examples 1 to 3>

A 0.3-mm thick aluminum plate (material: JIS A1050) was etched by immersing in 10 mass% sodium hydroxide at 60°C for 25 seconds, washed with running water, neutralized and washed with 20 mass% nitric acid, and then washed with water. The resulting aluminum plate was then subjected to an electrolytic surface roughening treatment in a 1 mass% aqueous nitric acid solution by using an alternating current with a sinusoidal waveform at an anode time electricity of 300 coulomb/$dm^2$. The resulting plate was then immersed in a 1 mass% aqueous sodium hydroxide solution at 40°C for 5 seconds, subjected to a desmut treatment at 60°C for 40 seconds by immersing in a 30 mass% aqueous sulfuric acid solution, and then subjected to an anodizing treatment for 2 minutes in a 20 mass% aqueous sulfuric acid solution at a current density of 2 A/$dm^2$ to give a thickness of an anodic oxide film of 2.7 g/$m^2$. Then, the plate was treated at 20°C for 10 seconds with a 1 mass% aqueous sodium silicate solution. The center line average roughness (Ra) of the support thus obtained was measured using a stylus having a diameter of 2 $\mu$m and was found to be 0.25 $\mu$m (Ra value according to JIS B0601).

Further, the undercoat liquid (1) described below was bar-coated to the support, dried in an oven at 80°C for 10 seconds, and applied to give a dry coat weight of 15 mg/$m^2$ to prepare a support having an undercoat layer for use in the following test.

<Undercoat liquid (1)>

| | |
|---|---|
| Undercoat compound (1) | 0.017 g |
| Methanol | 9.00 g |
| Water | 1.00 g |

[Chem. 43]

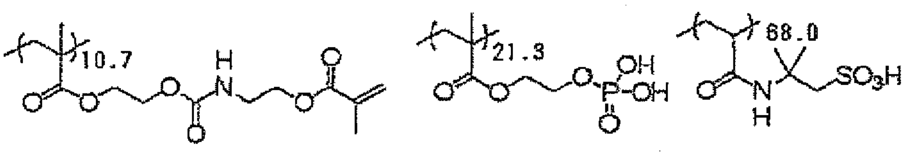

Undercoat compound (1) Mass average molecular weight: 88000

(a ratio of repeating unit: molar ratio)

On the aluminum support provided with the undercoat layer, Photosensitive layer coating Solution (1) having the composition shown below was bar coated and dried in an oven at 70°C for 60 seconds to form a photosensitive layer having a dry coating weight of 1.1 g/m2. On the resulting photosensitive layer, Protective layer coating solution (1) having the composition shown below was bar coated to give a dry coating weight of 0.95 g/m2 and dried at 125°C for 70 seconds to form a protective layer, thereby preparing a lithographic printing plate precursor.

Photosensitive layer coating solution (1)

| | |
|---|---|
| • Binder Polymer shown in Table 1 | 0.50 g |
| • Polymerizable Compound | 0.50 g |
| (Dipentaerythritol pentaacrylate, "SR39", product of Nippon Kayaku) | |
| • Polymerization Initiator (I-1) shown below | 0.08 g |
| • Sensitizing Dye (D-1) shown below | 0.06 g |
| • Chain transfer agent (S-1) shown below | 0.07 g |
| • Dispersion of ε-phthalocyanine pigment | 0.40 g |
| (15 parts by mass of the pigment, 10 parts by mass of allyl methacrylate/methacrylic acid (80/20) copolymer as a dispersing agent, and 15 parts by mass/20 parts by mass/40 parts by mass cyclohexanone/methoxypropyl acetate/1-methoxy-2-propanol as a solvent) | |
| • Thermal polymerization inhibitor | 0.01 g |
| N-nitrosophenylhydroxylamine aluminum | |
| • Fluorine-based surfactant (F-1) shown below | 0.001 g |
| • Polyoxyethylene-polyoxypropylene condensate | 0.04 g |
| ("Pluronic L44", product of ADEKA Corp) | |
| • 1-Methoxy-2-propanol | 3.5 g |
| • Methyl ethyl ketone | 8.0 g |

[Chem. 44]

D－1

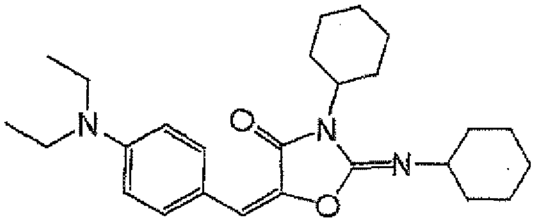

I－1

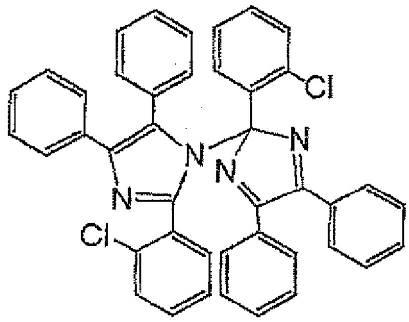

S－1

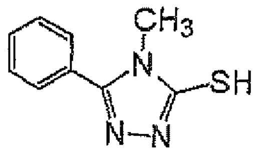

[Chem. 45]

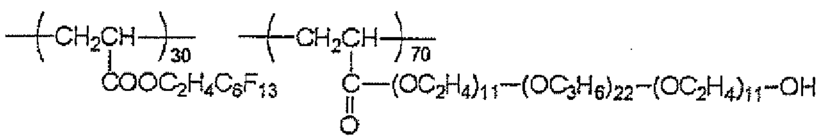

F－1

Protective layer coating solution 1

| | |
|---|---|
| • Polyvinyl alcohol ("PVA-105", product of Kuraray, saponification degree: 98 mol%, polymerization degree: 500) | 40 g |
| • Polyvinylpyrrolidone (mass average molecular weight: 50000) | 5 g |
| • Poly(vinylpyrrolidone/(vinyl acetate (1/1)) mass average molecular weight: 70000 | 0.5 g |
| • Surfactant ("Emalex 710", product of Nippon Emulsion) | 0.5 g |
| • Water | 950 g |

[Exposure, development, and printing]

Each of the lithographic printing plate precursors was subjected to image-wise exposure by using a 405-nm semiconductor laser having an output of 100 mW while changing an energy density. Within 30 seconds after laser exposure, the lithographic printing plate precursor was put in an oven and the entire surface of the lithographic printing plate precursor was heated by blowing a hot wind thereto. It was kept at 110°C for 15 seconds.

Then, Developer 1 having the below-described composition was prepared and adjusted to pH 4.3 with phosphoric acid. By using the resulting aqueous solution as a developer, development processing was performed using an

automatic development processor having a structure as shown in FIG. 1 to produce a lithographic printing plate (without heating). The automatic development processor was an automatic processor having two rotating brush rollers. The first brush roller was a brush roller having an outer diameter of 90 mm and implanted with fibers of polybutylene terephthalate (bristle diameter: 200 μm, bristle length: 17 mm), and the brush roller was rotated at 200 rpm in the same direction as the transport direction (peripheral velocity at the tip of brush: 0.94 m/sec). The second brush roller was a brush roller having an outer diameter of 60 mm and implanted with fibers of polybutylene terephthalate (bristle diameter: 200 μm, bristle length: 17 mm), and the brush roller was rotated at 200 rpm in the opposite direction to the transport direction (peripheral velocity at the tip of brush: 0.63 m/sec). The lithographic printing plate precursor was transported while changing the transport speed variously.

The developer was supplied to the surface of the plate by showering it from a spray pipe using a circulation pump. The tank volume for the developer was 10 liters.

Developer 1

| | |
|---|---|
| • Water | 100.00 g |
| • Benzyl alcohol | 1.00 g |
| • Polyoxyethylene naphthyl ether (average number n of oxyethylene=13) | 1.00 g |
| • Sodium salt of dioetylsulfosuccinate ester | 0.50 g |
| • Gum arabic (MW=250000) | 1.00 g |
| • Ethylene glycol | 0.50 g |
| • Ammonium dihydrogen phosphate | 0.50 g |
| • Citric acid | 0.05 g |
| • Tetrasodium ethylenediaminetetraacetate | 0.05 g |

The lithographic printing plate thus-obtained was mounted on a printing machine "SOR-M", manufactured by Heidelberg, and printing was performed at a printing speed of 6000 sheets per hour by using a fountain solution ("EU-3" (etching solution, product of FUJIFILM Corporation))/water/isopropyl alcohol = 1/89/10 (by volume ratio)) and "TRANS-G (N)" black ink (product of Dai-Nippon Ink & Chemicals).

[Evaluation]

The lithographic printing plate precursors were evaluated for developability, sensitivity, runlength, and stain resistance in the following manners, respectively. The results are shown in Table 1.

<Developability>

Development was performed at various transport speeds as described above and the cyan density in the non-image area was measured using a Macbeth densitometer. The transport speed at which the cyan density of the non-image area became equivalent to the cyan density of the aluminum substrate was determined and designated as developability. In evaluation, developability was indicated as a relative developability defined as below using Comparative Example 1 as a criterion (1.0). The greater the value of the relative developability, the higher the developability and the better the performance.

Relative developability = (Transport speed of subject sensitized material)/(Transport speed of criterion sensitized material)

<Sensitivity>

After performing printing of 100 sheets as described above and confirming that a printed material thus obtained was free from ink stain in the non-image area, 500 sheets were continuously printed. The exposure amount at which no unevenness occurred in the ink density of the image area on the 600th printed material was determined as the sensitivity. In evaluation, sensitivity was indicated as a relative sensitivity defined as below using Comparative Example 1 as a criterion (1.0). The greater the value of the relative sensitivity, the higher the sensitivity and the better the performance.

Relative sensitivity = (The exposure amount of criterion sensitized material)/(The exposure amount of subject sensitized material)

<Runlength>

With an increase in the number of printing sheets, the photosensitive layer was gradually abraded to deteriorate the ink receptivity, resulting in decrease of the ink density on printing paper. In the printing plates exposed to the same exposure amount (90 $\mu J/cm^2$), the runlength was evaluated based on the number of printed materials obtained until the ink density (reflection density) decreased by 0.1 from that at the beginning of printing. The evaluation of the runlength was indicated as a relative runlength defined as below using Comparative Example 1 as a criterion (1.0). The greater the number of the relative runlength, the higher the runlength.

Relative runlength = (Number of printed sheets of subject sensitized material)/(Number of printed sheets of criterion sensitized material)

<Stain resistance>

After printing of 500 sheets as described above, a printing plate utterly free from ink stain in the non-image area is rated A, a printing plate inferior but having no problem in practical use is rated B, a printing plate having a problem in practical use because stain is observed, though partially is rated C, and a printing plate having stain in the non-image area is rated D.

<Generation of scum in exhausted developer>

Presence or absence of scum generated in a developer was analyzed by dissolving, in 100 mL of the above-described developer, the same amount of the photosensitive layer as that used for the processing of 2500 $m^2/L$ of a printing plate.

[Table 1]

| | Binder polymer | Developability | Sensitivity | Runlength | Stain resistance | Generation of scum in exhausted developer |
|---|---|---|---|---|---|---|
| Example 1 | P-1 | 1.4 | 1.0 | 1.1 | A | None |
| Example 2 | P-2 | 1.3 | 1.0 | 1.1 | A | None |
| Example 3 | P-3 | 1.3 | 1.0 | 1.2 | A | None |
| Example 4 | P-4 | 1.3 | 1.1 | 1.4 | A | None |
| Example 5 | P-6 | 1.4 | 1.0 | 1.1 | A | None |
| Example 6 | P-23 | 1.2 | 1.0 | 1.1 | A | None |
| Example 7 | P-29 | 1.2 | 1.0 | 1.1 | A | None |
| Example 8 | P-31 | 1.1 | 1.0 | 1.2 | A | None |
| Example 9 | P-33 | 1.0 | 1.1 | 1.3 | A | None |
| Example 10 | P-34 | 1.3 | 1.0 | 1.1 | A | None |
| Example 11 | P-35 | 1.3 | 1.0 | 1.1 | A | None |
| Example 12 | P-38 | 1.3 | 1.1 | 1.3 | A | None |
| Example 13 | P-39 | 1.3 | 1.1 | 1.3 | A | None |
| Example 14 | P-45 | 1.2 | 1.0 | 1.1 | A | None |
| Example 15 | P-48 | 1.2 | 1.1 | 1.3 | A | None |

(continued)

| | Binder polymer | Developability | Sensitivity | Runlength | Stain resistance | Generation of scum in exhausted developer |
|---|---|---|---|---|---|---|
| Example 16 | P-49 | 1.3 | 1.0 | 1.1 | A | None |
| Example 17 | P-52 | 1.3 | 1.1 | 1.3 | A | None |
| Example 18 | P-55 | 1.0 | 1.2 | 1.1 | A | None |
| Example 19 | P-57 | 1.0 | 1.2 | 1.2 | A | None |
| Example 20 | P-58 | 1.0 | 1.3 | 1.3 | A | None |
| Example 21 | P-63 | 1.2 | 1.2 | 1.1 | B | None |
| Example 22 | P-67 | 1.2 | 1.3 | 1.3 | B | None |
| Comparative Example 1 | PR-1 | 1.0 | 1.0 | 1.0 | D | Generation of scum |
| Comparative Example 2 | PR-2 | 0.2 | Development failure | 1.1 | D | Generation of scum |
| Comparative Example 3 | PR-3 | 0.8 | 1.1 | 1.1 | D | Generation of scum |

Examples 1-22 are reference examples, which are not part of the claimed subject-matter.

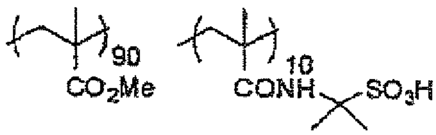
Mw = 52000

PR-1

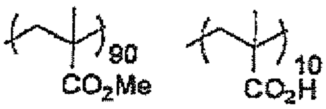
Mw = 50000

PR-2

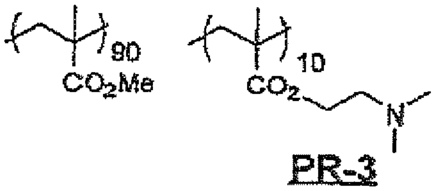
Mw = 59000

PR-3

As is apparent from Table 1, using the binder polymers of the invention makes it possible to improve developability and stain resistance while keeping the sensitivity and runlength to a level equal to or superior to Comparative Examples 1 to 3 which are outside the scope of the invention. Further, when the binder polymers of the invention are used, generation of scum in an exhausted developer is unexpectedly inhibited, which is presumed to result from the improvement in the affinity with the developer. From the standpoint of developability, X in the binder polymer is especially preferably sulfonic acid, a salt of sulfonic acid, or a salt of carboxylic acid. From the standpoint of runlength, a polymer having a butyral unit and/or polymerizable group is especially preferred, which is presumed to attributable to the developer resistance of the butyral unit and crosslink property of the polymerizable group.

<Reference Examples 23 to 47 Comparative Examples 4 to 6>

[Production of Lithographic printing plate precursor 2]

It was produced in a manner similar to that employed for the production of Lithographic printing plate precursor 1 except that Photosensitive layer coating solution 1 was replaced by Photosensitive layer coating solution 2 and Protective layer coating solution 1 was replaced by Protective layer coating solution 2, while using the same undercoat liquid formulation.

Photosensitive layer coating solution 2

| | |
|---|---|
| • Binder Polymer shown in Table 2 | 0.48 g |
| • Compound (M-1) having an ethylenically unsaturated bond | 0.54 g |
| • Radical polymerization Initiator (I-1) | 0.08 g |
| • Sensitizing Dye (D-1) | 0.06 g |
| • Chain transfer agent (S-2) | 0.07 g |
| • Dispersion of ε-phthalocyanine pigment | 0.40 g |
| (15 parts by mass of the pigment, 10 parts by mass of allyl methacrylate/methacrylic acid (80/20) copolymer as a dispersing agent, and 15 parts by mass/20 parts by mass/40 parts by mass cyclohexanone/methoxypropyl acetate/1-methoxy-2-propanol as a solvent) | |
| • Thermal polymerization inhibitor (N-nitrosophenylhydroxylamine aluminum) | 0.01 g |
| • Fluorine-based surfactant (F-1) | 0.001 g |
| • Polyoxyethylene-polyoxypropylene condensate ("Pluronic L44", product of ADEKA Corp) | 0.04 g |
| • Tetraethylamine hydrochloride | 0.01 g |
| • 1-Methoxy-2-propanol | 3.5 g |
| • Methyl ethyl ketone | 8.0 g |

[Chem. 47]

Mixture of

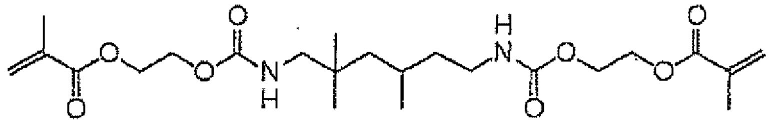

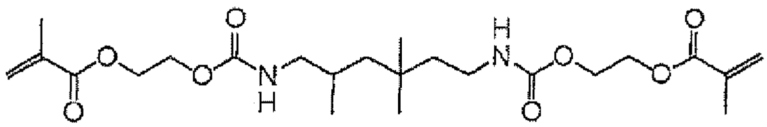

M-1

S-2

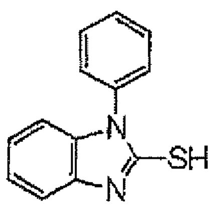

Protective layer coating solution (2)

- Mica dispersion (1) described below 13.00 g
- Polyvinyl alcohol (saponification degree: 98 mol%, polymerization degree: 500) 1.30 g
- Sodium 2-ethylhexylsulfosuccinate 0.20 g
- Poly(vinylpyrrolidone/(vinyl acetate (1/1)) mass average molecular weight: 70000 0.05 g

Surfactant ("Emalex 710", product of Nippon Emulsion) 0.05 g
Water 133.00 g

Preparation of Mica dispersion (1)

Mica dispersion (1) was prepared by adding 32 g of synthetic mica ("Somasif ME-100", product of Co-op Chemical, aspect ratio: 1000 or greater) to 368 g of water and dispersing the resulting mixture by using a homogenizer until the average particle size (laser scattering method) became 0.5 μm.

[Exposure, development, and printing]

Exposure, development, and printing were performed in manners similar to Example 1 except that the developer for each lithographic printing plate precursor was changed from Developer 1 to Developer 2.

Developer 2

- Water 100.00 g
- N-lauryldimethylbetaine 10.00 g
("Pionin C157K", product of Takemoto Oil & Fat)
- Polystyrenesulfonic acid (Mw=20000) 1.00 g
- Ammonium dihydrogen phosphate 0.05 g
- Citric acid 0.05 g
- Tetrasodium ethylenediaminetetraacetate 0.05 g

The developer was adjusted to pH 9.8 with sodium hydrogen carbonate and then used as Developer 2.

[Evaluation]

The lithographic printing plates thus obtained were evaluated in a manner similar to Example 1 except that developability, sensitivity, and runlength were evaluated with those of Comparative Example 4 as a criterion (1.0). The results are shown in Table 2.

[Table 2]

| | Binder polymer | Developability | Sensitivity | Runlength | Strain resistance | Generation of scum in exhausted developer |
|---|---|---|---|---|---|---|
| Example 23 | P-1 | 1.4 | 1.1 | 1.1 | A | None |
| Example 24 | P-14 | 1.4 | 1.0 | 1.1 | A | None |
| Example 25 | P-15 | 1.3 | 1.0 | 1.1 | A | None |
| Example 26 | P-16 | 1.3 | 1.0 | 1.2 | A | None |
| Example 27 | P-17 | 1.3 | 1.1 | 1.4 | A | None |
| Example 28 | P-25 | 1.4 | 1.1 | 1.1 | A | None |
| Example 29 | P-27 | 1.3 | 1.0 | 1.1 | A | None |
| Example 30 | P-28 | 1.3 | 1.0 | 1.1 | A | None |
| Example 31 | P-29 | 1.2 | 1.0 | 1.1 | A | None |

(continued)

| | Binder polymer | Developability | Sensitivity | Runlength | Strain resistance | Generation of scum in exhausted developer |
|---|---|---|---|---|---|---|
| Example 32 | P-30 | 1.1 | 1.0 | 1.1 | A | None |
| Example 33 | P-31 | 1.1 | 1.0 | 1.2 | A | None |
| Example 34 | P-33 | 1.1 | 1.1 | 1.4 | A | None |
| Example 35 | P-35 | 1.3 | 1.0 | 1.1 | A | None |
| Example 36 | P-37 | 1.3 | 1.0 | 1.1 | A | None |
| Example 37 | P-39 | 1.3 | 1.1 | 1.3 | A | None |
| Example 38 | P-40 | 1.3 | 1.1 | 1.3 | A | None |
| Example 39 | P-41 | 1.3 | 1.1 | 1.4 | A | None |
| Example 40 | P-49 | 1.3 | 1.0 | 1.1 | A | None |
| Example 41 | P-50 | 1.3 | 1.0 | 1.1 | A | None |
| Example 42 | P-51 | 1.3 | 1.0 | 1.2 | A | None |
| Example 43 | P-52 | 1.3 | 1.1 | 1.3 | A | None |
| Example 44 | P-60 | 1.0 | 1.0 | 1.1 | B | None |
| Example 45 | P-64 | 1.0 | 1.0 | 1.1 | B | None |
| Example 46 | P-66 | 1.0 | 1.0 | 1.3 | B | None |
| Example 47 | P-68 | 1.0 | 1.1 | 1.4 | B | None |
| Comparative Example 4 | PR-1 | 1.0 | 1.0 | 1.0 | C | Generation of scum |
| Comparative Example 5 | PR-2 | 1.0 | 1.0 | 1.0 | D | Generation of scum |
| Comparative Example 6 | PR-3 | 0.2 | Development failure | 1.1 | D | Generation of scum |

Reference examples, not part of the claimed invention.

As is apparent from Table 2, using the binder polymers of the invention makes it possible to improve developability and stain resistance while keeping the sensitivity and runlength to a level equal to or superior to Comparative Examples 4 to 6 which are outside of the scope of the invention. Further, when the binder polymers of the invention are used, generation of scum in an exhausted developer can be inhibited as in Examples 1 to 22 described above.

<Reference Examples 48 to 64 , Comparative Examples 7 to 9>

[Production of Lithographic printing plate precursor 3]

It was produced in a manner similar to that employed for the production of Lithographic printing plate precursor 2 except that the photosensitive layer coating solution was changed from Photosensitive layer coating solution 2 to Photosensitive layer coating solution 3, while using the same undercoat liquid formulation.

Photosensitive layer coating solution 3

- Binder Polymer shown in Table 3 0.50 g
- Compound having an ethylenically unsaturated bond 1.00 g

("NK Ester M-315", isocyanuric-acid EO modified triacrylate; product of Shin-Nakamura Chemical)

- Radical polymerization Initiator (1-2) 0.08 g
- Sensitizing Dye (D-2) 0.06 g

(continued)

| | |
|---|---|
| • Dispersion of ε-phthalocyanine pigment | 0.40 g |
| (15 parts by mass of the pigment, 10 parts by mass of allyl methacrylate/methacrylic acid (80/20) copolymer as a dispersing agent, and 15 parts by mass/20 parts by mass/40 parts by mass cyclohexanone/methoxypropyl acetate/1-methoxy-2-propanol as a solvent) | |
| • Thermal polymerization inhibitor | 0.01 g |
| (N-nitrosophenylhydroxylamine aluminum) | |
| • Fluorine-based surfactant (F-1) | 0.001 g |
| • 1-Methoxy-2-propanol | 7.0 g |
| • Methyl ethyl ketone | 7.0 g |

[Chem. 48]

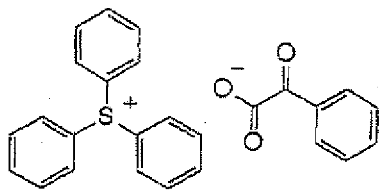

I－2

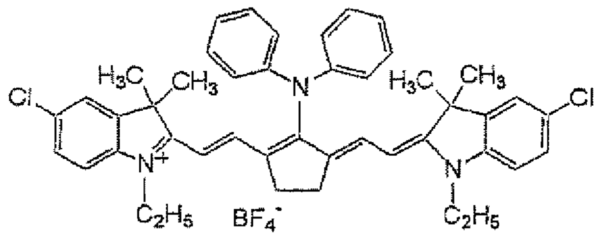

D－2

[Exposure, development, and printing]

Exposure, development, and printing were performed in manners similar to Example 1 except that the developer for each lithographic printing plate precursor was changed from Developer 1 to Developer 2.

[Evaluation]

The lithographic printing plate thus obtained were evaluated in a manner similar to Example 1 except that developability, sensitivity, and runlength were evaluated with those of Comparative Example 7 as a criterion (1.0) and with respect to exposure, image-wise exposure was performed by using "Trendsetter 3244VX", product of Creo, equipped with a water-cooling type 40-W infrared semiconductor laser at a resolution of 2400 dpi and at the number of revolutions of external drum of 150 rpm while changing an energy density (conditions upon evaluation of runlength: an output of 9W, the number of revolutions of external drum of 210 rpm, and a resolution of 2400 dpi).

The results are shown in Table 3.

[Table 3]

| | Binder polymer | Developability | Sensitivity | Runlength | Stain resistance | Generation of scum in exhausted developer |
|---|---|---|---|---|---|---|
| Example 48 | P-1 | 1.3 | 1.0 | 1.1 | A | None |
| Example 49 | P-18 | 1.4 | 1.0 | 1.1 | A | None |

(continued)

| | Binder polymer | Developability | Sensitivity | Runlength | Stain resistance | Generation of scum in exhausted developer |
|---|---|---|---|---|---|---|
| Example 50 | P-19 | 1.4 | 1.0 | 1.1 | A | None |
| Example 51 | P-20 | 1.4 | 1.0 | 1.2 | A | None |
| Example 52 | P-21 | 1.4 | 1.1 | 1.4 | A | None |
| Example 53 | P-22 | 1.4 | 1.1 | 1.4 | A | None |
| Example 54 | P-35 | 1.3 | 1.0 | 1.1 | A | None |
| Example 55 | P-40 | 1.3 | 1.1 | 1.3 | A | None |
| Example 56 | P-41 | 1.3 | 1.1 | 1.4 | A | None |
| Example 57 | P-53 | 1.2 | 1.0 | 1.1 | A | None |
| Example 58 | P-54 | 1.2 | 1.0 | 1.1 | A | None |
| Example 59 | P-56 | 1.1 | 1.0 | 1.1 | A | None |
| Example 60 | P-57 | 1.1 | 1.0 | 1.2 | A | None |
| Example 61 | P-58 | 1.1 | 1.1 | 1.3 | A | None |
| Example 62 | P-63 | 1.1 | 1.0 | 1.1 | B | None |
| Example 63 | P-65 | 1.1 | 1.0 | 1.2 | B | None |
| Example 64 | P-67 | 1.1 | 1.1 | 1.3 | B | None |
| Comparative Example 7 | PR-1 | 1.0 | 1.0 | 1.0 | C | None |
| Comparative Example 8 | PR-2 | 1.0 | 1.0 | 1.0 | C | None |
| Comparative Example 9 | PR-3 | 0.2 | Developmet failure | 1.1 | D | None |

Examples 48-64 are reference examples, which are not part of the claimed subject-matter.

As is apparent from Table 3, using the binder polymers of the invention makes it possible to improve developability and stain resistance while keeping the sensitivity and runlength to a level equal to or superior to Comparative Examples 7 to 9 which are outside of the scope of the invention. Further, when the binder polymers of the invention are used, generation of scum in an exhausted developer can be inhibited as in Examples 1 to 47 described above.

<Reference Examples 65 to 70, Comparative Example 10>

<Support>

A support was prepared by treating an aluminum plate in a manner similar to that employed for the production of Lithographic printing plate precursor 1 except that polyvinylphosphonic acid (mass average molecular weight: 30000) was used as Undercoat compound (1).

A photosensitive layer coating solution having the composition shown in Table 4 was bar-coated onto the aluminum support having the undercoat layer formed thereon, followed by oven drying at 70°C for 60 seconds to form a photosensitive layer having a dry coating weight of 1.1 g/m$^2$. A protective layer coating solution having the composition shown in Table 5 was then applied onto the photosensitive layer by using a bar coater to give a dry coating weight of 0.95 g/m$^2$, followed by drying at 125°C for 70 seconds to form a protective layer. In such a manner, a lithographic printing plate precursor was produced.

[Table 4]

| Compound | Amount added |
|---|---|
| Binder polymer described in Table 7 | 0.50 g |
| Polymerizable compound (M-1) | 0.60 g |
| Radical polymerization initiator (I-1) | 0.08 g |
| Sensitizing dye (D-1) | 0.06 g |
| Chain transfer agent (S-2) | 0.07 g |
| Dispersion of ε-phthalocyanine pigment [(15 parts by mass of the pigment, 10 parts by mass of allyl methacrylate/methacrylic acid (80/20) copolymer as a dispersing agent, and 15 parts by mass/20 parts by mass/40 parts by mass cyclohexanone/methoxypropyl acetate/1-methoxy-2-propanol as a solvent)] | 0.40 g |
| Thermal polymerization inhibitor (N-nitrosophenylhydroxylamine aluminum, | 0.01 g |
| Fluorine-based surfactant (F-1) | 0.001 g |
| Polyoxyethylene-polyoxypropylene condensate | 0.04 g |
| ("Pluronic L44", product of ADEKA Corp) | |
| Tetraethylamine hydrochloride | 0.01 g |
| 1-Methoxy-2-propanol | 3.5 g |
| Methyl ethyl ketone | 8.0 g |

[Table 5]

| | |
|---|---|
| Polyvinyl alcohol (saponifcation degree: 98 mol%, polymerization degree: 500) | 40 g |
| Polyvinylpyrrolidone (molecular weight: 50000) | 5 g |
| Poly[vinylpyrrolidone/vinyl acetate (1/1)] (molecular weight: 70000) | 0.5 g |
| Surfactant ("Emalex 710", product of Nippon Emulsion) | 0.5 g |
| Water | 950 g |

[Exposure, development, printing]

Each of the lithographic printing plate precursors was subjected to image-wise exposure by using a 405-nm semiconductor laser having an output of 100 mW while changing an energy density. Within 30 seconds after laser exposure, the lithographic printing plate precursor was put in an oven and the entire surface of the lithographic printing plate precursor was heated by blowing a hot wind thereto. It was kept at 110°C for 15 seconds.

Then, using a developer (pH=9.8) having the composition shown in Table 6, development processing was performed using an automatic development processor having a structure as shown in FIG 1 to produce a lithographic printing plate (not heated). The automatic development processor was an automatic processor having two rotating brush rollers. The first brush roller was a brush roller having an outer diameter of 90 mm and implanted with polybutylene terephthalate fibers (bristle diameter: 200 μm, bristle length: 17 mm), and it was rotated at 200 rpm in the same direction as the transport direction (peripheral velocity at the tip of brush: 0.94 m/sec). The second brush roller was a brush roller having an outer diameter of 60 mm, and implanted with polybutylene terephthalate fibers (bristle diameter: 200 μm, bristle length: 17 mm), and the brush roller was rotated at 200 rpm in the opposite direction to the transport direction (peripheral velocity at the tip of brush: 0.63 m/sec). The lithographic printing plate precursor was transported while changing the transport speed variously.

The developer was supplied onto the surface of the plate by showering it from a spray pipe by using a circulation pump. The tank volume of the developer was 10 liters.

[Table 6]

| | |
|---|---|
| Water | 100.00 g |

(continued)

| | |
|---|---|
| Polyoxyethylene naphthyl ether average number of oxyethylene n=13 | 5.00 g |
| Citric acid | 0.05 g |
| Tetrasodium ethylenediaminetetraacetate | 0.05 g |
| Sodium carbonate | 1.5 g |
| Sodium hydrogen carbonate | 0.5 g |

The lithographic printing plate thus-obtained was mounted on a printing machine "SOR-M", manufactured by Heidelberg, and printing was performed at a printing speed of 6000 sheets per hour by using a fountain solution ("EU-3" (etching solution, product of FUJIFILM Corporation))/water/isopropyl alcohol = 1/89/10 (by volume ratio)) and "TRANS-G (N)" black ink (produced by Dai-Nippon Ink & Chemicals).

[Evaluation]

The lithographic printing plate precursors were evaluated for developability, sensitivity runlength, and stain resistance in the following manners, respectively. The results are shown in Table 7

<Developability>

Development was performed at various transport speeds as described above and the cyan density in the non-image area was measured using a Macbeth densitometer. The transport speed at which the cyan density of the non-image area became equivalent to the cyan density of the aluminum substrate was determined and designated as developability. The developability was indicated as a relative developability defined as below with Comparative Example 1 as a criterion (1.0). The greater the value of the relative developability, the higher the developability and the better the performance.

Relative developability = (Transport speed of subject sensitized material)/(Transport speed of criterion sensitized material)

<Sensitivity>

As described above, 100 sheets were printed. After confirming that printed materials free from ink stain in a non-image area were obtained, 500 sheets were printed subsequently. Using the 600th sheet of the printed materials, the exposure amount that gave uniform ink density in an image area was determined and defined as the sensitivity. The sensitivity was expressed as a relative sensitivity defined as below by using Comparative Example 10 as a criterion (1.0). The greater the value of the relative sensitivity, the higher the sensitivity and the better the performance. In Examples which will be described below, the sensitivity in Comparative Examples 11 to 15 is used as a criterion (1.0), respectively.

Relative sensitivity = (The exposure amount of criterion sensitized material/(The exposure amount of subject sensitized material)

<Runlength>

With an increase in the number of printed sheets, the photosensitive layer was gradually abraded to cause a decrease in the ink receptivity, resulting in a decrease in the ink density on the printed paper. With regard to the printing plates exposed to the same exposure amount (90 $\mu J/cm^2$), runlength was evaluated by the number of printed sheets at which the ink density (reflection density) decreased by 0.1 from that at the initiation of printing. The runlength was expressed as a relative runlength defined as below with Comparative Example 1 as a criterion (1.0). The greater the value of relative runlength, the higher the runlength.

Relative runlength = (Number of printed sheets of subject sensitized material)/(Number of printed sheets of criterion sensitized material)

<Stain resistance>

After printing 500 sheets as described above, a printing plate utterly free from ink stain in the non-image area is rated A, a printing plate inferior to that rated A but has no problem in practical use is rated B, a printing plate having a problem in practical use because a stain is observed, though partially is rated C, and a printing plate stained in the non-image area is rated D.

Scratch resistance, OC (protective layer coating liquid) coating properties, and halftone dot reproduction were evaluated in the following manners, respectively.

<Scratch resistance>

Using the lithographic printing plate precursors, solid images (all were images in the exposure area) were exposed under conditions similar to those employed in the evaluation of runlength and then scratched by using a scratching tester equipped with a sapphire needle having a diameter of 0.1 mm, while changing a load applied thereto. After development and printing under the above-described conditions, a maximum load at which no scratch was formed at the scratched portion was determined. When the maximum load is 50 g or greater, the precursor is rated A and the maximum load is from 30 g to less than 50 g, the precursor is rated B.

<OC coating properties>

After an undercoat layer, a photosensitive layer, and an OC layer (overcoat layer meaning a protective layer) were applied in the order of mention successively, the surface of the plate after application of the OC layer was visually evaluated. A plate surface having a uniform OC layer is rated A, a plate surface a little inferior to the plate surface rated "A" but having no problem in practical use is rated "B", and a plate surface having a problem in practical use because of having strains, large unevenness, or flow of the photosensitive layer is rated "C".

<Halftone dot reproduction>

After printing 1000 sheets as described above, a lithographic printing plate showing no decrease in halftone dot (small dot) area thereon is rated "A", a lithographic printing plate inferior to that rated A but having no problem in practical use is rated "B", and a lithographic printing plate showing a decrease in halftone dot area and having a problem in practical use is rated "C".

[Table 7]

| | Binder polymer | Developability | Sensitivity | Runlength | Stain resistance | Scratch resistance | OC coating properties | Halftone dot reproduction |
|---|---|---|---|---|---|---|---|---|
| Example 65 | F-1 | 1.4 | 1.0 | 1.2 | A | A | A | A |
| Example 66 | F-2 | 1.2 | 1.0 | 1.2 | A | A | A | A |
| Example 67 | F-3 | 1.0 | 1.0 | 1.2 | A | A | A | B |
| Example 68 | F-4 | 1.0 | 1.1 | 1.0 | A | B | B | B |
| Example 69 | F-5 | 1.1 | 1.3 | 1.4 | A | A | A | A |
| Example 70 | F-6 | 1.2 | 1.3 | 1.5 | A | A | A | A |
| Comparative Example 10 | PR-4 | 0.5 | 1.0 | 1.0 | C | B | B | C |

Reference examples, not part of the claimed subject-matter.

The following are the binder polymers shown in Table 7.

[Chem. 49]

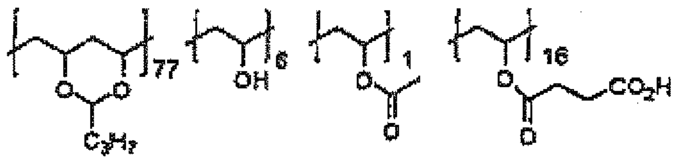

82,000 (F-1)

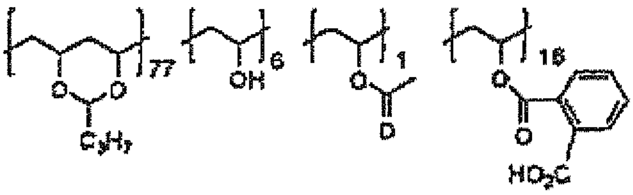

80,000 (F-2)

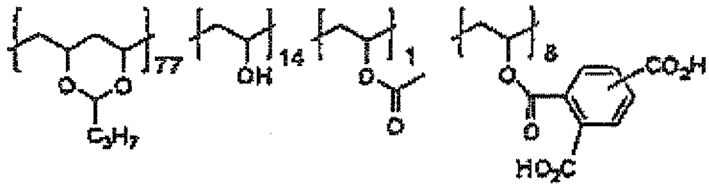

81000 (F-3)

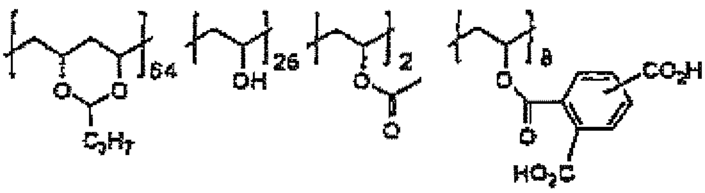

78,000 (F-4)

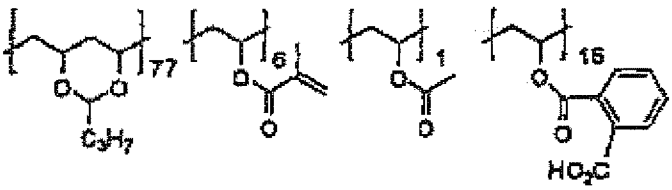

89,000 (F-5)

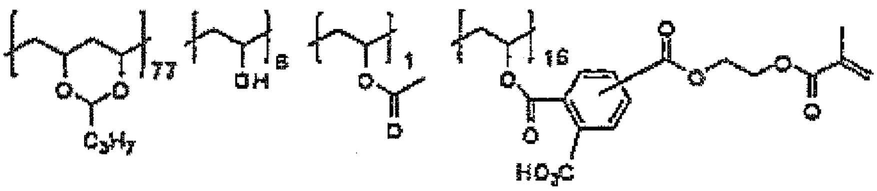

80,000 (F-6)

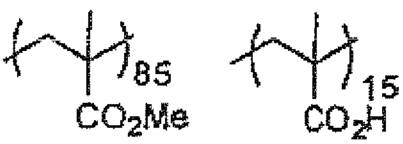

Mw = 50000

PR-4

It is apparent from Table 7 that the lithographic printing plate precursors of the invention are excellent in developability, sensitivity, runlength, stain resistance, scratch resistance, OC coating properties, and halftone dot reproduction.

<Examples 71 to 75, Comparative Example 11>

In a manner similar to Example 65 except for the use of a photosensitive layer coating solution having the composition shown in Table 8, lithographic printing plate precursors were produced.
Exposure, development, and printing were performed in manners similar to those employed in Example 65 except for the use of the lithographic printing plate precursors thus obtained and a developer (pH=9.8) having the composition shown in Table 9. Developability, sensitivity, runlength, stain resistance, development scum, and halftone dot reproduction were evaluated. The results are shown in Table 10.
Developability, sensitivity, runlength, stain resistance, and halftone dot reproduction were evaluated as in Example 65.
Development scum was evaluated as follows.

<Development scum>

A photosensitive layer and a protective layer, 0.4 g in total, were scraped from each of the lithographic printing plate precursors and dispersed in 10 mL of a developer (an amount of the photosensitive layer and the protective layer that dissolve when 20 $m^2/L$ of a lithographic printing plate precursor is subjected to development processing). After the dispersion was stored at 30°C for one week, scum in the developer was observed visually. A uniform dispersion is rated "A", a dispersion inferior to the dispersion rated "A" but having no problem in practical use is rated "B", a dispersion containing a turbidity component and having a problem in practical use is rated "C", and a dispersion having a precipitate therein is rated "D".

[Table 8]

| Compound | Amount added |
|---|---|
| Binder polymer described in Table 10 | 1.00 g |
| Polymerizable compound (M-1) | 0.50 g |
| Radical polymerization initiator (I-1) | 0.08 g |
| Sensitizing dye (D-1) | 0.06 g |
| Chain transfer agent (S-2) | 0.07 g |
| Dispersion of ε-phthatocyanine pigment, [(15 parts by mass of the pigment, 10 parts by mass of allyl methacrylate/methacrylic acid (80/20) copolymer as a dispersing agent, and 15 parts by mass/20 parts by mass/40 parts by mass cyclohexanone/methoxypropyl acetate/1-methoxy-2-propanol as a solvent)] | 0.40 g |
| Thermal polymerization inhibitor (N-nitrosophenylhydroxylamine aluminum | 0.01 g |
| Fluorine-based surfactant (F-1) | 0.001 g |
| Polyoxyethylene-polyoxypropylene condensate | 0.04 g |
| ("Pluronic L44", product of ADEKA Corp) | |
| Tetraethylamine hydrochloride | 0.01 g |
| 1-Methoxy-2-propanol | 3.5 g |
| Methyl ethyl ketone | 8.0 g |

[Table 9]

| | |
|---|---|
| Water | 100.00 g |
| Polyoxyethylene naphthyl ether average number of oxyethylene n=13 | 5.00 g |
| Gum Arabic (Mw=250000) | 1.00 g |
| Citric acid | 0.05 g |
| Tetrasodium ethylenediaminetetraacetate | 0.05 g |

(continued)

| | |
|---|---|
| Sodium carbonate | 1.5 g |
| Sodium hydrogen carbonate | 0.5 g |

[Table 10]

| | Binder polymer | Developability | Sensitivity | Runlength | Stain resistance | Development scum | Halftone dot reproduction |
|---|---|---|---|---|---|---|---|
| Example 71 | F-7 | 1.5 | 1.0 | 1.0 | A | A | A |
| Example 72 | F-8 | 1.4 | 1.0 | 1.0 | A | A | A |
| Example 73 | F-9 | 1.2 | 1.0 | 1.0 | A | A | B |
| Example 74 | F-4 | 1.0 | 1.1 | 1.0 | A | C | B |
| Example 75 | F-10 | 1.5 | 1.3 | 1.3 | A | A | A |
| Comparative Example 11 | PR-4 | 0.5 | 1.0 | 1.0 | D | D | C |

The following are the binder polymers shown in Table 10.

[Chem. 50]

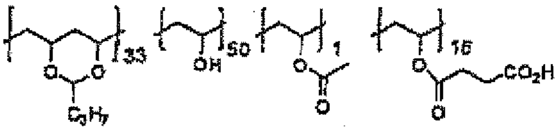

82,000 (F-7)

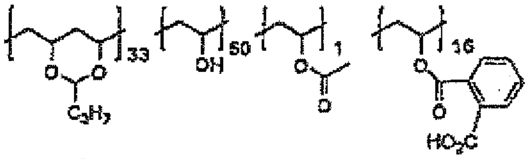

80,000 (F-8)

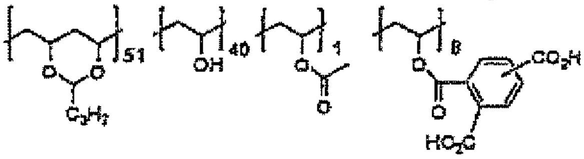

81,000 (F-9)

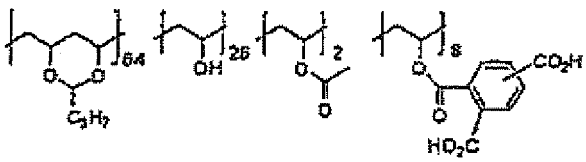

78,000 (F-4)

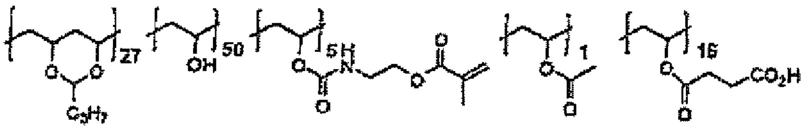

79,000 (F-10)

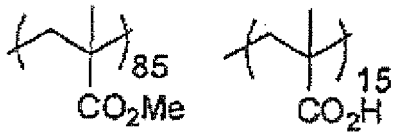

Mw = 50000

PR-4

It is apparent from Table 10 that the lithographic printing plate precursors of the invention are excellent in developability, sensitivity, runlength, stain resistance, development scum, and halftone dot reproduction.

<Examples 76 to 78, Comparative Example 12>

In a manner similar to Example 71 except for the use of a photosensitive layer coating solution having the composition shown in Table 11, a lithographic printing plate precursor was produced.

Exposure, development, and printing were performed in manners similar to those employed in Example 65 except for the use of the lithographic printing plate precursors thus obtained. Developability, sensitivity, runlength, and stain resistance were evaluated as in Example 71. The results are shown in Table 12.

[Table 11]

| Compound | Amount added |
|---|---|
| Binder polymer described in Table 12 | 1.00 g |
| Polymerizable compound (M-1) | 0.50 g |

(continued)

| Compound | Amount added |
|---|---|
| Radical polymerization initiator (I-1) | 0.08 g |
| Sensitizing dye (D-1) | 0.06 g |
| Chain transfer agent (S-2) | 0.07 g |
| Dispersion of $\varepsilon$-phthalocyanine pigment [(15 parts by mass of the pigment, 10 parts by mass of allyl methacrylate/methacrylic acid (80/20) copolymer as a dispersing agent, and 15 parts by mass/20 parts by mass/40 parts by mass cyclohexanone/methoxypropyl acetate/1-methoxy-2-propanol as a solvent)] | 0.40 g |
| Thermal polymerization inhibitor (N-nitrosophenylhydroxylamine aluminum | 0.01 g |
| Fluorine-based surfactant (F-1) | 0.001 g |
| Polyoxyethylene-polyoxypropylene condensate | 0.04 g |
| ("Pluronic L44", product of ADEKA Corp) | |
| Tetraethylamine hydrochloride | 0.01 g |
| 1-Methoxy-2-propanol | 3.5 g |
| Methyl ethyl ketone | 8.0 g |

[Table 12]

| | Binder polymer | Developability | Sensitivity | Runlength | Stain resistance |
|---|---|---|---|---|---|
| Example 76 | F-8 | 0.7 | 1.3 | 1.3 | B |
| Example 77 | F-4 | 1.0 | 1.1 | 1.0 | A |
| Example 78 | F-9 | 1.2 | 1.0 | 1.0 | A |
| Comparative Example 12 | PR-4 | 0.5 | 1.0 | 1.0 | D |

The following are the binder polymers shown in Table 12.

[Chem. 51]

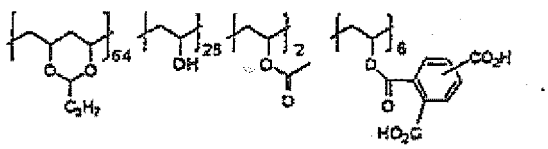

169,000 (F-8)

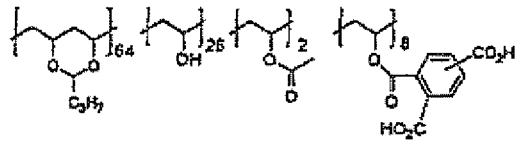

78,000 (F-4)

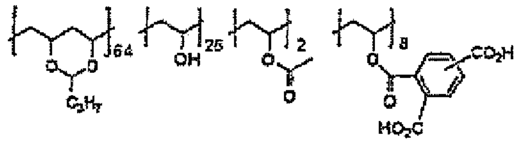

18,000 (F-9)

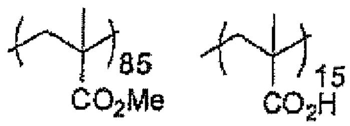

Mw = 50000

PR-4

It is apparent from Table 12 that the lithographic printing plate precursors of the invention are excellent in developability, sensitivity, runlength, and stain resistance.

<Examples 79 to 86, Comparative Example 13>

Lithographic printing plate precursors were produced in a manner similar to Example 65 except for the use of a photosensitive layer coating solution having the composition shown in Table 13.

Exposure, development, and printing were performed in manners as in Example 65 except for the use of the lithographic printing plate precursors thus obtained and a developer having the composition shown in Table 14 and adjusted to pH 7.0 with phosphoric acid and sodium carbonate. Developability, sensitivity, runlength, stain resistance, scratch resistance, and development scum were evaluated. Evaluation results are shown in Table 15.

The developability, sensitivity, runlength, stain resistance, and scratch resistance were evaluated as in Example 65, while the development scum was evaluated as in Example 71.

[Table 13]

| Compound | Amount added |
|---|---|
| Binder polymer (F-4, PR-4 in Comparative Example) | 0.50 g |
| Polymerizable compound (M-2) | 1.00 g |
| Radical polymerization initiator (I-1) | 0.08 g |
| Sensitizing dye (D-1) | 0.06 g |
| Chain transfer agent (S-3) | 0.07 g |
| Dispersion of ε-phthalocyanine pigment [(15 parts by mass of the pigment, 10 parts by mass of allyl methacrylate/methacrylic acid (80/20) copolymer as a dispersing agent, and 15 parts by mass/20 parts by mass/40 parts by mass cyclohexanone/methoxypropyl acetate/1-methoxy-2-propanol as a solvent)] | 0.40 g |
| Thermal polymerization inhibitor (N-nitrosophenylhydroxylamine aluminium | 0.01 g |
| Fluorine-based surfactant (F-1) | 0.001 g |
| Polyoxyethylene-polyoxypropylene condensate | 0.04 g |
| ("Pluronic L44", product of ADEKA Corp) | |

(continued)

| Compound | Amount added |
|---|---|
| Neutralizer (compound shown in Table 15) | 0.17 g |
| Tetraethylamine hydrochloride | 0.01 g |
| 1-Methoxy-2-propanol | 3.5 g |
| Methyl ethyl ketone | 8.0 g |

[Table 14]

| | |
|---|---|
| Water | 100.00 g |
| Surfactant shown in Table 15 | 5.00 g |
| Gum Arabic (Mw=250000) | 1.00 g |
| Gluconic acid | 0.05 g |
| Tetrasodium ethylenediaminetetraacetate | 0.05 g |
| Triethanolamine | 0.75 g |
| Morpholinoethanol | 0.75 g |

[Table 15]

| | Neutralizer | Surfactant | Developability | Sensitivity | Runlength | Stain resistance | Scratch resistance | Development scum |
|---|---|---|---|---|---|---|---|---|
| Example 79 | N-1 | W-1 | 1.4 | 1.0 | 1,0 | A | B | A |
| Example 80 | N-2 | W-1 | 1.3 | 1.0 | 1.2 | A | A | A |
| Example 81 | N-2 | W-2 | 1.3 | 1.0 | 1.2 | A | A | A |
| Example 82 | N-2 | W-3 | 1.3 | 1.0 | 1.2 | A | A | A |
| Example 83 | N-2 | W-4 | 1.0 | 1.0 | 1.2 | B | A | B |
| Example 84 | N-2 | W-5 | 0.9 | 1.1 | 1.2 | B | A | B |
| Example 85 | N-3 | W-1 | 1.1 | 1.3 | 1.2 | A | A | A |
| Example 86 | - | W-1 | 0.9 | 1.1 | 1.2 | B | A | A |
| Comparative Example 13 | - | W-1 | 0.5 | 1.0 | 1.0 | D | B | D |

The following are Polymerizable compound (M-2) and Chain transfer agent (S-3) shown in Table 13, and Neutralizers (N-1) to (N-3) and Surfactants (W-1) to (W-5) shown in Table 15.

[Chem. 52]

(W-1) "Newcol B13" (product ofNippon Nyukazai)

(W-2) "Softazoline LPB-R": lauramidopropyl betaine (product of Kawaken Fine Chemical)

(W-3) "Softazoline LAO": lauramidopropylamine oxide (product of Kawaken Fine Chemical)

(W-4) "ELEMINOL MON2": mixture of sodium alkyldiphenyl ether disulfonate and sodium alkyl diphenyl ether monosulfonate (product of Sanyo Chemical)

(W-5) "Pionin B-111": lauryl trimonium chloride (product of Takemoto Oil & Fat)

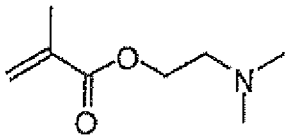

(N-1)

$CH_3ONa$ (N-2)

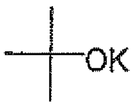

(N-3)

M-2

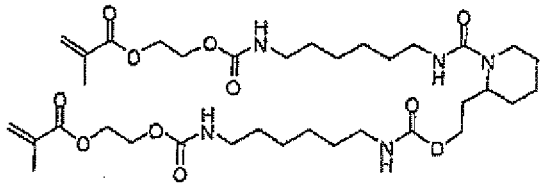

S-3

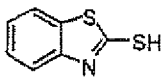

It is apparent from Table 15 that the lithographic printing plate precursors of the invention are excellent in developability, sensitivity, runlength, stain resistance, scratch resistance, and development scum.

<Examples 87 to 94, Comparative Example 14>

Lithographic printing plate precursors were produced in a manner similar to Example 65 except for the use of a photosensitive layer coating solution having the composition shown in Table 16.

Exposure, development, and printing were performed in manners similar to Example 65 except for the use of the lithographic printing plate precursors thus obtained and a developer having the composition shown in Table 17 and adjusted to pH 7.0 with phosphoric acid and sodium carbonate. Developability, sensitivity, runlength, stain resistance, and development scum were evaluated as in Example 79. Evaluation results are shown in Table 18.

[Table 16]

| Compound | Amount added |
|---|---|
| Binder polymer (F-4, PR-4 in Comparative Example) | 0.50 g |
| Polymerizable compound (M-2) | 0.60 g |
| Radical polymerization initiator (I-1) | 0.08 g |
| Sensitizing dye (D-1) | 0.06 g |
| Chain transfer agent (S-3) | 0.07 g |
| Dispersion of ε-phthalocyanine pigment [(15 parts by mass of the pigment, 10 parts by mass of allyl methacrylate/methacrylic acid (80/20) copolymer as a dispersing agent, and 15 parts by mass/20 parts by mass/40 parts by mass cyclohexanone/methoxypropyl acetate/1-methoxy-2-propanol as a solvent)] | 0.40 g |
| Thermal polymerization inhibitor (N-nitrosophenylhydroxylamine aluminum | 0.01 g |

(continued)

| Compound | Amount added |
|---|---|
| Fluorine-based surfactant (F-1) | 0.001 g |
| Polyoxyethylene-polyoxypropylene condensate ("Pluronic L44", product of ADEKA Corp) | 0.04 g |
| Neutralizer (N-1) | 0.17 g |
| Tetraethylamine hydrochloride | 0.01 g |
| 1-Methoxy-2-propanol | 3.5 g |
| Methyl ethyl ketone | 8.0 g |

[Table 17]

| | |
|---|---|
| Water | 100.00 g |
| Surfactant shown in Table 18 | 5.00 g |
| Gum Arabic (Mw=250000) | 1.00 g |
| Gluconic acid | 0.05 g |
| Tetrasodium ethylenediaminetetraacetate | 0.05 g |
| Amine compound listed in Table 18 | 1.50 g |

[Table 18]

| | Aminecompound | Surfactant | Developability | Sensitivity | Runlength | Stain resistance | Development scum |
|---|---|---|---|---|---|---|---|
| Example 87 | A-1 | W-1 | 1.4 | 1.0 | 1,0 | A | A |
| Example 88 | A-1 | W-2 | 1.3 | 1.0 | 1.1 | A | A |
| Example 89 | A-1 | W-3 | 1.3 | 1.0 | 1.1 | A | A |
| Example 90 | A-1 | W-4 | 1.0 | 1.0 | 1.0 | A | A |
| Example 91 | A-1 | W-5 | 0.9 | 1.0 | 1.1 | B | B |
| Example 92 | A-2 | W-1 | 1.4 | 1.1 | 1.0 | B | B |
| Example 93 | A-3 | W-1 | 1.4 | 1.3 | 1.0 | A | A |
| Example 94 | - | W-1 | 0.7 | 1.1 | 1.2 | B | B |
| Comparative Example 14 | - | W-1 | 0.5 | 1.0 | 1.0 | D | D |

The following are Amine compounds (A-1) to (A-3) shown in Table 18.

A-1: Triethanolamine

A-2: Morpholinoethanol

A-3: 1-Piperidineethanol

It is apparent from Table 18 that the lithographic printing plate precursors of the invention are excellent in developability, sensitivity, runlength, stain resistance, and development scum.

<Examples 95 to 98, Comparative Example 15>

Lithographic printing plate precursors were produced in a manner similar to Example 65 except for the use of a photosensitive layer coating solution having the composition shown in Table 19.

Exposure, development, and printing were performed in manners similar to Example 65 except for the use of the lithographic printing plate precursors thus obtained and a developer having the composition shown in Table 20 and adjusted to pH 7.0 with phosphoric acid and sodium carbonate. Developability, sensitivity, runlength, stain resistance, and halftone dot reproduction were evaluated as in Example 65. Evaluation results are shown in Table 21.

[Table 19]

| Compound | Amount added |
|---|---|
| Binder polymer (1) (F-4, 0.50 g of PR-4 in Comparative Example) | 0.30 g |
| Binder polymer (2) (compound listed in Table 21) | 0.25 g |
| Polymerizable compound (M-1) | 1.00 g |
| Radical polymerization initiator (I-1) | 0.08 g |
| Sensitizing dye (D-1) | 0.06 g |
| Chain transfer agent (S-3) | 0.07 g |
| Dispersion of ε-phthalocyanine pigment [(15 parts by mass of the pigment, 10 parts by mass of allyl methacrylate/methacrylic acid (80/20) copolymer as a dispersing agent, and 15 parts by mass/20 parts by mass/40 parts by mass cyclohexanone/methoxypropyl acetate/1-methoxy-2-propanol as a solvent)] | 0.40 g |
| Thermal polymerization inhibitor (N-nitrosophenylhydroxylamine aluminum | 0.01 g |
| Fluorine-based surfactant (F-1) | 0.001 g |
| Neutralizer (N-1) | 0.17 g |
| 1-Methoxy-2-propanol | 3.5 g |
| Methyl ethyl ketone | 8.0 g |

[Table 20]

| | |
|---|---|
| Water | 100.00 g |
| W-1 | 5.00 g |
| Gum Arabic (Mw=250000) | 1.00 g |
| Gluconic acid | 0.05 g |
| Tetrasodium ethylenediaminetetraacetate | 0.05 g |
| Triethanolamine | 1.50 g |

[Table 21]

| | Binder polymer (2) | Developability | Sensitivity | Runlength | Stain resistance | Halftone dot reproduction |
|---|---|---|---|---|---|---|
| Example 95 | F-10 | 1.1 | 1.0 | 1.0 | A | A |
| Example 96 | F-11 | 1.0 | 1.0 | 1.1 | A | A |
| Example 97 | F-12 | 1.0 | 1.0 | 1.2 | A | A |
| Example 98 | (F-4) | 1.4 | 1.0 | 1.0 | A | B |
| Comparative Example 15 | - | 0.5 | 1.0 | 1.0 | D | C |

The following are Binder polymers (F-10) to (F-12) shown in Table 21.

[Chem. 53]

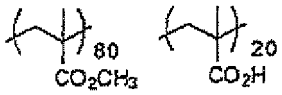
Mw = 50000 (F-10)

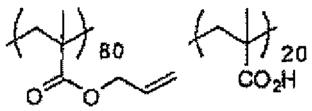
Mw = 65000 (F-11)

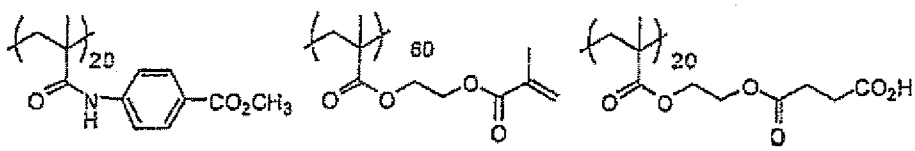
(F-12)

Mw = 65000

It is apparent from Table 21 that the lithographic printing plate precursors of the invention are excellent in developability, sensitivity, runlength, stain resistance, and halftone dot reproduction.

INDUSTRIAL APPLICABILITY

The present invention can provide a lithographic printing plate precursor that enables development with an aqueous developer having a pH from 2 to 10, has a photosensitive layer capable of imparting excellent runlength to an image area when cured by laser exposure, and enables effective removal of a non-image area, that is, an unexposed portion, by using an aqueous developer having a pH from 2 to 10; and a production process of a lithographic printing plate by using the lithographic printing plate precursor.

Although the invention has been described in detail or described in reference to specific embodiments, it is obvious for those skilled in the art that variations and modifications can be added without departing from the scope of the invention as defined by the appended claims.

The present application is based on Japanese Patent Publication (Japanese Patent Application JP 2008-84983), filed March 27, 2008.

**Claims**

1. A process for producing a lithographic printing plate comprising:

   (i) image-wise exposing a lithographic printing plate precursor comprising at least a photosensitive layer on a support; and

(ii) removing unexposed areas of the photosensitive layer in the presence of an aqueous developer having a pH of from 2 to 10 and which contains a water soluble polymer compound and a surfactant selected from a nonionic surfactant, an amphoteric surfactant and a combination thereof to carry out development and gumming at the same time;

wherein the photosensitive layer of the lithographic printing plate precursor comprises the following components (A), (B), and (C):

(A) a copolymer having a repeating unit represented by the formula (1), a repeating unit represented by the formula (I) and at least either one of a repeating unit represented by the formula (2) and a repeating unit represented by the formula (3):

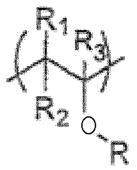 (1) 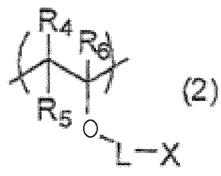 (2) 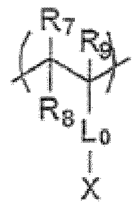 (3) 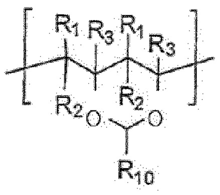 (I)

in the formulae (1), (I), (2), and (3), R represents an acyl group having from 2 to 20 carbon atoms, an alkyl group having from 1 to 20 carbon atoms, an aryl group having from 6 to 20 carbon atoms, an alkenyl group having from 2 to 20 carbon atoms, or an alkynyl group having from 2 to 20 carbon atoms; $R_1$ to $R_9$ are each independently a hydrogen atom or an alkyl group having from 1 to 20 carbon atoms; $R_{10}$ represents a hydrogen atom, a methyl group, an ethyl group, a propyl group, a phenyl group or a hydroxyphenyl group, with the proviso that any two of $R_1$ to $R_3$ in formula (I) may be the same or different; L represents a divalent linking group containing alkylene, arylene, alkenylene,$-SO_2-$, -SO-, -O-, -S-, -CO-, $-N(R_{3a})-$, either singly or in combination, wherein $R_{3a}$ represents an alkyl group, an aryl group or a hydrogen atom; X represents a carboxylic acid group or a carboxylate salt; $L_0$ represents a single bond or a divalent hydrocarbon group having from 1 to 6 carbon atoms, with the proviso that $R_2$ and R in the formula (1), $R_5$ and L in the formula (2), and $R_8$ and $L_0$ in the formula (3) may be coupled to each other to form a ring;
(B) a compound having an ethylenically unsaturated bond; and
(C) a polymerization initiator.

2. A process according to Claim 1, wherein the photosensitive layer further comprises (D) a sensitizing dye.

3. A process according to Claim 1, wherein the copolymer (A) contains 70 mol% or greater but not greater than 95 mol% of the repeating unit represented by the formula (I).

4. A process according to Claim 2 or Claim 3, wherein the copolymer (A) contains 30 mol% or greater but not greater than 80 mol% of repeating units represented by the formula (II) :

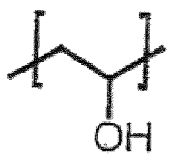 (II)

5. A process according to any of Claims 2-4, wherein the copolymer (A) has a mass average molecular weight (Mw) of from 10,000 to 40,000.

6. A process according to any of Claims 2-5, wherein the number of the carboxylic acid or carboxylate salt contained in one repeating unit of formula (2) or formula (3) is one.

7. A process according to any of Claims 2-6, wherein L or $L_0$ in formula (2) and/or formula (3) represents an aliphatic linking group which may have a substituent.

8. A process according to any of Claims 2-7, wherein the copolymer (A) has at least one ethylenically unsaturated

double bond group.

**9.** A process according to any of Claims 2-8, wherein the copolymer (A) contains the repeating unit represented by the formula (2) or the formula (3) in which X represents a carboxylate having a metal salt as a counter cation.

**10.** A process according to any of Claims 2-9, wherein the photosensitive layer further contains an acrylic resin.

**11.** A process according to Claim 1, wherein the developer contains an organic amine compound.

**12.** A process according to Claim 1, wherein the pH of the developer is from 4 to 7.

**13.** A process according to Claim 1, wherein the water soluble polymer is a soybean polysaccharide, modified starch, gum arabic, dextrin, a cellulose derivative or a modified product thereof, pullulan, polyvinyl alcohol or a derivative thereof, polyvinylpyrrolidone, polyacrylamide, an acrylamide copolymer, a vinyl methyl ether/maleic anhydride copolymer, a vinyl acetate/maleic anhydride copolymer or a styrene/maleic anhydride copolymer.

**Patentansprüche**

**1.** Verfahren zur Herstellung einer Lithographiedruckplatte, umfassend:

(i) bildweises Belichten eines Lithographiedruckplattenvorläufers, der zumindest eine fotoempfindliche Schicht auf einem Träger umfasst; und
(ii) Entfernen von nicht belichteten Bereichen der fotoempfindlichen Schicht in der Gegenwart eines wässrigen Entwicklers mit einem pH-Wert von 2 bis 10, der eine wasserlösliche Polymerverbindung und ein Tensid enthält, ausgewählt aus einem nichtionischen Tensid, einem amphoteren Tensid und einer Kombination hiervon, um eine Entwicklung und Gummierung gleichzeitig durchzuführen;

worin die fotoempfindliche Schicht des Lithographiedruckplattenvorläufers die folgenden Komponenten (A), (B) und (C) umfasst:

(A) ein Copolymer mit einer durch die Formel (1) dargestellten Wiederholungseinheit, einer durch die Formel (I) dargestellten Widerholungseinheit und zumindest einer von einer durch die Formel (2) dargestellten Wiederholungseinheit und einer durch die Formel (3) dargestellten Wiederholungseinheit:

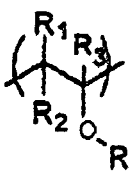 (1) 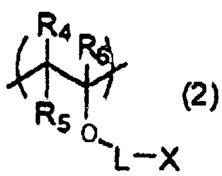 (2) 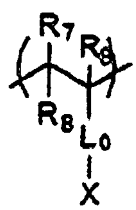 (3) 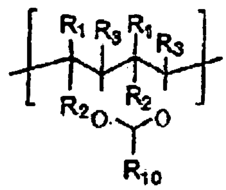 (I)

worin in den Formeln (1), (I), (2) und (3) R eine Acylgruppe mit 2 bis 20 Kohlenstoffatomen, eine Alkylgruppe mit 1 bis 20 Kohlenstoffatomen, eine Arylgruppe mit 6 bis 20 Kohlenstoffatomen, eine Alkenylgruppe mit 2 bis 20 Kohlenstoffatomen oder eine Alkinylgruppe mit 2 bis 20 Kohlenstoffatomen darstellt; $R_1$ bis Rg jeweils unabhängig ein Wasserstoffatom oder eine Alkylgruppe mit 1 bis 20 Kohlenstoffatomen sind; $R_{10}$ ein Wasserstoffatom, eine Methylgruppe, eine Ethylgruppe, eine Propylgruppe, eine Phenylgruppe oder eine Hydroxyphenylgruppe darstellt, mit der Maßgabe, dass jegliche zwei von $R_1$ bis $R_3$ in Formel (I) gleich oder verschieden sein können; L eine divalente Verknüpfungsgruppe darstellt, die Alkylen, Arylen, Alkenylen, $-SO_2-$, -SO-, -O-, -S-, -CO-, $-N(R_{3a})-$ enthält, entweder einzeln oder in Kombination, worin $R_{3a}$ eine Alkylgruppe, eine Arylgruppe oder ein Wasserstoffatom darstellt; X eine Carbonsäuregruppe oder ein Carboxylatsalz darstellt; $L_0$ eine Einfachbindung oder eine divalente Kohlenwasserstoffgruppe mit 1 bis 6 Kohlenstoffatomen darstellt, mit der Maßgabe, dass $R_2$ und R in Formel (1), $R_5$ und L in der Formel (2) und $R_8$ und $L_0$ in der Formel (3) miteinander verbunden sein können, um einen Ring zu bilden;
(B) eine Verbindung, die eine ethylenisch ungesättigte Bindung aufweist; und
(C) einen Polymerisationsinitiator.

2. Verfahren gemäß Anspruch 1, worin die fotoempfindliche Schicht ferner (D) einen Sensibilisierungsfarbstoff umfasst.

3. Verfahren gemäß Anspruch 1, worin das Copolymer (A) 70 mol% oder mehr, jedoch nicht mehr als 95 mol% der durch die Formel (I) dargestellten Wiederholungseinheit enthält.

4. Verfahren gemäß Anspruch 2 oder Anspruch 3, worin das Copolymer (A) 30 mol% oder mehr, jedoch nicht mehr als 80 mol% der durch die Formel (II) dargestellten Wiederholungseinheiten enthält:

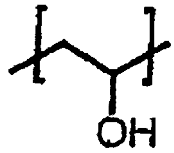

(II)

.

5. Verfahren gemäß irgendeinem der Ansprüche 2 bis 4, worin das Copolymer (A) ein massegemitteltes Molekulargewicht (Mw) von 10.000 bis 40.000 aufweist.

6. Verfahren gemäß irgendeinem der Ansprüche 2 bis 5, worin die Anzahl der Carbonsäuregruppen oder der Carboxylatsalzgruppen, die in einer Wiederholungseinheit der Formel (2) oder Formel (3) enthalten ist, eins ist.

7. Verfahren gemäß irgendeinem der Ansprüche 2 bis 6, worin L oder $L_0$ in der Formel (2) und/oder der Formel (3) eine aliphatische Verknüpfungsgruppe darstellt, die einen Substituenten aufweisen kann.

8. Verfahren gemäß irgendeinem der Ansprüche 2 bis 7, worin das Copolymer (A) mindestens eine ethylenisch ungesättigte Doppelbindungsgruppe aufweist.

9. Verfahren gemäß irgendeinem der Ansprüche 2 bis 8, worin das Copolymer (A) die durch die Formel (2) oder die Formel (3) dargestellte Wiederholungseinheit enthält, worin X ein Carboxylat mit einem Metallsalz als Gegen-Kation darstell.

10. Verfahren gemäß irgendeinem der Ansprüche 2 bis 9, worin die fotoempfindliche Schicht ferner ein Acrylharz enthält.

11. Verfahren gemäß Anspruch 1, worin der Entwickler eine organische Aminverbindung enthält.

12. Verfahren gemäß Anspruch 1, worin der pH-Wert des Entwicklers von 4 bis 7 beträgt.

13. Verfahren gemäß Anspruch 1, worin das wasserlösliche Polymer ein Soja-Polysaccharid, modifizierte Stärke, Gummi arabikum, Dextrin, ein Cellulosederivat oder ein modifiziertes Produkt hiervon, Pullulan, Polyvinylalkohol oder ein Derivat hiervon, Polyvinylpyrrolidon, Polyacrylamid, ein Acrylamid-Copolymer, ein Vinylmethylether/Maleinsäureanhydrid-Copolymer, ein Vinylacetat/Maleinsäureanhydrid-Copolymer oder ein Styrol/Maleinsäureanhyrid-Copolymer ist.

## Revendications

1. Procédé de production d'une plaque d'impression lithographique comprenant :

(i) l'exposition selon une image d'un précurseur de plaque d'impression lithographique comprenant au moins une couche photosensible sur un support ; et
(ii) l'enlèvement de zones non exposées de la couche photosensible en présence d'un révélateur aqueux ayant un pH de 2 à 10 et qui contient un composé polymère soluble dans l'eau et un tensioactif choisi parmi un tensioactif non ionique, un tensioactif amphotère et une de leurs combinaisons pour réaliser dans le même temps un développement et un gommage ;

dans lequel la couche photosensible du précurseur de plaque d'impression lithographique comprend les composants (A), (B) et (C) suivants :

(A) un copolymère ayant un motif répété représenté par la formule (1), un motif répété représenté par la formule

(I) et au moins l'un d'un motif répété représenté par la formule (2) et d'un motif répété représenté par la formule (3) :

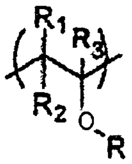 (1) 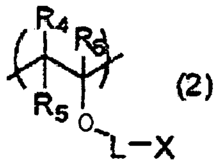 (2) 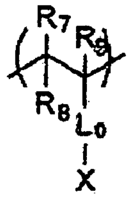 (3) 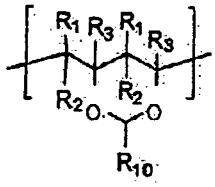 (I)

dans les formules (1), (I), (2) et (3), R représente un groupe acyle comportant de 2 à 20 atomes de carbone, un groupe alkyle comportant de 1 à 20 atomes de carbone, un groupe aryle comportant de 6 à 20 atomes de carbone, un groupe alcényle comportant de 2 à 20 atomes de carbone ou un groupe alcynyle comportant de 2 à 20 atomes de carbone ; $R_1$ à $R_9$ sont chacun indépendamment un atome d'hydrogène ou un groupe alkyle comportant 1 à 20 atomes de carbone ; $R_{10}$ représente un atome d'hydrogène, un groupe méthyle, un groupe éthyle, un groupe propyle, un groupe phényle ou un groupe hydroxyphényle, à condition que deux quelconques de $R_1$ à $R_3$ dans la formule (I) puissent être identiques ou différents ; L représente un groupe de liaison divalent contenant des groupes alkylène, arylène, alcénylène, - $SO_2$- -SO-, -O-, -S-, -CO-, -N($R_{3a}$)-, soit seul, soit en combinaison, $R_{3a}$ représente un groupe alkyle, un groupe aryle ou un atome d'hydrogène ; X représente un groupe acide carboxylique ou un sel de carboxylate ; $L_0$ représente une simple liaison ou un groupe hydrocarbure divalent comportant de 1 à 6 atomes de carbone, à condition que $R_2$ et R dans la formule (1), $R_5$ et L dans la formule (2) et $R_8$ et $L_0$ dans la formule (3) puissent être couplés les uns aux autres pour former un cycle ;
(B) un composé comportant une liaison éthyléniquement insaturée ; et
(C) un initiateur de polymérisation.

2. Procédé selon la revendication 1, dans lequel la couche photosensible comprend en outre (D) un colorant sensibilisateur.

3. Procédé selon la revendication 1, dans lequel le copolymère (A) contient 70 % en mole ou plus, mais pas plus de 95 % en mole du motif répété représenté par la formule (I).

4. Procédé selon la revendication 2 ou la revendication 3, dans lequel le copolymère (A) contient 30 % en mole ou plus, mais pas plus de 80 % en mole de motifs répétés représentés par la formule (II) :

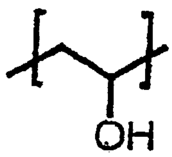 (II)

5. Procédé selon l'une quelconque des revendications 2 à 4, dans lequel le copolymère (A) a un poids moléculaire moyen en masse (Mw) de 10 000 à 40 000.

6. Procédé selon l'une quelconque des revendications 2 à 5, dans lequel le nombre d'acide carboxylique ou de sel de carboxylate contenu dans un motif répété de formule (2) ou de formule (3) est de un.

7. Procédé selon l'une quelconque des revendications 2 à 6, dans lequel L ou $L_0$ dans la formule (2) et/ou la formule (3) représente un groupe de liaison aliphatique qui peut comporter un substituant.

8. Procédé selon l'une quelconque des revendications 2 à 7, dans lequel le copolymère (A) comporte au moins un groupe à double liaison éthyléniquement insaturée.

9. Procédé selon l'une quelconque des revendications 2 à 8, dans lequel le copolymère (A) contient le motif répété représenté par la formule (2) ou la formule (3), dans laquelle X représente un carboxylate comportant un sel de métal en tant que contre-cation.

**10.** Procédé selon l'une quelconque des revendications 2 à 9, dans lequel la couche photosensible contient en outre une résine acrylique.

**11.** Procédé selon la revendication 1, dans lequel le révélateur contient un composé d'amine organique.

**12.** Procédé selon la revendication 1, dans lequel le pH du révélateur est de 4 à 7.

**13.** Procédé selon la revendication 1, dans lequel le polymère soluble dans l'eau est un polysaccharide de soja, de l'amidon modifié, de la gomme arabique, de la dextrine, un dérivé de cellulose ou un produit modifié de celui-ci, du pullulane, un poly(alcool vinylique) ou un dérivé de celui-ci, de la poly(vinylpyrrolidone), un poly(acrylamide), un copolymère d'acrylamide, un copolymère de vinylméthyléther/anhydride maléique, un copolymère d'acétate de vinyle/anhydride maléique ou un copolymère de styrène/anhydride maléique.

FIG. 1

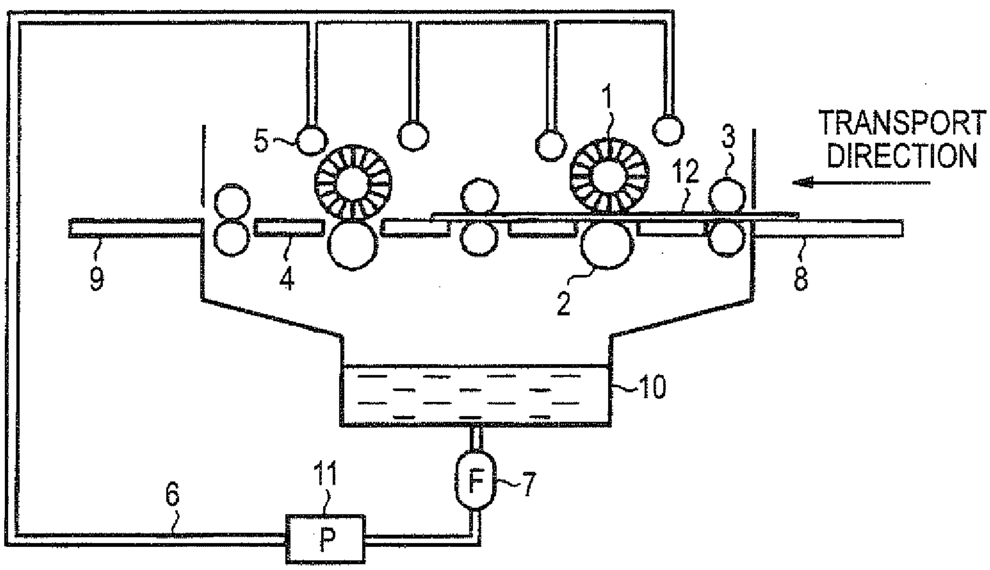

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2002365789 A
- US 20040013968 A
- JP 2001330952 A
- EP 1788431 A2
- JP 9235438 A
- JP 51047334 A
- JP SHO57196231 A
- JP 59005240 A
- JP 59005241 A
- JP 2226149 A
- JP 1165613 A
- JP SHO5421726 B
- JP 48041708 A
- JP SHO5137193 A
- JP 2032293 A
- JP 2016765 A
- JP 58049860 A
- JP 56017654 A
- JP SHO6239417 A
- JP SHO6239418 B
- JP SHO63277653 A
- JP SHO63260909 A
- JP HEI1105238 A
- JP SHO4864183 A
- JP SHO4943191 A
- JP SHO5230490 A
- JP SHO4643946 A
- JP HEI140337 A
- JP 1040336 A
- JP HEI225493 A
- JP SHO6122048 A
- JP 4537377 B
- JP SHO4486516 B
- JP 2001343742 A
- JP 2002148790 A
- JP 2007171406 A
- JP 2007206216 A
- JP 2007206217 A
- JP 2007225701 A
- JP 2007225702 A
- JP 2007316582 A
- JP 2007328243 A
- JP 2007058170 A
- JP 2001133969 A
- JP 2002278057 A
- JP 2001277740 A
- JP 2001277742 A
- US 2800457 A
- US 2800458 A
- US 3287154 A
- JP SHO3819574 B
- JP SHO42446 B
- US 3418250 A
- US 3660304 A
- US 3796669 A
- US 3914511 A
- US 4001140 A
- US 4087376 A
- US 4089802 A
- US 4025445 A
- JP SHO369163 A
- JP SHO519079 A
- GB 930422 A
- US 3111407 A
- GB 952807 A
- GB 967074 A
- JP 2007 A
- JP 171406 A
- JP 206217 A
- JP 225702 A
- US 3458311 A
- JP SHO5549729 B
- US 292501 A
- US 44563 A
- JP 54063902 A
- JP 2001253181 A
- JP 2001322365 A
- US 2714066 A
- US 3181461 A
- US 3280734 A
- US 3902734 A
- JP SHO3622063 B
- US 3276868 A
- US 4153461 A
- US 4689272 A
- JP 2001199175 A
- JP 2002079772 A
- JP HEI10282679 A
- JP HEI2304441 A
- JP HEI545885 A
- JP HEI635174 A
- JP 2008203359 A
- JP 2008276166 A
- JP H02220061 A
- JP S6059351 A
- US 5148746 A
- US 5568768 A
- GB 2297719 A

- JP S58159533 A
- JP H03100554 A
- JP S62167253 B
- JP 2008084983 A


**Non-patent literature cited in the description**


- *Journal of the Adhesion Society of Japan,* 1984, vol. 20 (7), 300-308
- Senryo Binran. The Society of Synthetic Organic Chemistry, 1970
- Saishin Ganryo Binran. Color Index. Pigment Technology Society of Japan, 1977
- Saishin Ganryo Oyou Gijutsu. CMC Publishing, 1986
- Insatsu Ink Gijutsu. CMC Publishing, 1984
- Kinzoku Sekken no Seishitsu to Oyo. CMC Publishing, 1984
- Saishin Ganryo Oyo Gijutsu. CMC Publishing, 1986